# EUROPEAN PATENT APPLICATION

(11) **EP 4 428 921 A1**
(43) Date of publication of application: **11.09.2024**
(21) Application number: 22890017.1
(22) Date of filing: 04.11.2022
(51) Int. Cl.: H01L 27/146, H04N 25/585, H04N 25/70

(54) **IMAGING ELEMENT AND ELECTRONIC DEVICE**

(30) Priority: 05.11.2021 JP 2021180818
(71) Applicant: Sony Semiconductor Solutions Corporation, Atsugi-shi, Kanagawa 243-0014 (JP)
(72) Inventor: OKITA, Koshi, Atsugi-shi, Kanagawa 243-0014 (JP); SAKANO, Yorito, Atsugi-shi, Kanagawa 243-0014 (JP); NAKAMURA, Ryosuke, Atsugi-shi, Kanagawa 243-0014 (JP); YAMANAKA, Takaya, Atsugi-shi, Kanagawa 243-0014 (JP); SHIRAI, Yuki, Atsugi-shi, Kanagawa 243-0014 (JP); NAKASHIMA, Yoshimitsu, Atsugi-shi, Kanagawa 243-0014 (JP); KUWAHARA, Shuto, Atsugi-shi, Kanagawa 243-0014 (JP); KOSUGO, Eiichiro, Atsugi-shi, Kanagawa 243-0014 (JP)
(74) Representative: MFG Patentanwälte Meyer-Wildhagen Meggle-Freund Gerhard PartG mbB
(86) International application number: PCT/JP2022/041146
(87) International publication number: WO 2023/080197

(57) **Abstract**

The present technique relates to an imaging element and an electronic device that can extend a dynamic range.

The imaging element includes: a first photoelectric conversion unit that is provided in a semiconductor substrate and generates a charge corresponding to the amount of light; a second photoelectric conversion unit having a smaller light-receiving area than the first photoelectric conversion unit; a first inter-pixel isolation portion that surrounds a unit pixel including the first photoelectric conversion unit and the second photoelectric conversion unit; and a second inter-pixel isolation portion provided between the first photoelectric conversion unit and the second photoelectric conversion unit, wherein the first inter-pixel isolation portion and the second inter-pixel isolation portion are each configured with a trench penetrating the semiconductor substrate. The present technique can be applied to an imaging element including a large pixel and a small pixel.

## Description

### [Technical Field]

The present technique relates to an imaging element and an electronic device, for example, an imaging element and an electronic device that can extend a dynamic range.

### [Background Art]

As a method for generating an image with a wide dynamic range, a method for synthesizing a first image and a second image is conventionally known, the first and second images being composed of the outputs of first pixels and second pixels, respectively, with different sensitivity levels on the pixel array of a CMOS (complementary metal-oxide semiconductor) image sensor or the like.

As a method for providing pixels with different sensitivity levels, for example, a method for providing a pixel having a long exposure time and a pixel having a short exposure time or a method for providing a pixel having a large photoelectric conversion unit (hereinafter referred to as a large pixel), e.g., a PD (photodiode) and a pixel having a small photoelectric conversion unit (hereinafter referred to as a small pixel) is available (for example, see PTL 1).

### [Citation List]

### [Patent Literature]

[PTL 1]
JP 2017-163010A

### [Summary]

### [Technical Problem]

Improvement in sensitivity and noise reduction with a wider dynamic range have been demanded.

The present technique has been devised in view of such circumstances and is configured to extend a dynamic range using pixels having different sizes, improve sensitivity, and reduce noise.

### [Solution to Problem]

An imaging element according to an aspect of the present technique is an imaging element including: a first photoelectric conversion unit that is provided in a semiconductor substrate and generates a charge corresponding to the amount of light; a second photoelectric conversion unit having a smaller light-receiving area than the first photoelectric conversion unit; a first inter-pixel isolation portion that surrounds a unit pixel including the first photoelectric conversion unit and the second photoelectric conversion unit; and a second inter-pixel isolation portion provided between the first photoelectric conversion unit and the second photoelectric conversion unit, wherein the first inter-pixel isolation portion and the second inter-pixel isolation portion are each configured with a trench penetrating the semiconductor substrate.

An electronic device according to an aspect of the present technique is an electronic device including an imaging element and a processing unit that processes a signal from the imaging element, the imaging element including: a first photoelectric conversion unit that is provided in a semiconductor substrate and generates a charge corresponding to the amount of light; a second photoelectric conversion unit having a smaller light-receiving area than the first photoelectric conversion unit; a first inter-pixel isolation portion that surrounds a unit pixel including the first photoelectric conversion unit and the second photoelectric conversion unit; and a second inter-pixel isolation portion provided between the first photoelectric conversion unit and the second photoelectric conversion unit, wherein the first inter-pixel isolation portion and the second inter-pixel isolation portion are each configured with a trench penetrating the semiconductor substrate.

An imaging element according to an aspect of the present technique includes: a first photoelectric conversion unit that is provided in a semiconductor substrate and generates a charge corresponding to the amount of light; a second photoelectric conversion unit having a smaller light-receiving area than the first photoelectric conversion unit; a first inter-pixel isolation portion that surrounds a unit pixel including the first photoelectric conversion unit and the second photoelectric conversion unit; and a second inter-pixel isolation portion provided between the first photoelectric conversion unit and the second photoelectric conversion unit, wherein the first inter-pixel isolation portion and the second inter-pixel isolation portion are each configured with a trench penetrating the semiconductor substrate.

An electronic device according to an aspect of the present technique is configured to include the imaging element.

The electronic device may be an independent device or an internal block constituting a single device.

### [Brief Description of Drawings]

[Fig. 1]

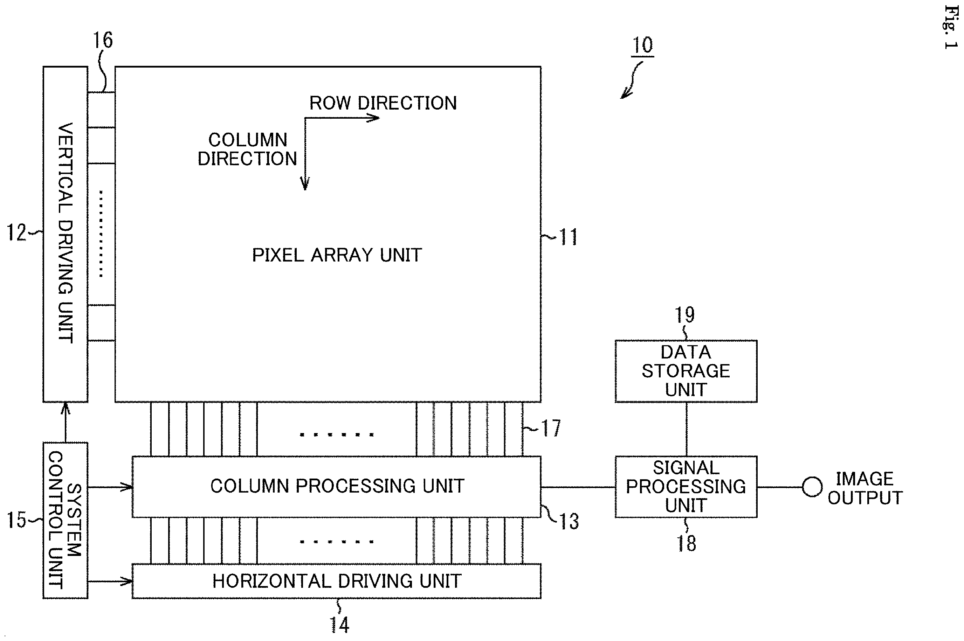

   Fig. 1 illustrates the configuration of an embodiment of an imaging device to which the present technique is applied.
[Fig. 2]

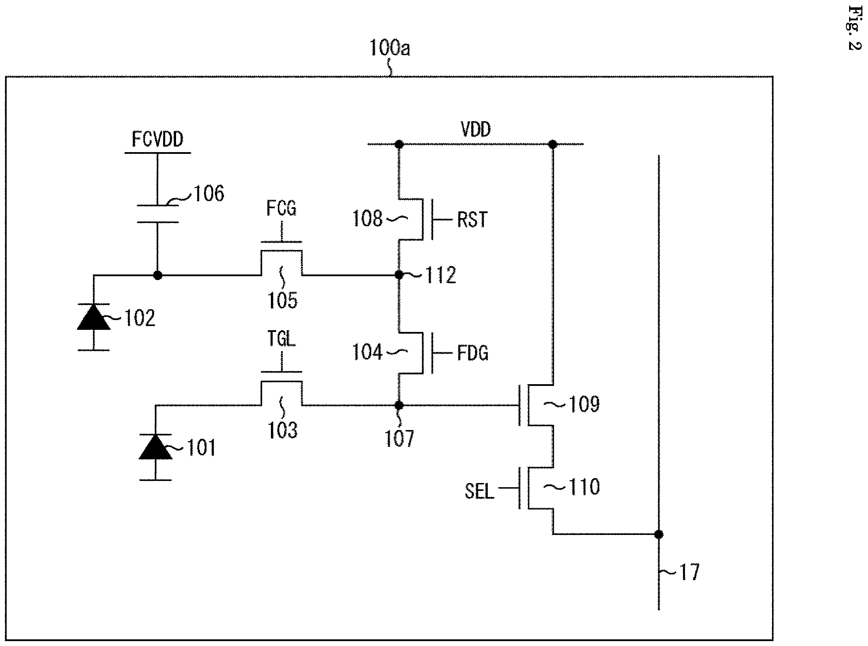

   Fig. 2 is a circuit diagram of a unit pixel.
[Fig. 3]

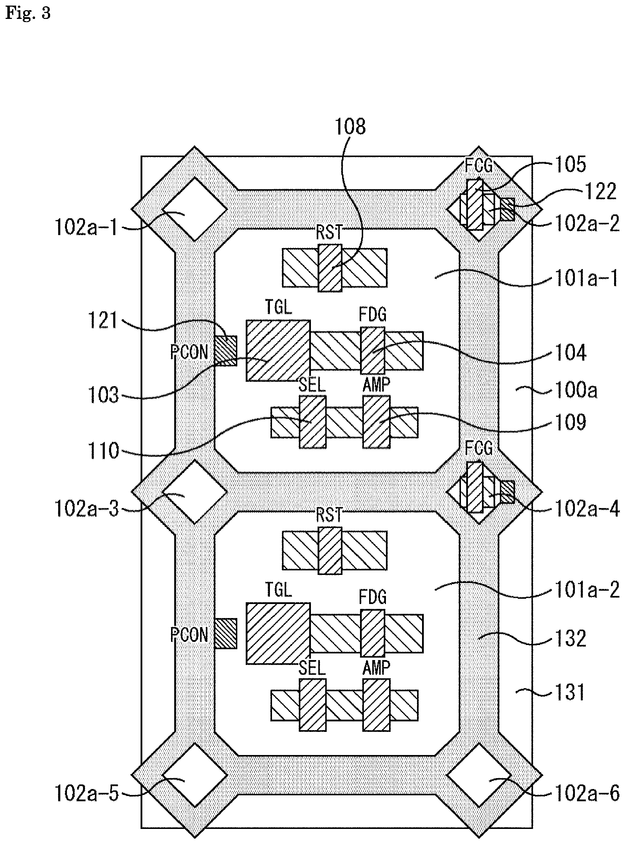

   Fig. 3 illustrates a plan configuration example of a unit pixel according to a first embodiment.
[Fig. 4]

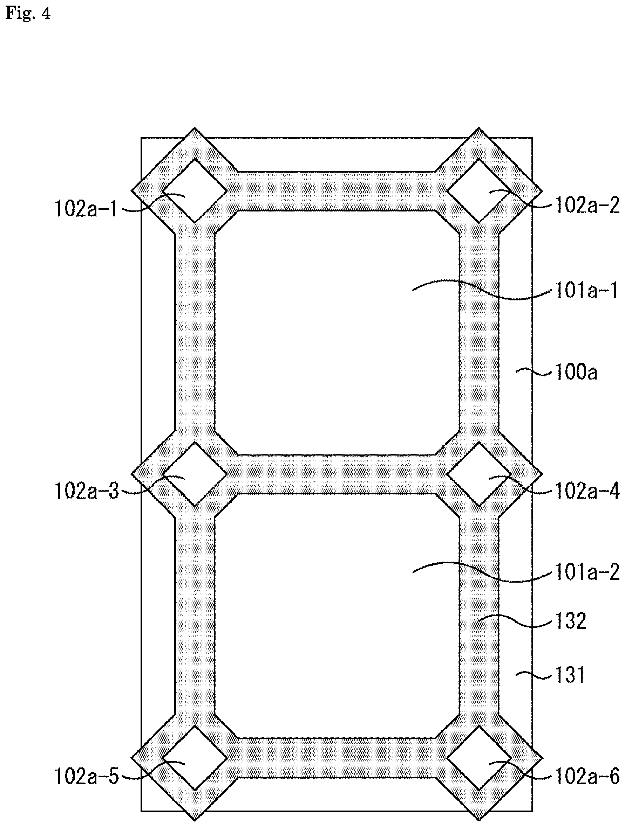

   Fig. 4 illustrates a plan configuration example of the unit pixel according to the first embodiment.
[Fig. 5]

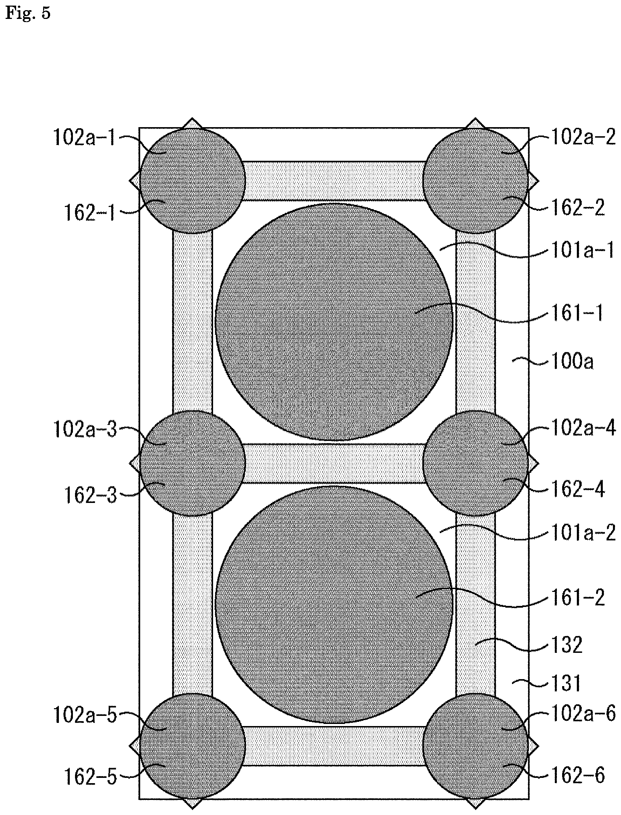

   Fig. 5 illustrates a plan configuration example of the unit pixel according to the first embodiment.
[Fig. 6]

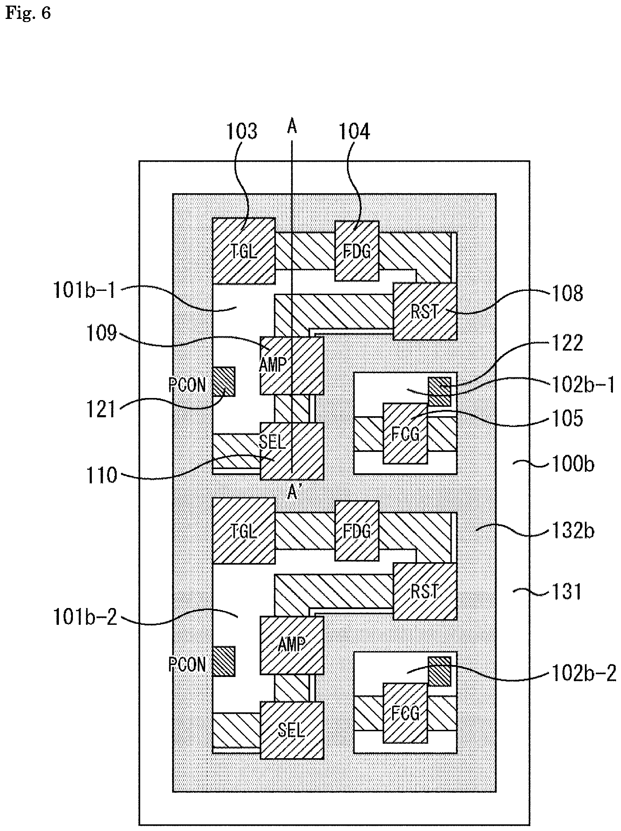

   Fig. 6 illustrates a plan configuration example of a unit pixel according to a second embodiment.
[Fig. 7]

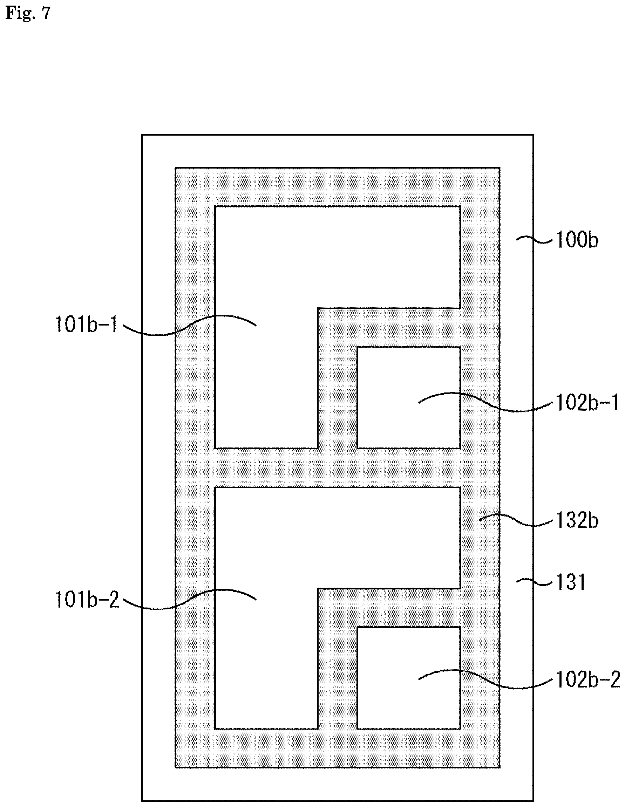

   Fig. 7 illustrates a plan configuration example of the unit pixel according to the second embodiment.
[Fig. 8]

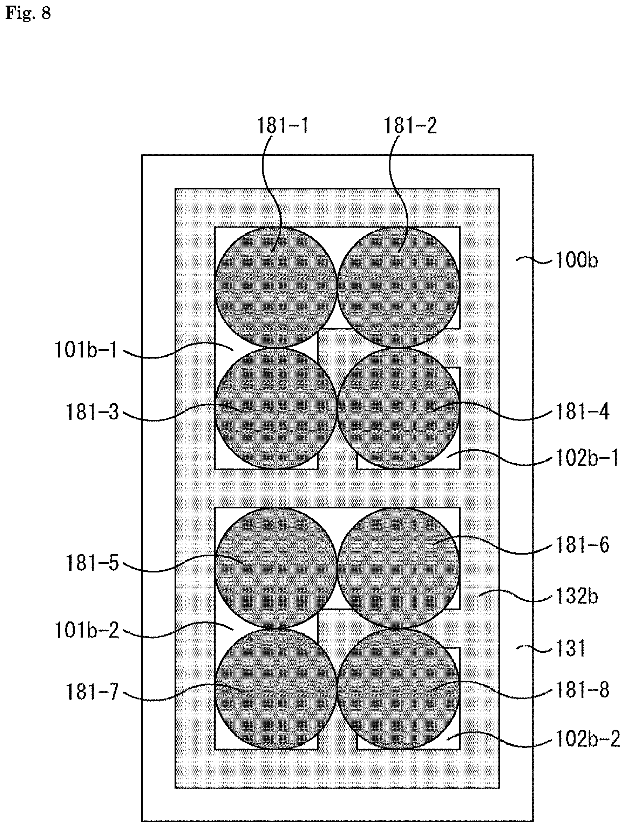

   Fig. 8 illustrates a plan configuration example of the unit pixel according to the second embodiment.
[Fig. 9]

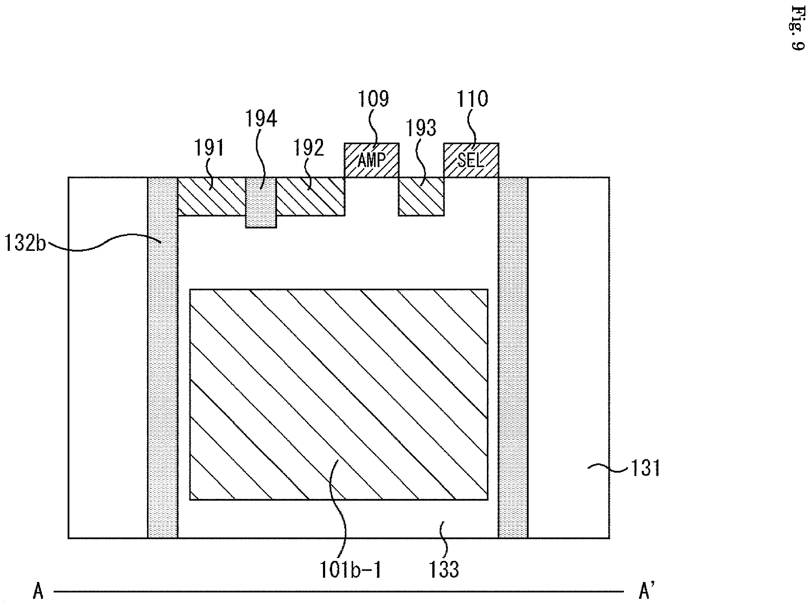

   Fig. 9 illustrates a sectional configuration example of the unit pixel according to the second embodiment.
[Fig. 10]

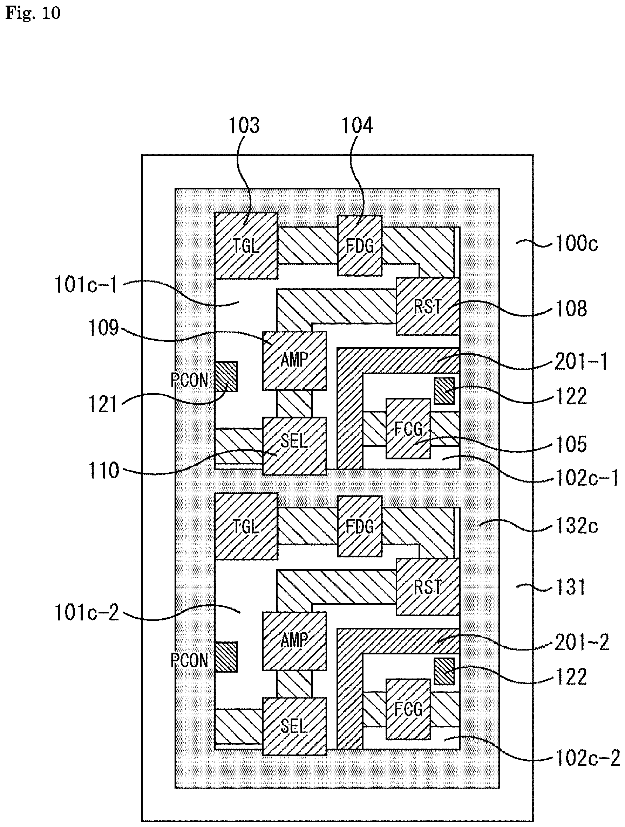

   Fig. 10 illustrates a plan configuration example of a unit pixel according to a third embodiment.
[Fig. 11]

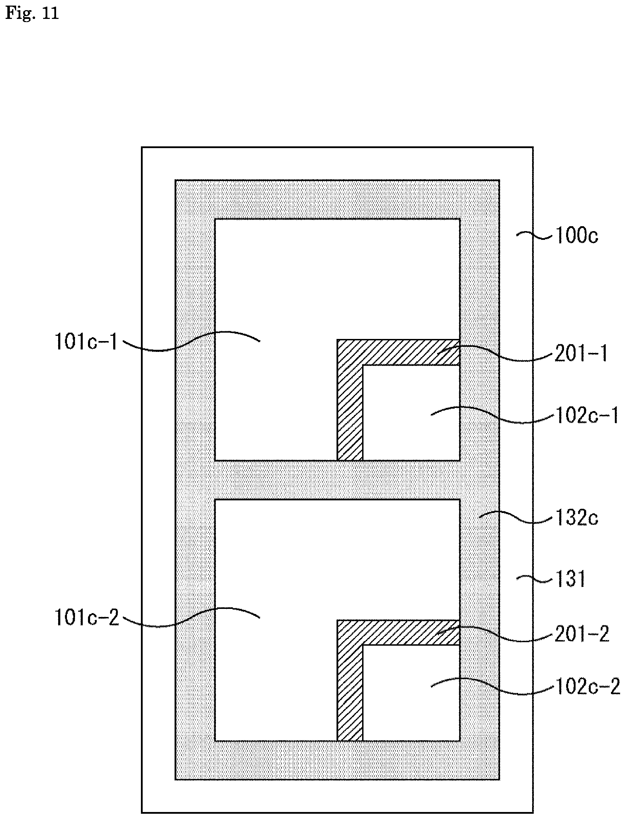

   Fig. 11 illustrates a plan configuration example of the unit pixel according to the third embodiment.
[Fig. 12]

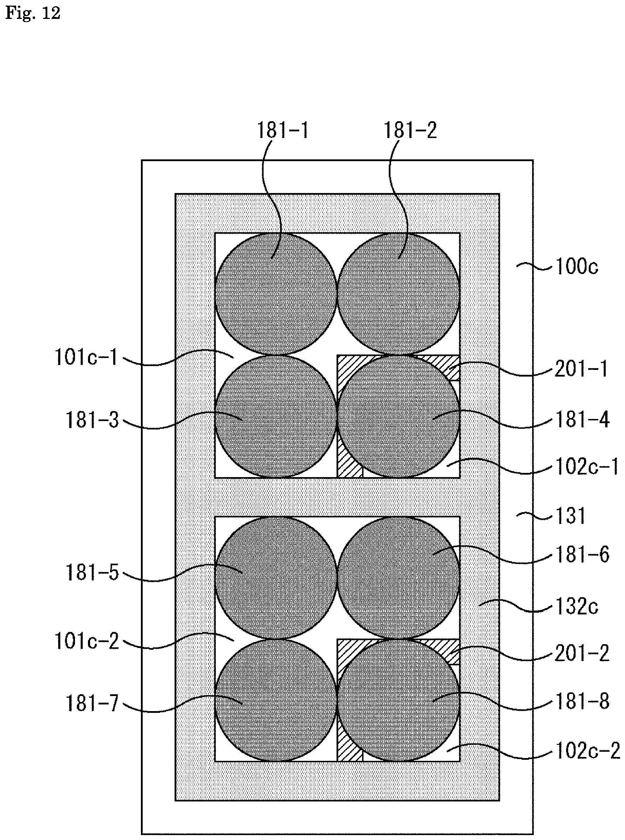

   Fig. 12 illustrates a plan configuration example of the unit pixel according to the third embodiment.
[Fig. 13]

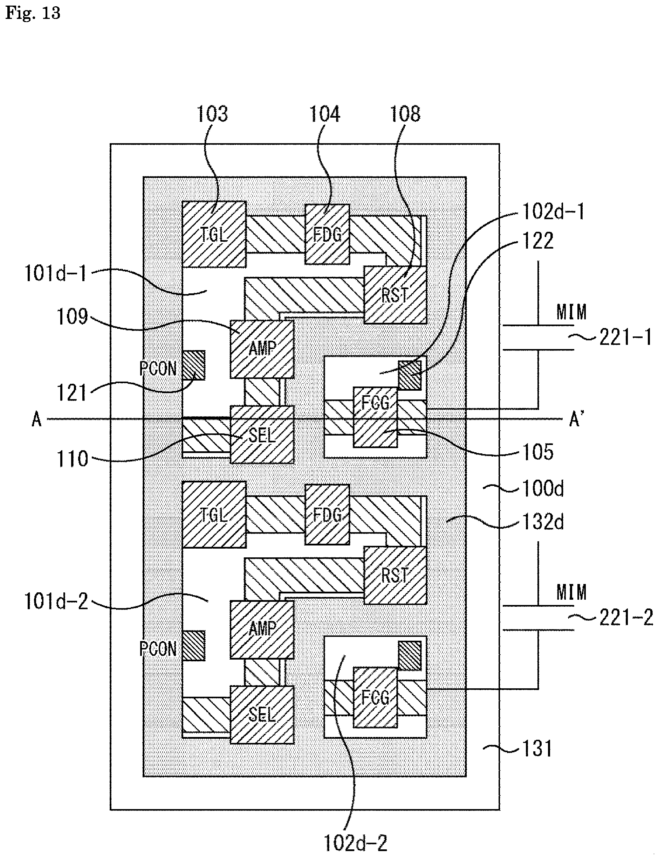

   Fig. 13 illustrates a plan configuration example of a unit pixel according to a fourth embodiment.
[Fig. 14]

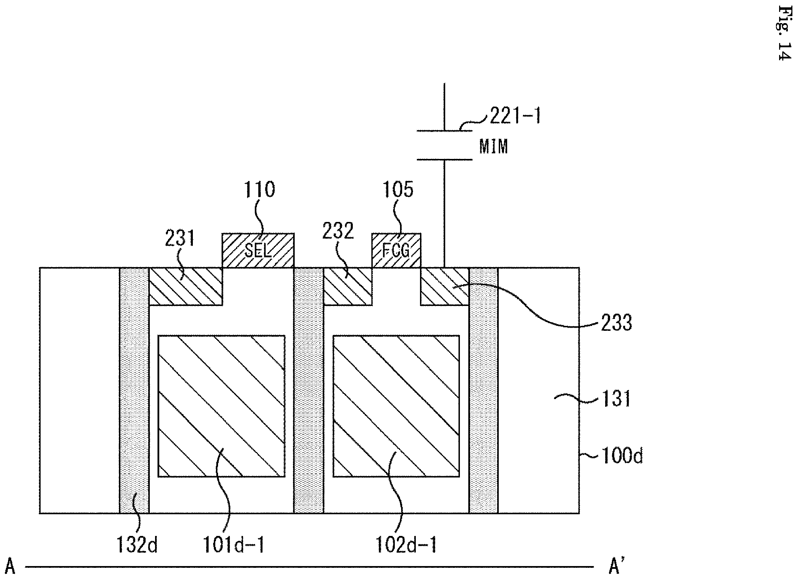

   Fig. 14 illustrates a sectional configuration example of the pixel according to the fourth embodiment.
[Fig. 15]

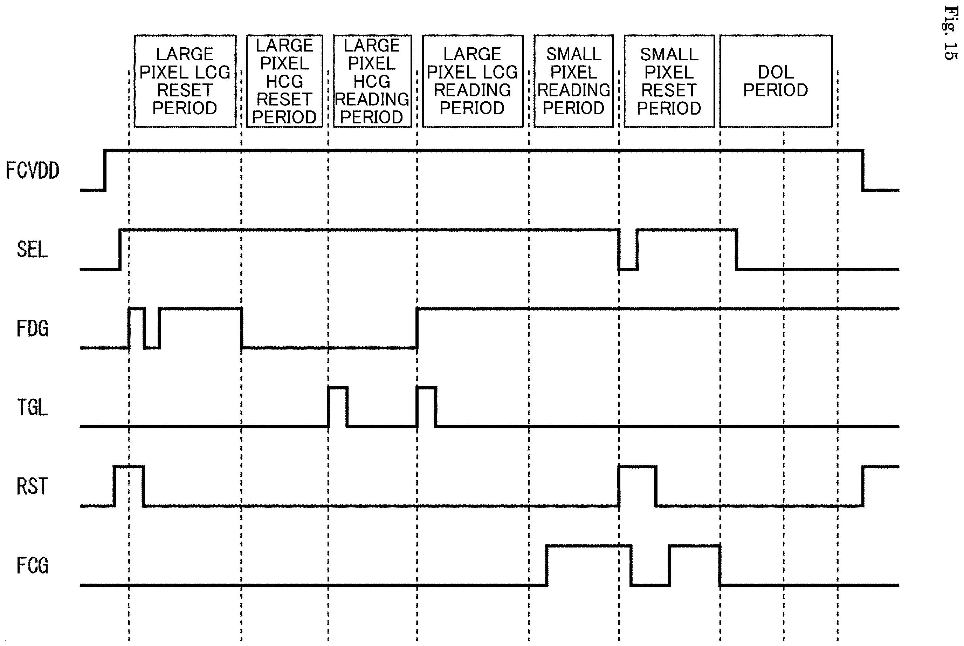

   Fig. 15 is a timing chart for explaining the operations of the unit pixel according to the first to fourth embodiments.
[Fig. 16]

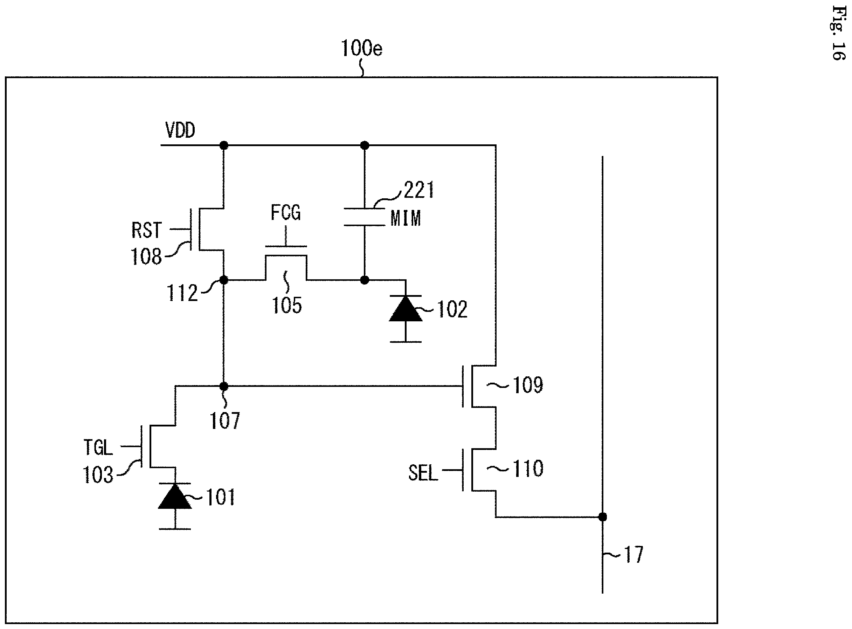

   Fig. 16 illustrates a circuit configuration example of a unit pixel according to a fifth embodiment.
[Fig. 17]

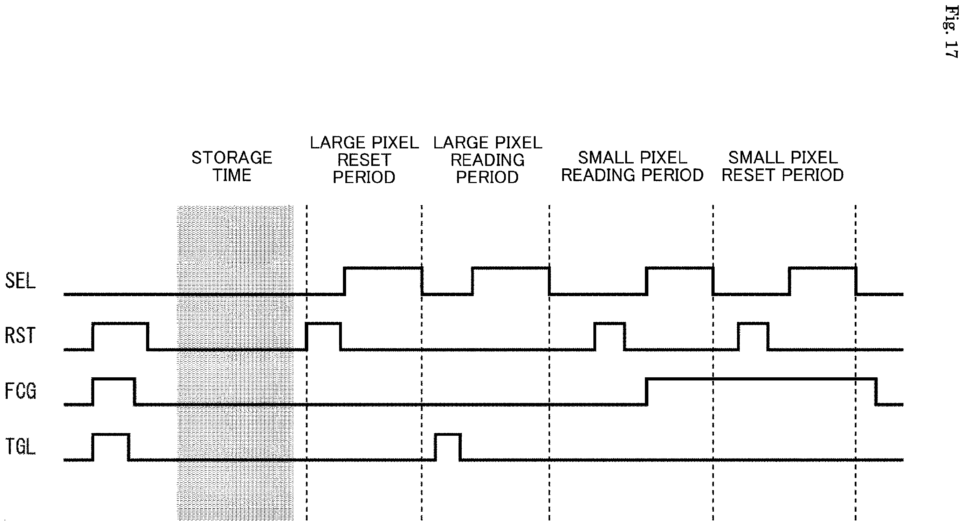

   Fig. 17 is a timing chart for explaining the operations of the unit pixel according to the fifth embodiment.
[Fig. 18]

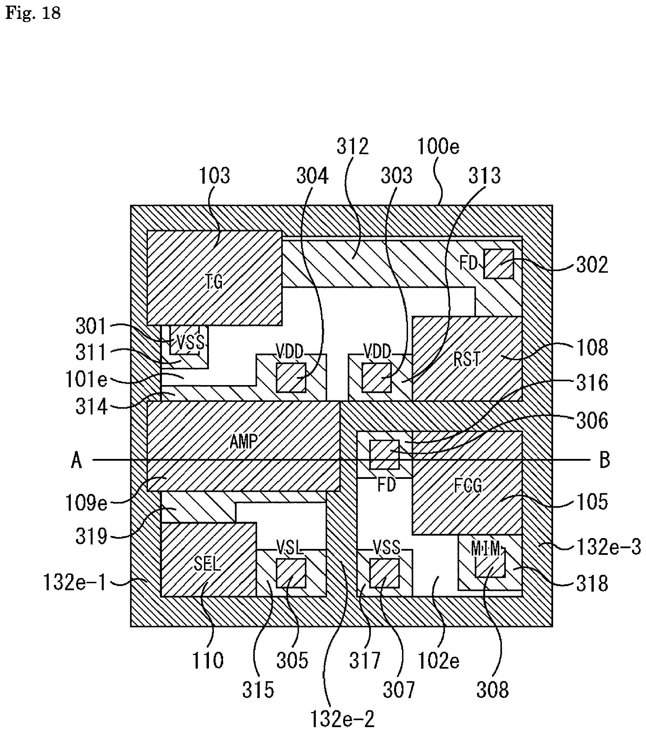

   Fig. 18 illustrates a plan configuration example of the unit pixel according to the fifth embodiment.
[Fig. 19]

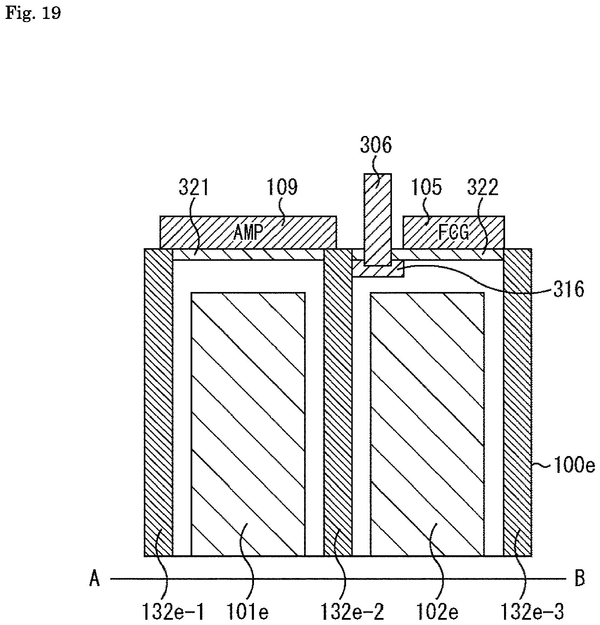

   Fig. 19 illustrates a sectional configuration example of the unit pixel according to the fifth embodiment.
[Fig. 20]

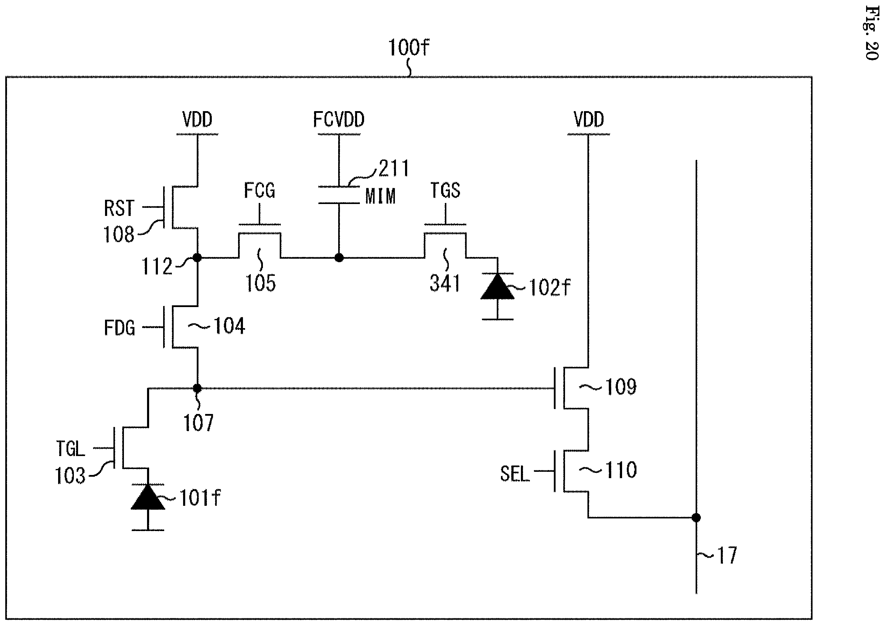

   Fig. 20 illustrates a circuit configuration example of a unit pixel according to a sixth embodiment.
[Fig. 21]

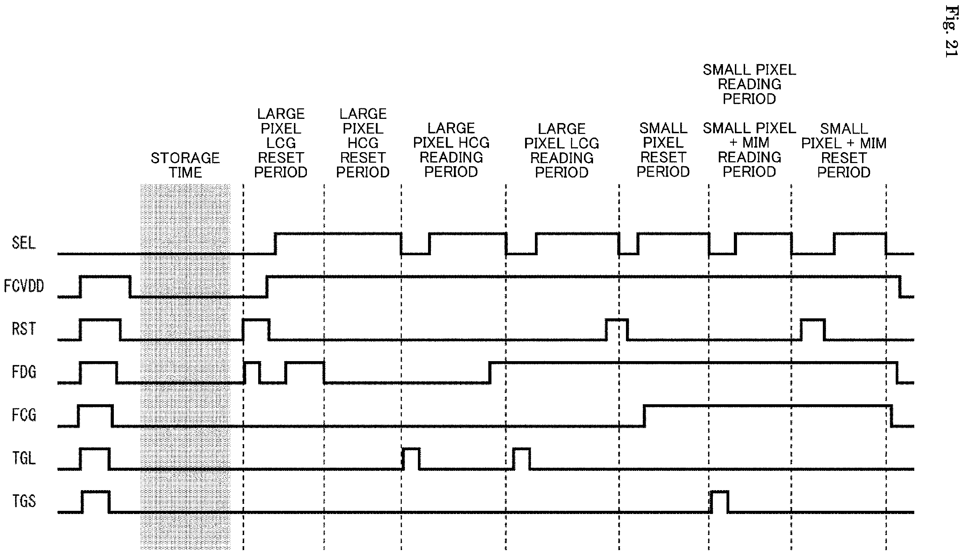

   Fig. 21 is a timing chart for explaining the operations of the unit pixel according to the sixth embodiment.
[Fig. 22]

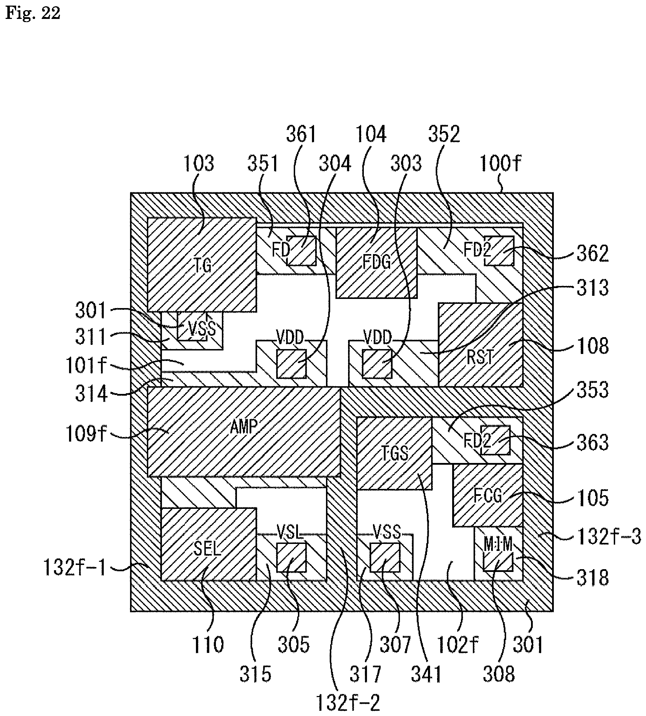

   Fig. 22 illustrates a plan configuration example of the unit pixel according to the sixth embodiment.
[Fig. 23]

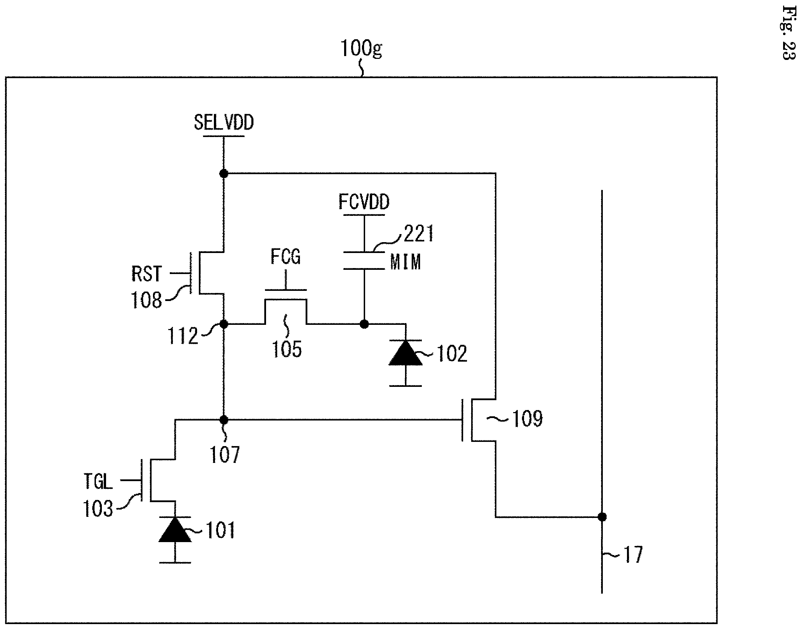

   Fig. 23 illustrates a circuit configuration example of a unit pixel according to a seventh embodiment.
[Fig. 24]

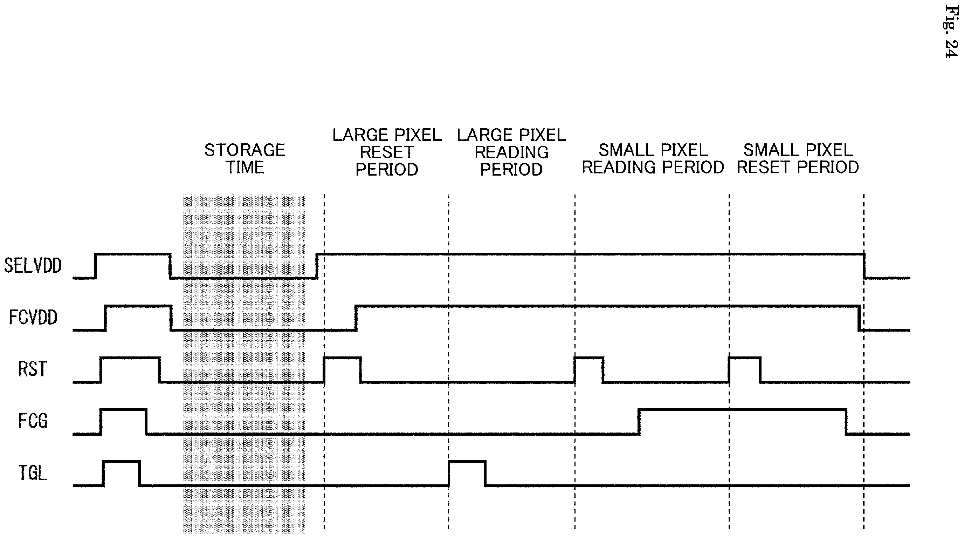

   Fig. 24 is a timing chart for explaining the operations of the unit pixel according to the seventh embodiment.
[Fig. 25]

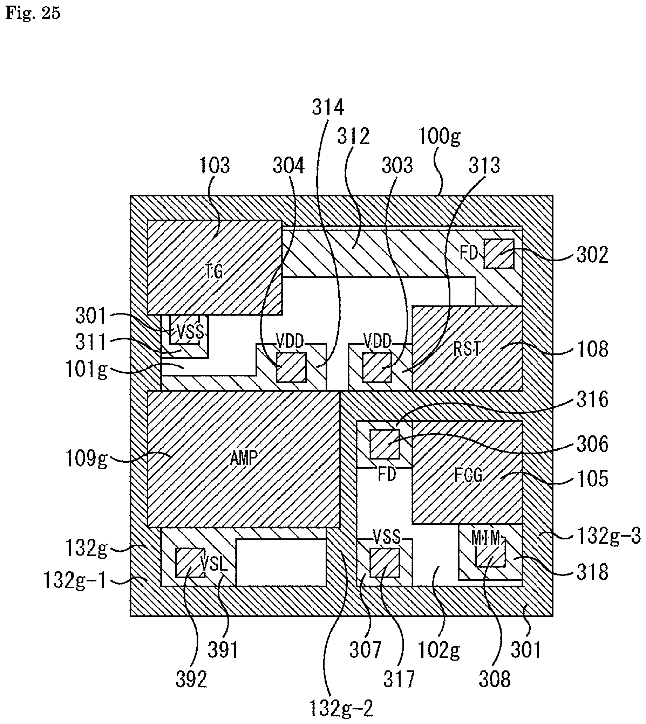

   Fig. 25 illustrates a plan configuration example of the unit pixel according to the seventh embodiment.
[Fig. 26]

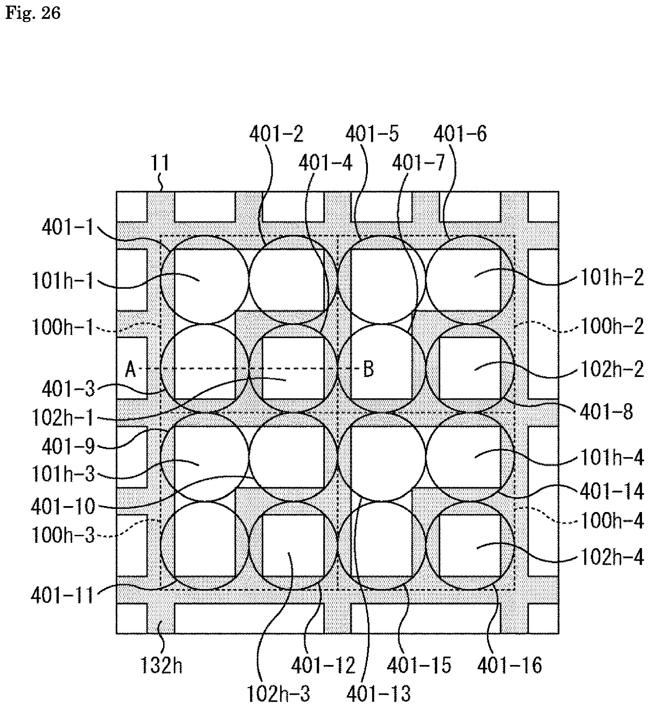

   Fig. 26 illustrates a plan configuration example of a unit pixel according to an eighth embodiment.
[Fig. 27]

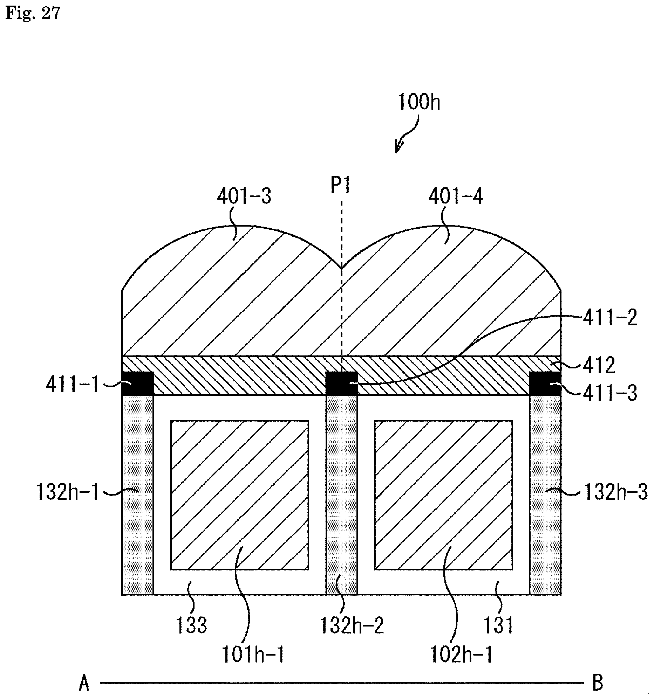

   Fig. 27 illustrates a sectional configuration example of the unit pixel according to the eighth embodiment.
[Fig. 28]

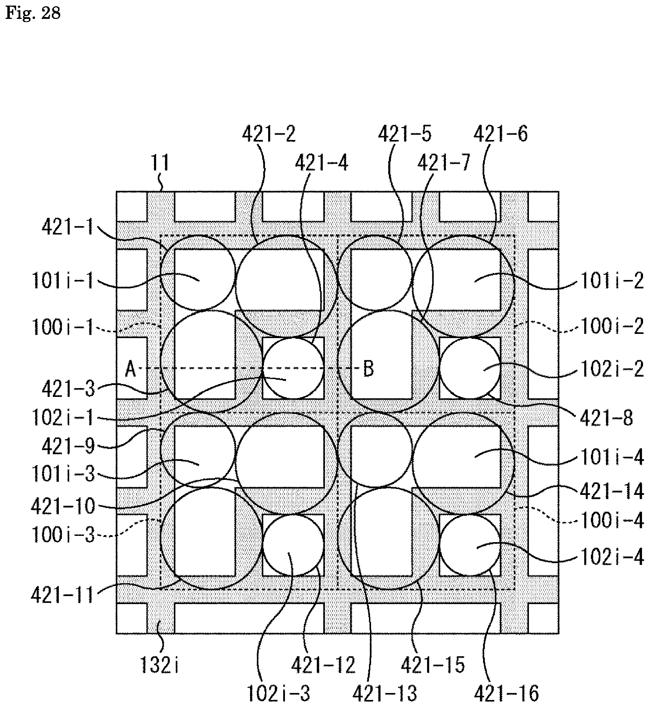

   Fig. 28 illustrates a plan configuration example of a unit pixel according to a ninth embodiment.
[Fig. 29]

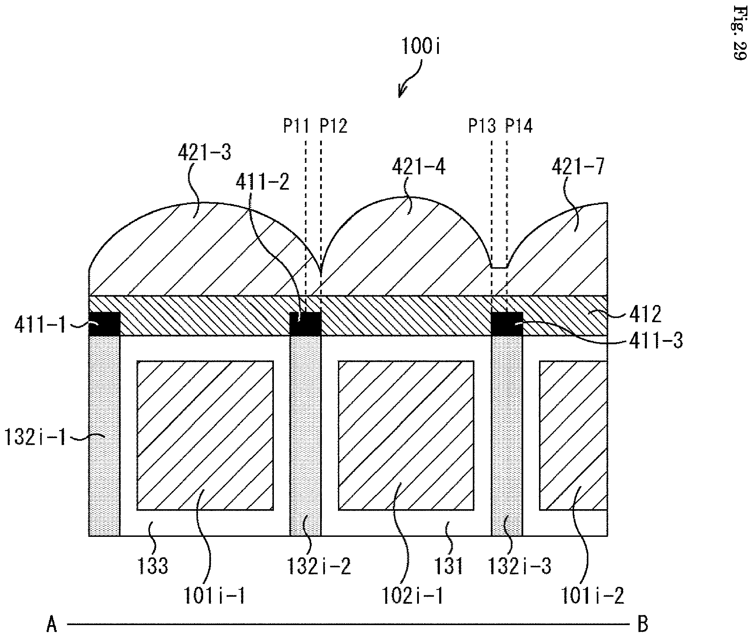

   Fig. 29 illustrates a sectional configuration example of the unit pixel according to the ninth embodiment.
[Fig. 30]

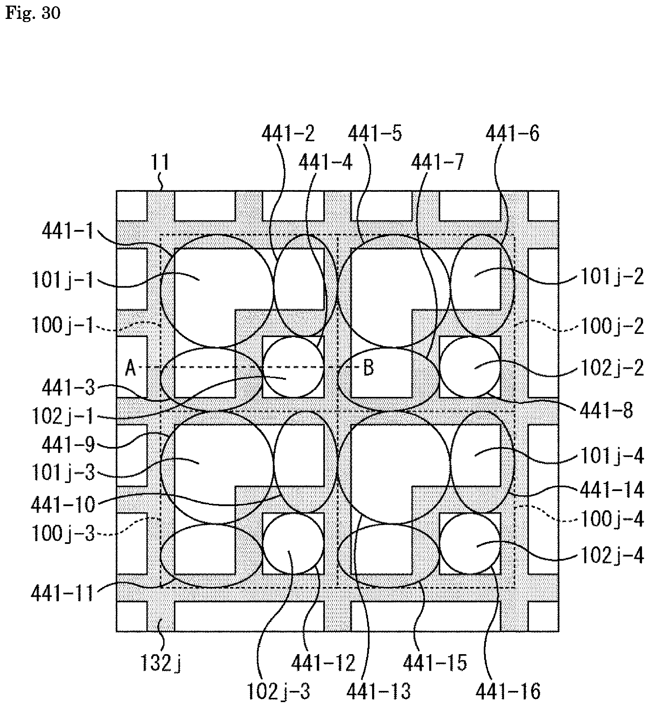

   Fig. 30 illustrates a plan configuration example of a unit pixel according to a tenth embodiment.
[Fig. 31]

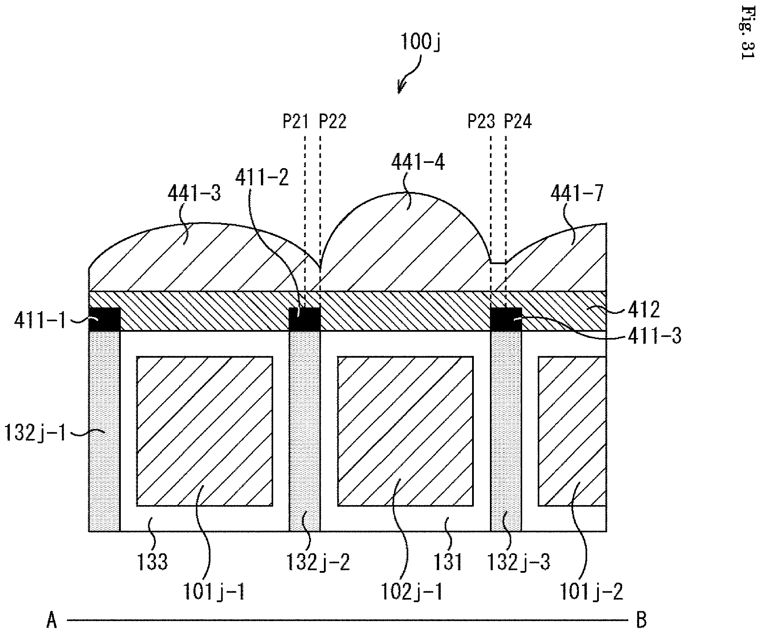

   Fig. 31 illustrates a sectional configuration example of the unit pixel according to the tenth embodiment.
[Fig. 32]

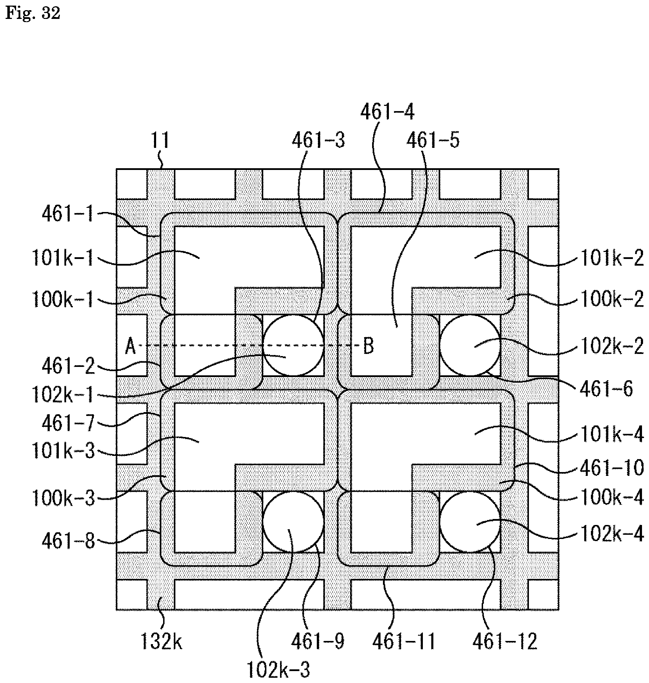

   Fig. 32 illustrates a plan configuration example of a unit pixel according to an eleventh embodiment.
[Fig. 33]

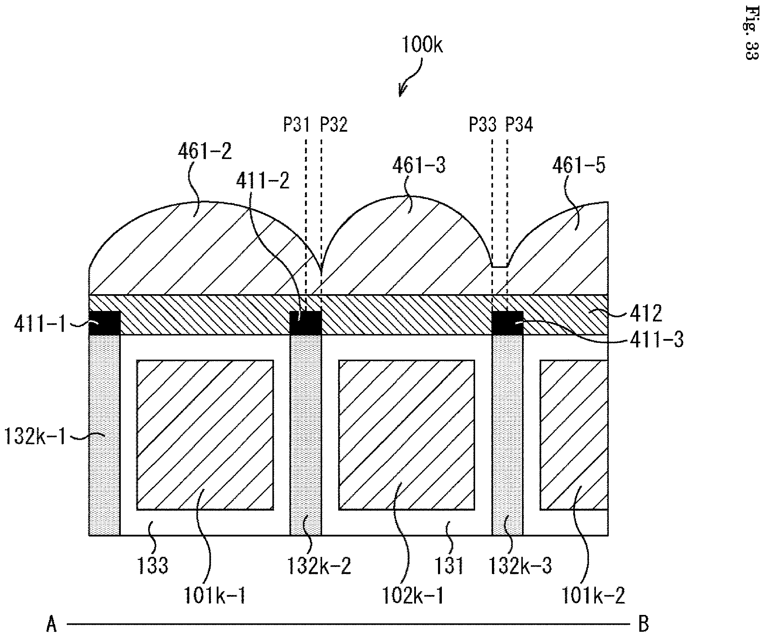

   Fig. 33 illustrates a sectional configuration example of the unit pixel according to the eleventh embodiment.
[Fig. 34]

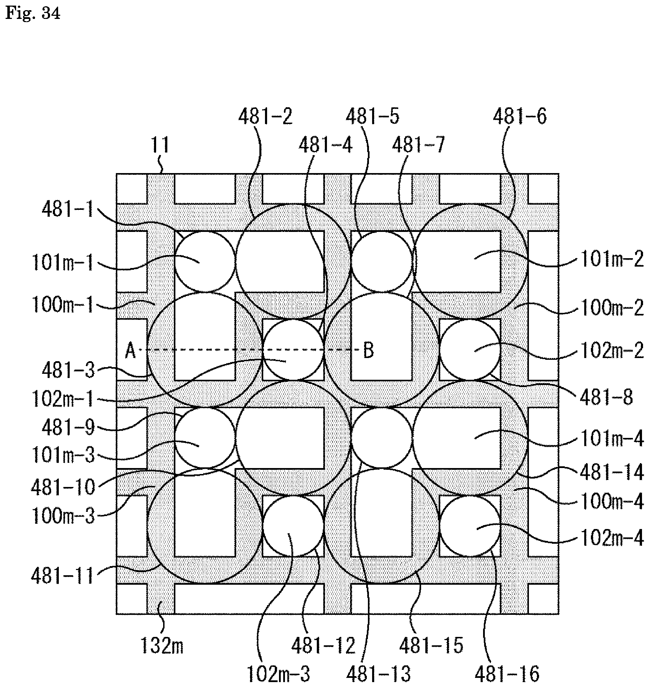

   Fig. 34 illustrates a plan configuration example of a unit pixel according to a twelfth embodiment.
[Fig. 35]

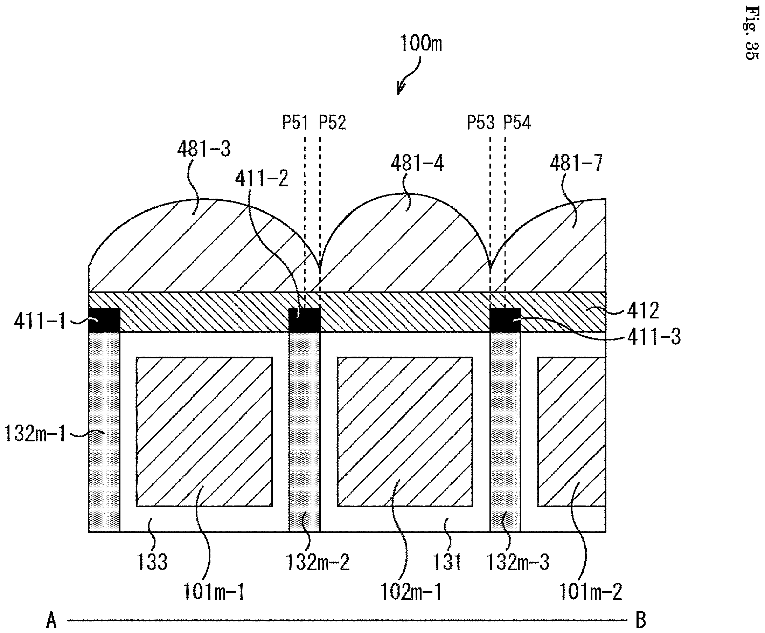

   Fig. 35 illustrates a sectional configuration example of the unit pixel according to the twelfth embodiment.
[Fig. 36]

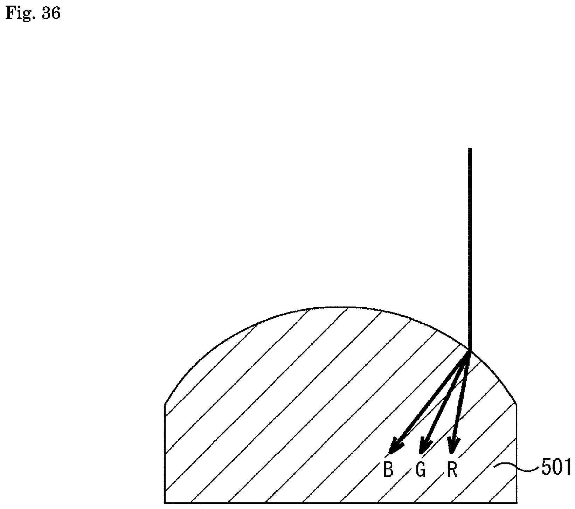

   Fig. 36 is an explanatory drawing of the traveling direction of light according to a difference in refractive index.
[Fig. 37]

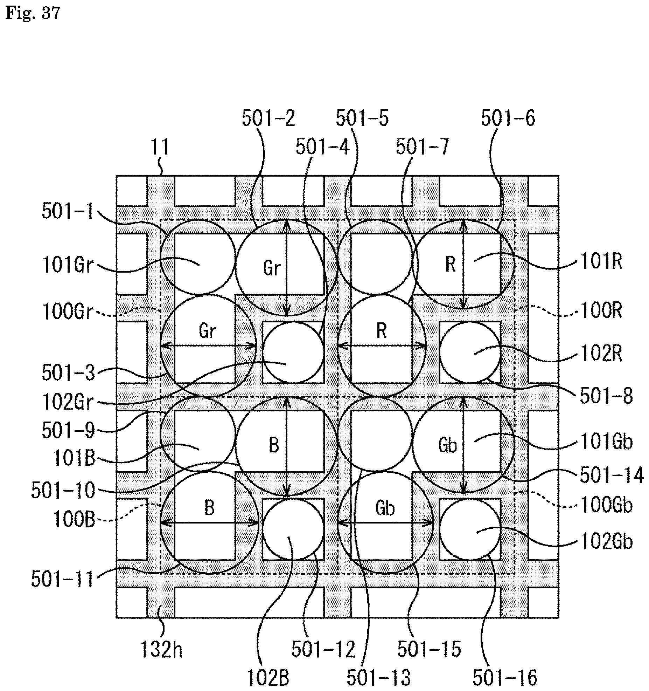

   Fig. 37 illustrates a plan configuration example of a unit pixel according to a thirteenth embodiment.
[Fig. 38]

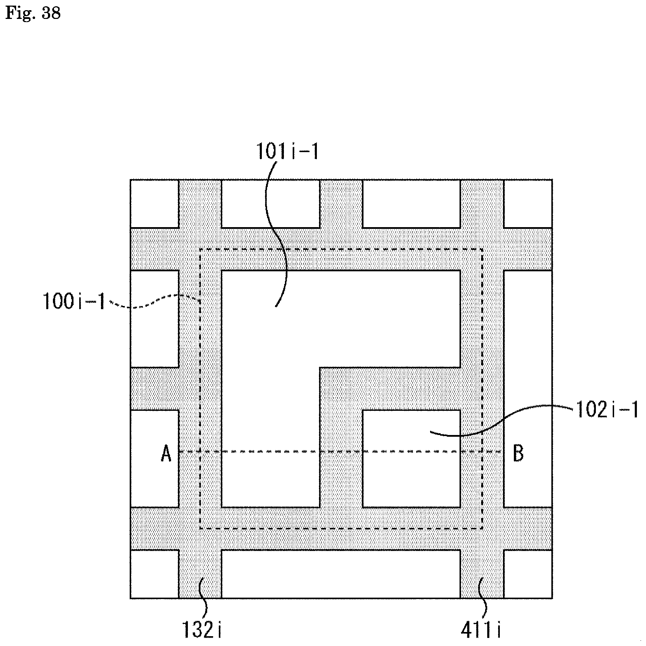

   Fig. 38 is an explanatory drawing of the positional relationship between a light shielding film and an inter-pixel isolation portion.
[Fig. 39]

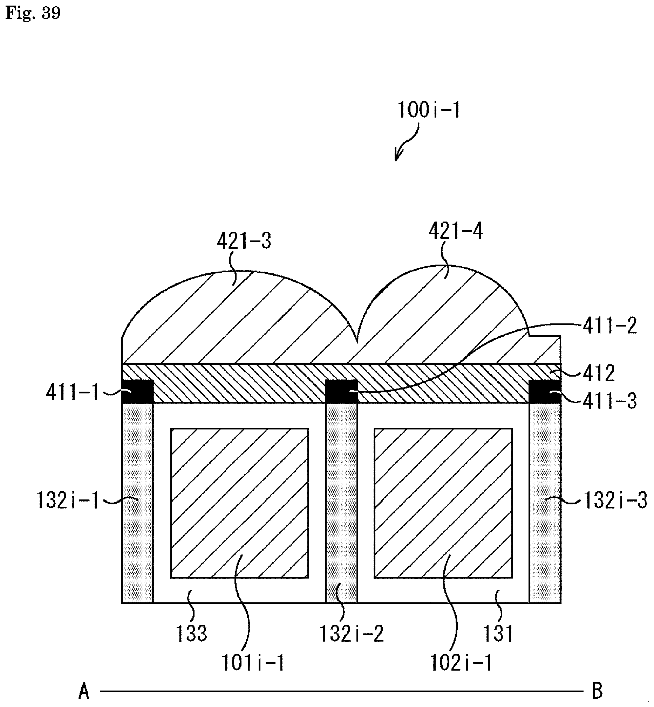

   Fig. 39 is an explanatory drawing of the positional relationship between the light shielding film and the inter-pixel isolation portion.
[Fig. 40]

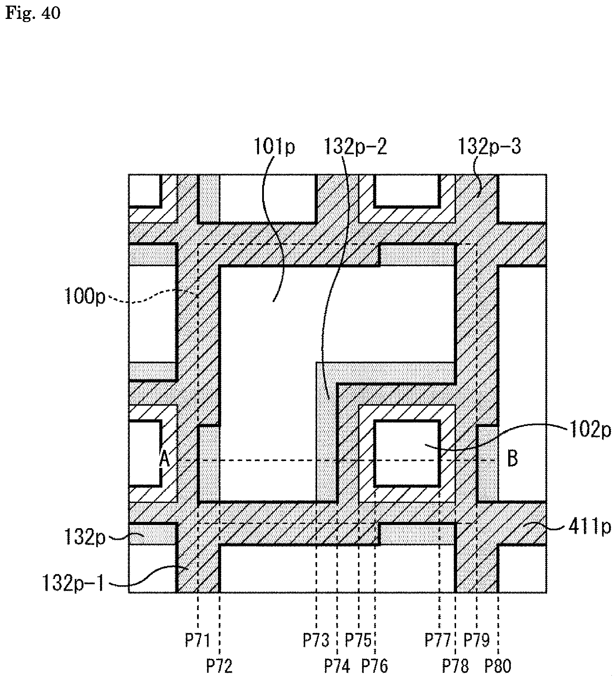

   Fig. 40 illustrates a plan configuration example of a unit pixel according to a fourteenth embodiment.
[Fig. 41]

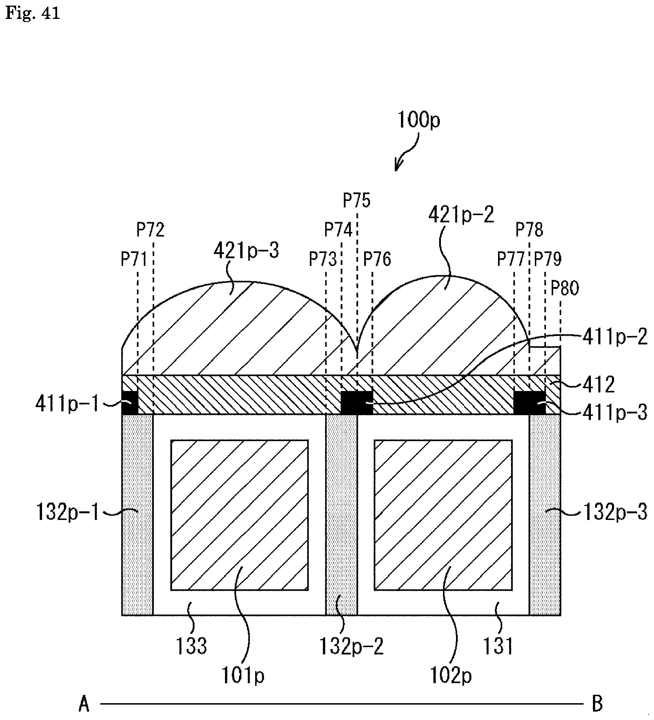

   Fig. 41 illustrates a sectional configuration example of the unit pixel according to the fourteenth embodiment.
[Fig. 42]

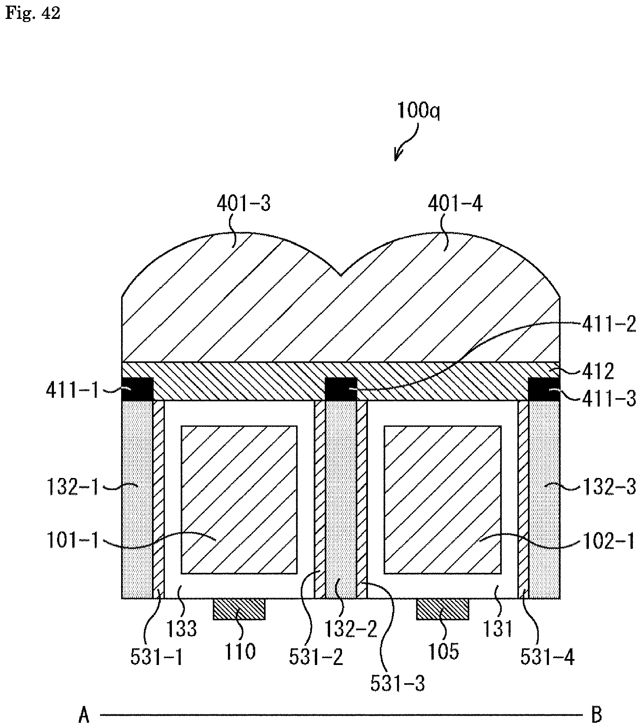

   Fig. 42 illustrates a sectional configuration example of a unit pixel according to a fifteenth embodiment.
[Fig. 43]

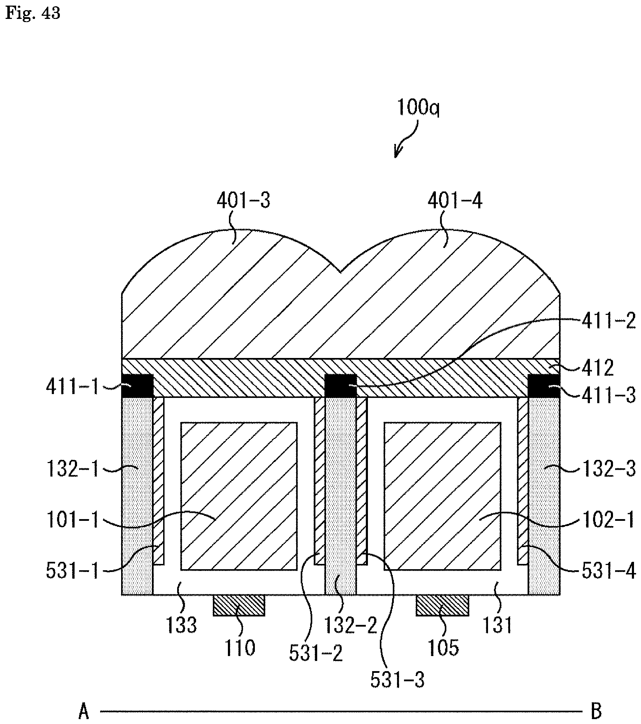

   Fig. 43 illustrates another sectional configuration example of the pixel according to the fifteenth embodiment.
[Fig. 44]

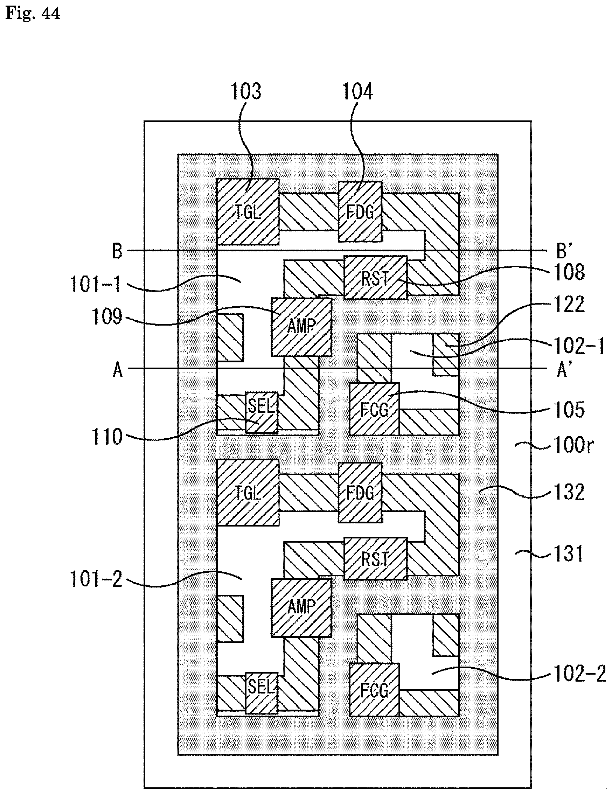

   Fig. 44 illustrates a plan configuration example of a unit pixel according to a sixteenth embodiment.
[Fig. 45]

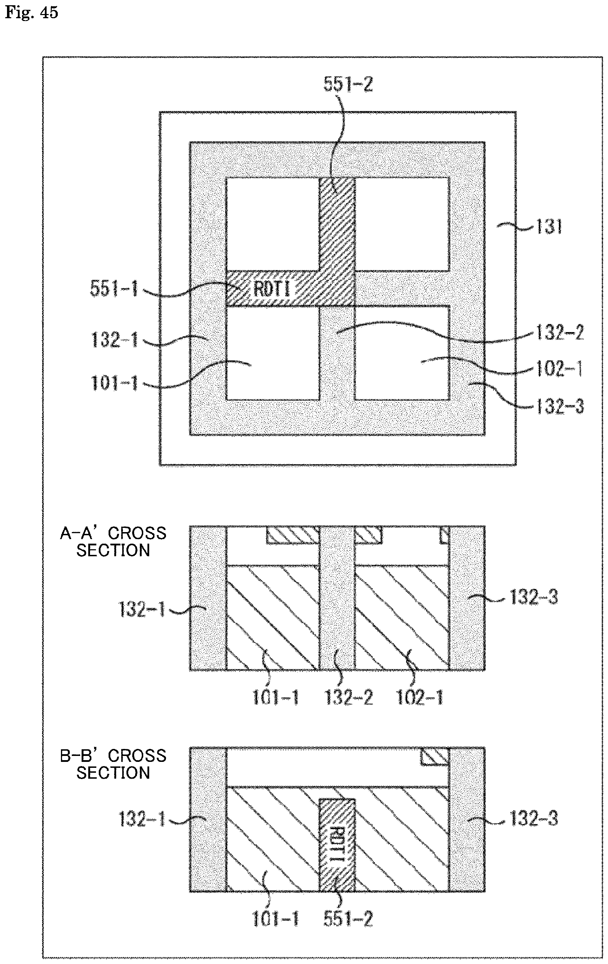

   Fig. 45 illustrating a configuration example of the unit pixel in plan view and cross-sectional view according to the fifteenth embodiment.
[Fig. 46]

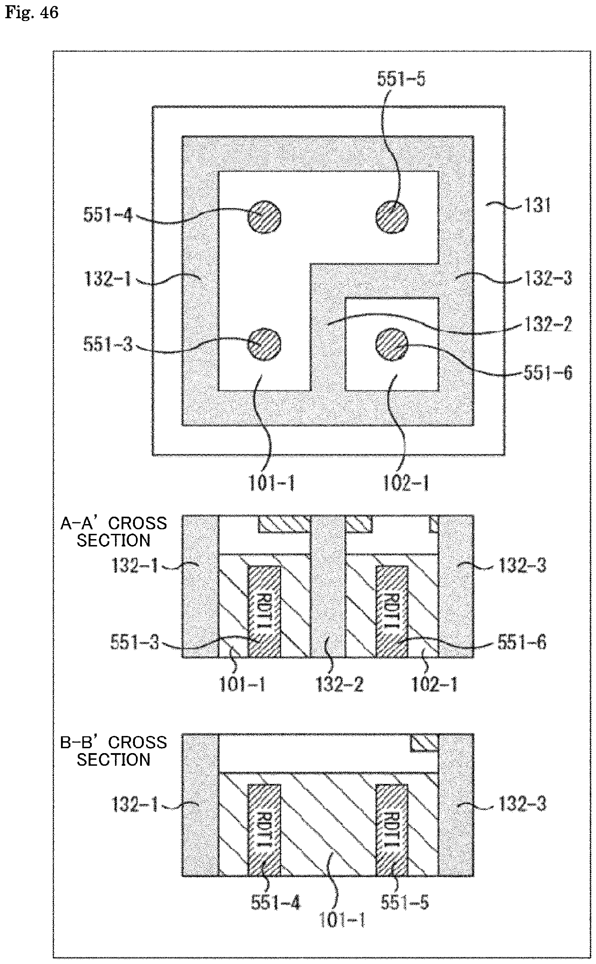

   Fig. 46 illustrates another configuration example of the unit pixel in plan view and cross-sectional view according to the fifteenth embodiment.
[Fig. 47]

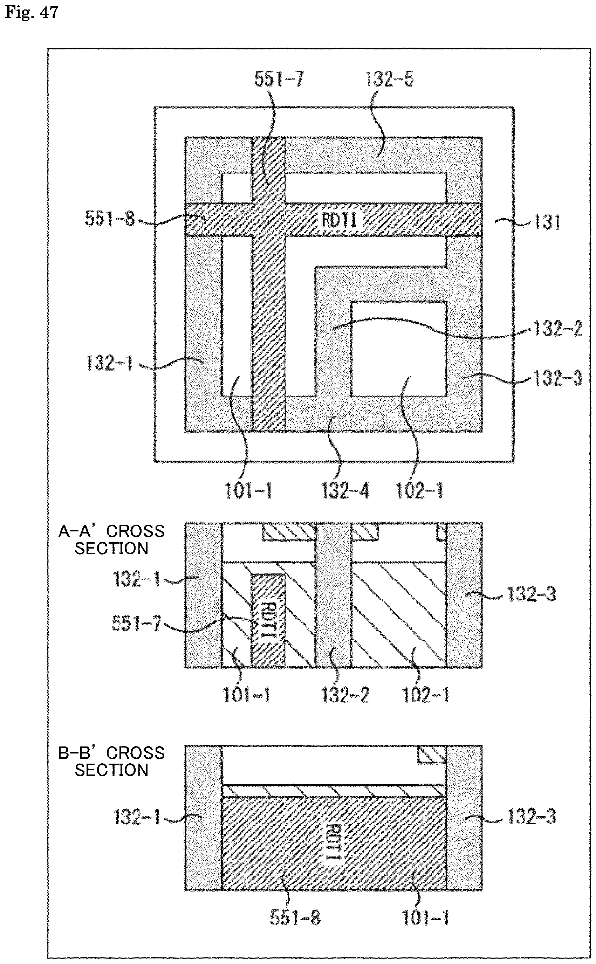

   Fig. 47 illustrates another configuration example of the pixel unit in plan view and cross-sectional view according to the fifteenth embodiment.
[Fig. 48]

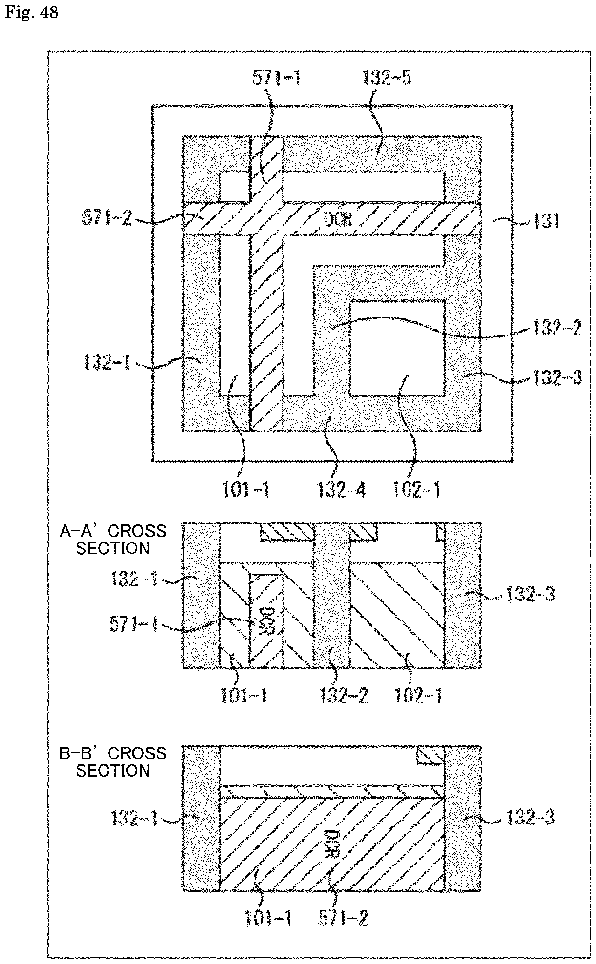

   Fig. 48 illustrates another configuration example of the unit pixel in plan view and cross-sectional view according to the fifteenth embodiment.
[Fig. 49]

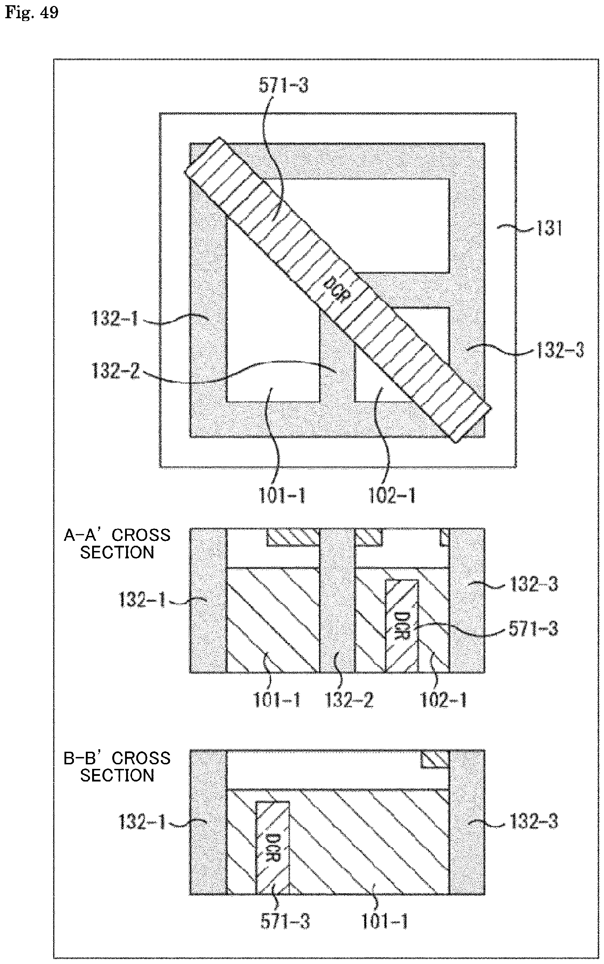

   Fig. 49 illustrates another configuration example of the unit pixel in plan view and cross-sectional view according to the fifteenth embodiment.
[Fig. 50]

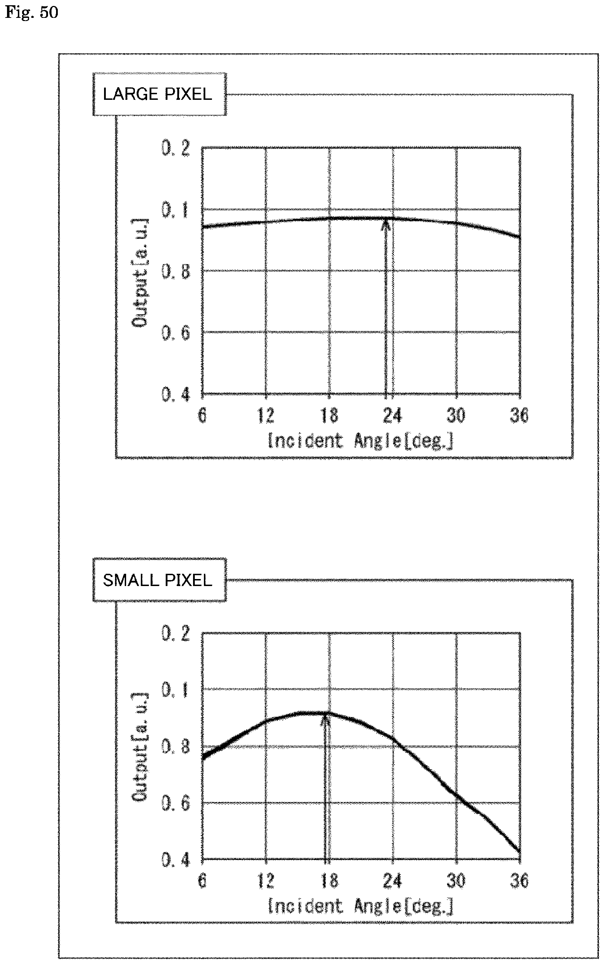

   Fig. 50 is an explanatory drawing of a difference in sensitivity between a large pixel and a small pixel.
[Fig. 51]

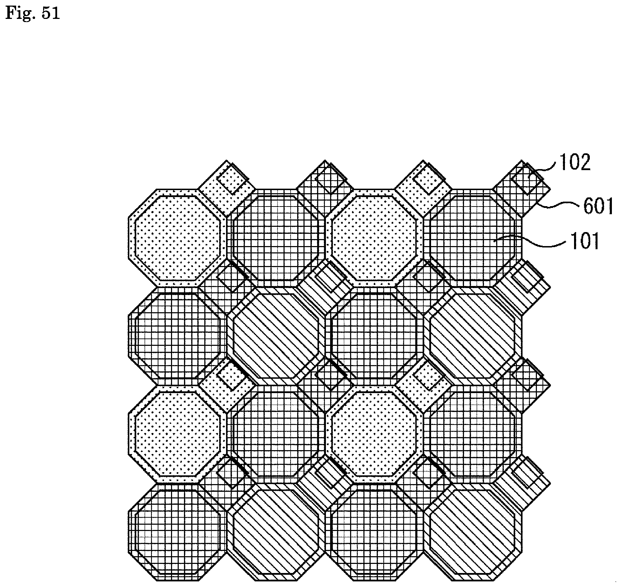

   Fig. 51 illustrates a configuration example of the unit pixel in plan view and cross-sectional view according to the sixteenth embodiment.
[Fig. 52]

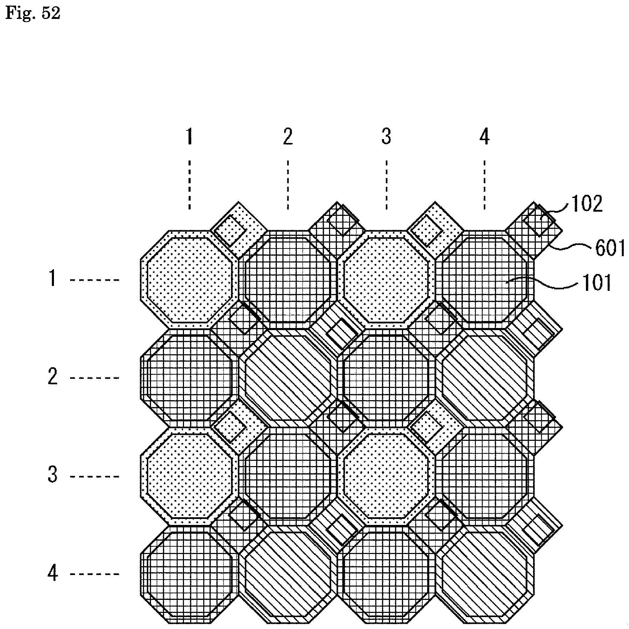

   Fig. 52 illustrates another configuration example of the unit pixel in plan view and cross-sectional view according to the fifteenth embodiment.
[Fig. 53]

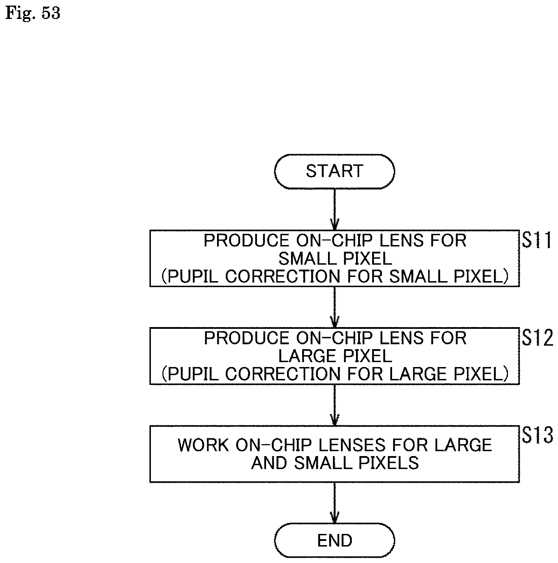

   Fig. 53 is an explanatory drawing of the production of on-chip lenses for a large pixel and a small pixel.
[Fig. 54]

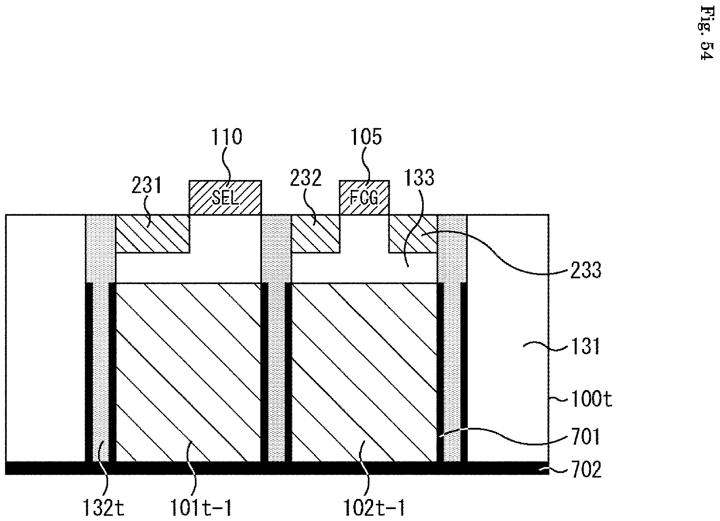

   Fig. 54 illustrates a sectional configuration example of a unit pixel according to an eighteenth embodiment.
[Fig. 55]

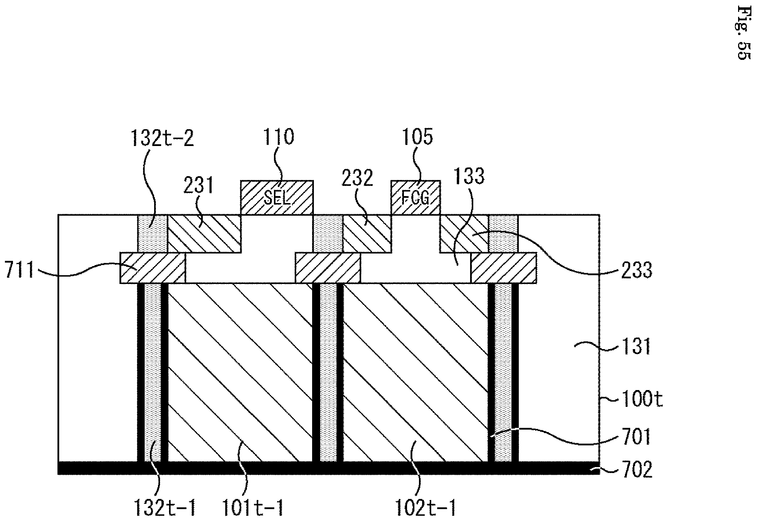

   Fig. 55 illustrates another sectional configuration example of the unit pixel according to the eighteenth embodiment.
[Fig. 56]

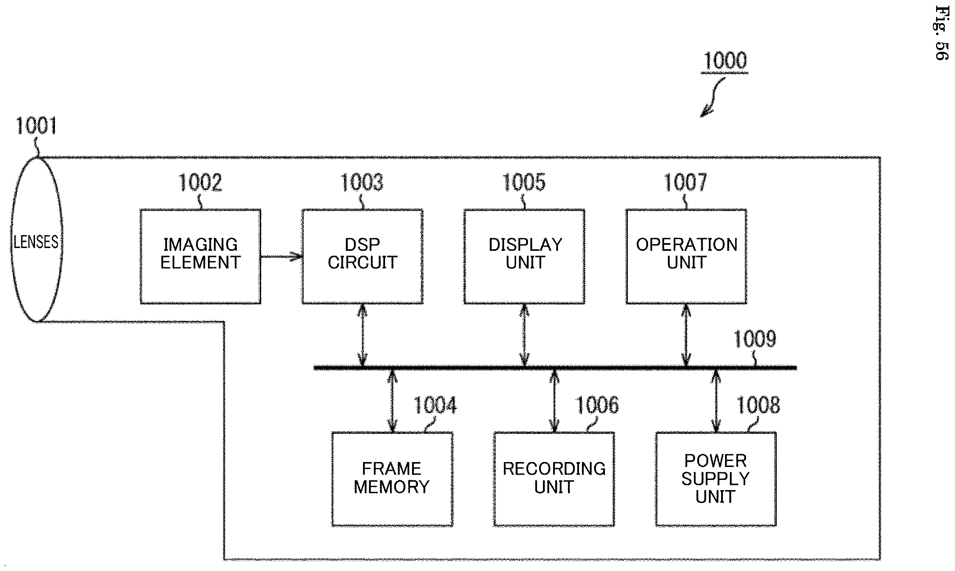

   Fig. 56 illustrates an exemplary configuration of an electronic device.
[Fig. 57]

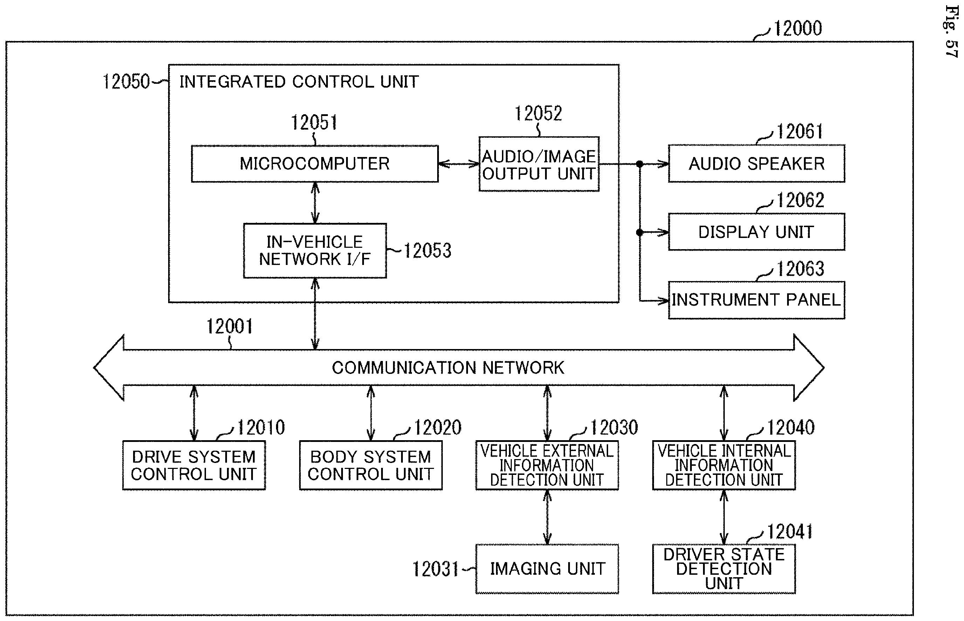

   Fig. 57 is a block diagram illustrating an example of a schematic configuration of a vehicle control system.
[Fig. 58]

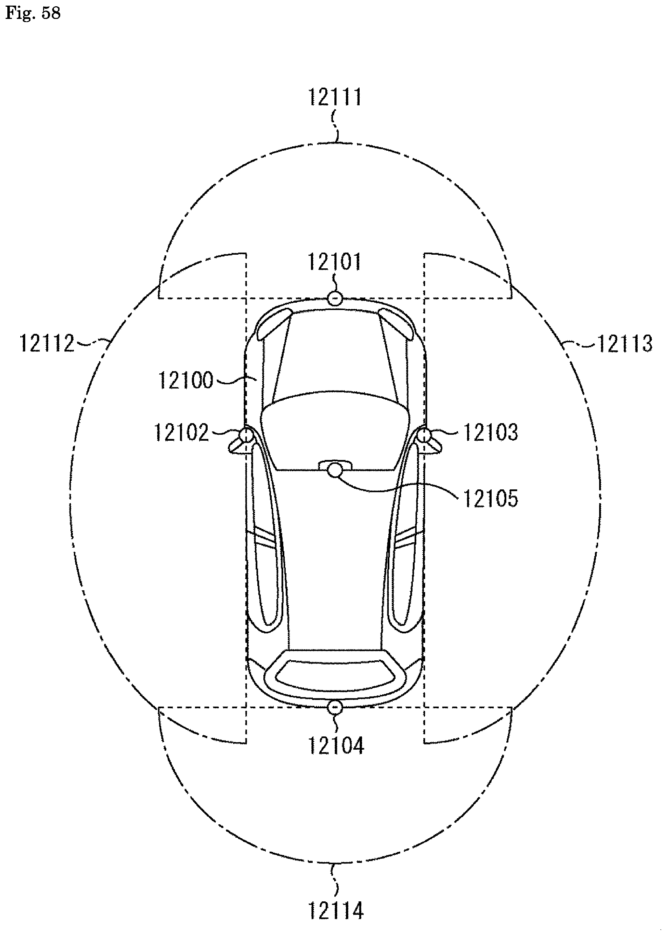

   Fig. 58 is an explanatory drawing illustrating an example of the installation positions of a vehicle external information detecting unit and an imaging unit.

### [Description of Embodiments]

Hereinafter, modes for carrying out the present technique (hereinafter referred to as embodiments) will be described.

### <Configuration of Imaging Device>

Fig. 1 is a system block diagram schematically illustrating the configuration of an imaging device to which the present technique is applied, for example, the configuration of a CMOS image sensor, a kind of X-Y address-system imaging device. In this case, the CMOS image sensor is an image sensor for which a CMOS process is applied or the CMOS process is partially used. For example, an imaging device is configured with a backside illumination CMOS image sensor.

An imaging device 10 includes a pixel array unit 11 formed on a semiconductor substrate (chip), which is not illustrated, and a peripheral circuit part integrated on the same semiconductor substrate as the pixel array unit 11. The peripheral circuit part includes, for example, a vertical driving unit 12, a column processing unit 13, a horizontal driving unit 14, a system control unit 15.

The imaging device 10 further includes a signal processing unit 18 and a data storage unit 19. The processing of the signal processing unit 18 and the data storage unit 19 includes processing performed by an external signal processing unit provided on a different substrate from the imaging device 10, for example, a DSP (Digital Signal Processor) circuit or software.

The pixel array unit 11 is configured such that unit pixels (hereinafter may be simply referred to as "pixels") are arranged in a row direction and a column direction, that is, in rows and columns in a two-dimensional array, the unit pixel including a photoelectric conversion unit that generates and accumulates an electric charge according to the amount of received light. In this configuration, the row direction refers to the direction of arrangement of the pixels in a pixel row (that is, a horizontal direction) and the column direction refers to the direction of arrangement of the pixels in a pixel column (that is, a vertical direction). The specific circuit configuration and the pixel structure of the unit pixels will be specifically described later.

In the pixel array unit 11, for a pixel array in a matrix form, a pixel driving line 16 is provided for each pixel row along the row direction and a vertical signal line 17 is provided for each pixel column along the column direction. The pixel driving line 16 transmits a driving signal for performing driving when a signal is read from the pixel. The pixel driving line 16 illustrated as a single wire in Fig. 1 is not limited to a single wire. One end of the pixel driving line 16 is connected to an output end of the vertical driving unit 12, the output end corresponding to each row.

The vertical driving unit 12 is configured with a shift register and an address decoder or the like and drives all the pixels of the pixel array unit 11 at the same time or drives the pixels for each row. In other words, the vertical driving unit 12 constitutes a driving unit that controls the operations of the pixels of the pixel array unit 11, with the system control unit 15 for controlling the vertical driving unit 12. The vertical driving unit 12 typically includes two scanning systems, that is, a reading scan system and a sweeping scan system, though the specific configuration of the vertical driving unit 12 is not illustrated.

The reading scan system sequentially selects and scans the unit pixels of the pixel array unit 11 for each row in order to read signals from the unit pixels. The signals read from the unit pixels are analog signals. The sweeping scan system performs a sweeping scan on the reading row to be subjected to a reading scan by the reading scan system, at a time preceding the reading scan by an exposure time.

The sweeping scan by the sweeping scan system sweeps unnecessary charges from the photoelectric conversion units of the unit pixels in the reading row, thereby resetting the photoelectric conversion units. A so-called electronic shutter operation is performed by sweeping (resetting) the unnecessary charges through the sweeping scan system. In this case, the electronic shutter operation refers to an operation of discarding the charge of the photoelectric conversion unit and starting another exposure (starting charge accumulation).

A signal read through a reading operation by the reading scan system corresponds to the amount of light received after the preceding reading operation or the electronic shutter operation. In addition, a period from the timing of reading by the preceding reading operation or the timing of sweeping by the electronic shutter operation to the timing of reading by the current reading operation serves as an exposure period of an electric charge in the unit pixels.

Signals output from the unit pixels in the pixel row selected and scanned by the vertical driving unit 12 are input to the column processing unit 13 through the vertical signal lines 17 for the respective pixel columns. The column processing unit 13 performs, for each pixel column of the pixel array unit 11, predetermined signal processing on the signals output from the pixels of the selected row through the vertical signal lines 17 and temporarily holds the pixel signals after the signal processing.

Specifically, the column processing unit 13 performs, as signal processing, at least noise removal processing such as CDS (Correlated Double Sampling) processing or DDS (Double Data Sampling) processing. For example, the CDS processing removes fixed pattern noise unique to the pixels, e.g., reset noise and variations in threshold value among amplification transistors in the pixels. In addition to noise removal, the column processing unit 13 may have, for example, an AD (analog-digital) conversion function of converting an analog pixel signal into a digital signal and output the digital signal.

The horizontal driving unit 14 is configured with a shift register and an address decoder or the like and sequentially selects unit circuits, which correspond to the pixel columns, in the column processing unit 13. Through a selective scan by the horizontal driving unit 14, the pixel signals subjected to the signal processing for each unit circuit in the column processing unit 13 are sequentially output.

The system control unit 15 is configured with, for example, a timing generator that generates various timing signals and controls driving of the vertical driving unit 12, the column processing unit 13, and the horizontal driving unit 14 or the like on the basis of the various timing signals generated by the timing generator.

The signal processing unit 18 has at least an arithmetic processing function and performs various kinds of signal processing such as arithmetic processing on a pixel signal output from the column processing unit 13. The data storage unit 19 temporarily stores data required for the signal processing in the signal processing unit 18.

### <Circuit Configuration of Unit Pixel>

Fig. 2 is a circuit diagram illustrating a configuration example of a unit pixel 100 disposed in the pixel array unit 11 of Fig. 1.

The unit pixel 100 includes a first photoelectric conversion unit 101, a second photoelectric conversion unit 102, a first transfer transistor 103, a second transfer transistor 104, a third transfer transistor 105, an in-pixel capacitor 106, an FD (floating diffusion) unit 107, a reset transistor 108, an amplification transistor 109, and a selection transistor 110.

The reset transistor 108 and the amplification transistor 109 are connected to a power supply voltage VDD. The in-pixel capacitor 106 is connected to a power supply voltage FCVDD. The first photoelectric conversion unit 101 includes a so-called embedded photodiode that has an n-type impurity region formed in a p-type impurity region formed in a silicon semiconductor substrate. Likewise, the second photoelectric conversion unit 102 includes an embedded photodiode. The first photoelectric conversion unit 101 and the second photoelectric conversion unit 102 generate a signal charge corresponding to an amount of received light and accumulates the generated charge to a certain amount.

The unit pixel 100 further includes the in-pixel capacitor 106. The in-pixel capacitor 106 is configured with, for example, a MOS capacitor or a MIS capacitor.

In Fig. 2, the first transfer transistor 103, the second transfer transistor 104, and the third transfer transistor 105 are connected in series between the first photoelectric conversion unit 101 and the second photoelectric conversion unit 102. A floating diffusion layer connected between the first transfer transistor 103 and the second transfer transistor 104 serves as the FD unit 107.

For the unit pixels 100, a plurality of driving lines are provided for, for example, the respective pixel rows as the pixel driving lines 16 in Fig. 1. Furthermore, various driving signals TGL, FDG, FCG, RST, and SEL are supplied from the vertical driving unit 12 of Fig. 1 via the plurality of driving lines. These driving signals are pulse signals that are activated in a high-level (e.g., the power supply voltage VDD) state and are deactivated in a low-level state (e.g., a negative potential) because each transistor of the unit pixel 100 is an NMOS transistor.

The driving signal TGL is applied to the gate electrode of the first transfer transistor 103. When the driving signal TGL is activated, the first transfer transistor 103 is brought into conduction and a charge accumulated in the first photoelectric conversion unit 101 is transferred to the FD unit 107 through the first transfer transistor 103.

The driving signal FDG is applied to the gate electrode of the second transfer transistor 104. When the driving signal FDG is activated and the second transfer transistor 104 is brought into conduction, the potentials of the FD unit 107 and a node 112 are coupled to become a single charge accumulation region.

The driving signal FCG is applied to the gate electrode of the third transfer transistor 105. When the driving signal FDG and the driving signal FCG are activated and the second transfer transistor 104 and the third transfer transistor 105 are brought into conduction, potentials from the FD unit 107 to the in-pixel capacitor 106 are coupled to become a single charge accumulation region.

When the third transfer transistor 105 and the second transfer transistor 104 are activated, potentials from the in-pixel capacitor 106 to the FD unit 107 are coupled and a charge accumulated in the second photoelectric conversion unit 102 is transferred to the coupled charge accumulation region. The in-pixel capacitor 106 accumulates a charge overflowing the second photoelectric conversion unit 102.

In addition to the second transfer transistor 104, the reset transistor 108 is connected to the node 112. To the reset transistor, a specific potential, for example, the power supply voltage VDD is connected. The driving signal RST is applied to the gate electrode of the reset transistor 108. When the driving signal RST is activated, the reset transistor 108 is brought into conduction and the potential of the node 112 is reset to the level of the voltage VDD.

When the driving signal RST is activated, the driving signal FDG of the second transfer transistor 104 and the driving signal FCG of the third transfer transistor 105 are activated, so that the coupled potentials of the node 112 and the FD unit 107 are reset to the level of the voltage VDD.

The FD unit 107 serving as a floating diffusion layer is charge-voltage conversion means. Specifically, when a charge is transferred to the FD unit 107, the potential of the FD unit 107 changes according to the amount of the transferred charge.

A current source (not illustrated) connected to one end of the vertical signal line 17 is connected to the source side of the amplification transistor 109, and the power supply voltage VDD is connected to the drain side of the amplification transistor 109. The amplification transistor 109 constitutes a source follower circuit together with the current source and the power supply voltage VDD. The FD unit 107 is connected to the gate electrode of the amplification transistor 109 and serves as the input of the source follower circuit.

The selection transistor 110 is connected between the source of the amplification transistor 109 and the vertical signal line 17. The driving signal SEL is applied to the gate electrode of the selection transistor 110. When the driving signal SEL is activated, the selection transistor 110 is brought into conduction, and the unit pixel 100 is placed in a selected state.

When a charge is transferred to the FD unit 107, the potential of the FD unit 107 becomes a potential according to the amount of the transferred charge, and then the potential is input to the source follower circuit. When the driving signal SEL is activated, the potential of the FD unit 107 is output as the output of the source follower circuit to the vertical signal line 17 through the selection transistor 110, the potential corresponding to the amount of the charge.

The first photoelectric conversion unit 101 has the photodiode with a larger light-receiving area than the second photoelectric conversion unit 102. Thus, if a subject is photographed with a predetermined illuminance level for a predetermined exposure time, a charge generated in the first photoelectric conversion unit 101 is larger than a charge generated in the second photoelectric conversion unit 102.

Thus, if the charge generated in the first photoelectric conversion unit 101 and the charge generated in the second photoelectric conversion unit 102 are transferred to the FD unit 107 and are subjected to charge-voltage conversion, a voltage change before and after the transfer of the charge generated in the first photoelectric conversion unit 101 to the FD unit 107 is larger than a voltage change before and after the transfer of the charge generated in the second photoelectric conversion unit 102 to the FD unit 107. Thus, a comparison between the first photoelectric conversion unit 101 and the second photoelectric conversion unit 102 indicates that the first photoelectric conversion unit 101 has higher sensitivity than the second photoelectric conversion unit 102.

In contrast, the second photoelectric conversion unit 102 has a structure directly coupled to the in-pixel capacitor 106. Thus, even if light enters with a high illuminance level, a charge generated in the second photoelectric conversion unit 102 can be accumulated in the in-pixel capacitor 106. When a charge generated in the second photoelectric conversion unit 102 is subjected to charge-voltage conversion, a charge accumulated in the in-pixel capacitor 106 can be subjected to charge-voltage conversion.

Thus, the second photoelectric conversion unit 102 can take a photograph of an image with a gradation over a wide illuminance range unlike the first photoelectric conversion unit 101. In other words, an image with a wide dynamic range can be photographed.

The two images, that is, the image photographed with high sensitivity by using the first photoelectric conversion unit 101 and the image photographed with a wide dynamic range by using the second photoelectric conversion unit 102 are synthesized into an image through wide-dynamic-range image synthesis that synthesizes two images into an image in, for example, an image signal processing circuit provided in the imaging device 10 or an image signal processing device connected to the outside of the imaging device 10.

As will be described later, a configuration that captures two or more images and performs image synthesis to synthesize one of the two or more captured images may be used.

### <First Embodiment>

Figs. 3 to 5 illustrate a configuration example of a unit pixel 100a disposed in a pixel array unit 11 according to a first embodiment. Figs. 3 to 5 illustrate the two unit pixels 100a vertically disposed in the pixel array unit 11.

Fig. 3 illustrates a configuration example of the front side of a semiconductor substrate 131 on which a first photoelectric conversion unit 101a and a second photoelectric conversion unit 102a are formed, the front side having transistors or the like disposed thereon. Fig. 4 illustrates a configuration example of the backside of the semiconductor substrate 131. Fig. 5 illustrates a configuration example of an on-chip lens 161 disposed on the back side of the semiconductor substrate 131. The front side of the semiconductor substrate 131 is a side where a wiring layer (not illustrated) is formed, and the back side is an entrance surface side where light enters.

A first photoelectric conversion unit 101a-1 is disposed on the upper side in the drawings, and a first photoelectric conversion unit 101a-2 is disposed on the lower side in the drawings. The first photoelectric conversion unit 101a is shaped like a square, and the second photoelectric conversion units 102a are provided at the corner regions. As a result, the first photoelectric conversion unit 101a is shaped like an octagon as illustrated in Fig. 3.

A second photoelectric conversion unit 102a-1 is provided at the upper-left corner region of the first photoelectric conversion unit 101a-1, and a second photoelectric conversion unit 102a-2 is provided at the upper-right corner region of the first photoelectric conversion unit 101a-1.

A second photoelectric conversion unit 102a-3 is provided at a region that is the lower-left corner region of the first photoelectric conversion unit 101a-1 and the upper-left corner region of the first photoelectric conversion unit 101a-2. A second photoelectric conversion unit 102a-4 is provided at a region that is the lower-right corner region of the first photoelectric conversion unit 101a-1 and the upper-right corner region of the first photoelectric conversion unit 101a-2.

A second photoelectric conversion unit 102a-5 is provided at the lower-left corner region of the first photoelectric conversion unit 101a-2, and a second photoelectric conversion unit 102a-6 is provided at the lower-right corner region of the first photoelectric conversion unit 101a-1.

In the following description, the first photoelectric conversion unit 101a-1 and the second photoelectric conversion unit 102a-2 constitutes the unit pixel 100a having the circuit configuration of Fig. 2. In other words, in the following example, the unit pixel 100a is configured with the first photoelectric conversion unit 101a and the second photoelectric conversion unit 102a located at the upper right of the first photoelectric conversion unit 101a.

The unit pixel 100a configured with the first photoelectric conversion unit 101a-1 and the second photoelectric conversion unit 102a-2 and the unit pixel 100a configured with the first photoelectric conversion unit 101a-2 and the second photoelectric conversion unit 102a-4 are identical in configuration. Thus, the unit pixel 100a configured with the first photoelectric conversion unit 101a-1 and the second photoelectric conversion unit 102a-2 is described in the following example.

Referring to Fig. 3, a first transfer transistor 103, a second transfer transistor 104, a reset transistor 108, an amplification transistor 109, and a selection transistor 110 are formed in a region where the first photoelectric conversion unit 101a-1 is formed. These transistors are connected via an N+ diffusion layer corresponding to a source or a drain that is formed in the semiconductor substrate 131. In the region of the first photoelectric conversion unit 101a-1, a PCON 121 used as a contact to be connected to wires formed in other layers or a power supply voltage is also formed.

In a region where the second photoelectric conversion unit 102a-2 is formed, a third transfer transistor 105 for the second photoelectric conversion unit 102a-2 and a PCON 122 (contact) are disposed, the PCON 122 being connected to wires formed in other layers and a power supply voltage. The second photoelectric conversion unit 102a-1 corresponds to a small pixel having a small light-receiving area, and at least one transistor (the third transfer transistor 105 in Fig. 3) and a contact (the PCON 122 in Fig. 3) are formed in the region of the second photoelectric conversion unit 102a-1.

The third transfer transistor 105 and the PCON 122 (at least one transistor and a contact) are also disposed in the second photoelectric conversion units 102a-1, 102a-3, 102a-5, and 102a-6, though the illustration thereof is omitted.

Referring to Fig. 4, the first photoelectric conversion unit 101a and the second photoelectric conversion unit 102a are each surrounded by an inter-pixel isolation portion 132. The inter-pixel isolation portion 132 is formed between the first photoelectric conversion unit 101a and the adjacent first photoelectric conversion unit 101a and is configured to prevent light from leaking into the adjacent first photoelectric conversion unit 101a. The inter-pixel isolation portion 132 is formed between the first photoelectric conversion unit 101a and the adjacent second photoelectric conversion unit 102a and is configured to prevent light from leaking into the adjacent second photoelectric conversion unit 102a.

The inter-pixel isolation portion 132 is configured such that a trench penetrates the semiconductor substrate 131 in the depth direction and the trench is filled with an insulator in the semiconductor substrate 131 made of, for example, silicon. For example, SiO2 is used as the insulator. The structure in the trench may be a layer made of SiO2 alone or a multilayer configuration made of SiO2 and polysilicon. A metallic film made of, for example, aluminum or tungsten may be formed on the inter-pixel isolation portion 132.

As described above, the provision of the inter-pixel isolation portion 132 can prevent light from leaking into an adjacent pixel, thereby reducing color mixture. In the case of the structure where the first photoelectric conversion unit 101a acting as a large pixel and the second photoelectric conversion unit 102a acting as a small pixel are formed next to each other as illustrated in Fig. 3, even slight leakage of light into the small pixel (second photoelectric conversion unit 102a) may seriously affect image quality.

The provision of the inter-pixel isolation portion 132 reduces leakage of light into the second photoelectric conversion unit 102a acting as a small pixel. The configuration that prevents light from leaking into the second photoelectric conversion unit 102a allows the formation of an overflow path with a small depth, thereby improving the saturation signal amount of the first photoelectric conversion unit 101a acting as a large pixel. The increase in the saturation signal amount of the first photoelectric conversion unit 101a can delay a transition point at which signal processing is switched from the large pixel to the small pixel, thereby improving an SN ratio at the transition point.

Also in the second photoelectric conversion unit 102a, leakage of light from the first photoelectric conversion unit 101a is suppressed, thereby preventing a deterioration of image quality in the small pixel.

As illustrated in Fig. 5, the first photoelectric conversion unit 101a and the second photoelectric conversion unit 102a are provided with on-chip lenses 161 and 162, respectively. The first photoelectric conversion unit 101a-1 is provided with an on-chip lens 161-1, and the first photoelectric conversion unit 101a-2 is provided with an on-chip lens 161-2.

The second photoelectric conversion unit 102a-1 is provided with an on-chip lens 162-1, and the second photoelectric conversion unit 102a-2 is provided with an on-chip lens 162-2. Likewise, the second photoelectric conversion unit 102a-3 is provided with an on-chip lens 162-3, and the second photoelectric conversion unit 102a-4 is provided with an on-chip lens 162-4. Similarly, the second photoelectric conversion unit 102a-5 is provided with an on-chip lens 162-5, and the second photoelectric conversion unit 102a-6 is provided with an on-chip lens 162-6.

Since the first photoelectric conversion unit 101a and the second photoelectric conversion unit 102a have different light-receiving areas, the on-chip lens 161 and the on-chip lens 162 are also formed in different sizes.

As described above, according to the present technique, the saturation signal amount of the large pixel (first photoelectric conversion unit 101a) can be increased, the transition point of signal processing to the small pixel (second photoelectric conversion unit 102a) can be delayed, and an SN ratio by the transition point can be improved. Blooming from the large pixel to the small pixel can be also suppressed, thereby preventing a deterioration of image quality of the small pixel.

### <Second Embodiment>

Figs. 6 to 9 illustrate a configuration example of a unit pixel 100b disposed in a pixel array unit 11 according to a second embodiment. Figs. 6 to 9 illustrate the two unit pixels 100b vertically disposed in the pixel array unit 11.

Fig. 6 illustrates the configuration example on the front side of a semiconductor substrate 131 of the unit pixel 100b. Fig. 7 illustrates the configuration example on the back side of the semiconductor substrate 131. Fig. 8 illustrates a configuration example of an on-chip lens 181 disposed on the back side of the semiconductor substrate 131. Fig. 9 illustrates a sectional configuration example of the unit pixel 100b taken along line A-A' of Fig. 6.

The circuit configuration example of the unit pixel 100b in Figs. 6 to 9 is identical to the circuit configuration example of the unit pixel 100a according to the first embodiment illustrated in Fig. 2, and thus the description thereof is omitted. In the following description, the same parts as those of the unit pixel 100a according to the first embodiment are denoted by the same reference numerals, and the description thereof is omitted as necessary.

A first photoelectric conversion unit 101b-1 is disposed on the upper side in Figs. 6 to 8, and a first photoelectric conversion unit 101b-2 is disposed on the lower side in the drawings. As illustrated in Fig. 7, the first photoelectric conversion unit 101b is L-shaped. The second photoelectric conversion unit 102b is square-shaped.

The unit pixel 100b is configured with the L-shaped first photoelectric conversion unit 101b and the square-shaped second photoelectric conversion unit 102b. The shape is a combination of the first photoelectric conversion unit 101b and the second photoelectric conversion unit 102b, in other words, the unit pixel 100 is shaped like a quadrangle (a square in Figs. 6 to 8).

In the following description, an L-shape refers to a shape determined by vertical lines and horizontal lines, the vertical and horizontal lines having different lengths. In the present embodiment, an L-shape also includes vertical and horizontal lines having the same length. Moreover, an L-shape is shaped like an L and includes the shape when rotated by 90°, 180°, or 270°.

In the pixel array unit 11, the unit pixels 100b are arranged in a matrix, the unit pixel 100b being configured with the first photoelectric conversion unit 101b and the second photoelectric conversion unit 102b. The unit pixels 100b are isolated from each other by an inter-pixel isolation portion 132b. The inter-pixel isolation portion 132b is also formed between the first photoelectric conversion unit 101b and the second photoelectric conversion unit 102b. The first photoelectric conversion unit 101b and the second photoelectric conversion unit 102b are isolated from each other by the inter-pixel isolation portion 132b.

The first photoelectric conversion unit 101b is L-shaped and is formed as a region having a light-receiving area that is three times larger than that of the second photoelectric conversion unit 102b. The unit pixel 100b is configured with a large pixel having a light-receiving area that is three times larger than that of the second photoelectric conversion unit 102b and a small pixel having a light-receiving area that is one third that of the first photoelectric conversion unit 101b. With respect to the unit pixel 100b, the first photoelectric conversion unit 101b (large pixel) accounts for three fourths of the region of the unit pixel 100 and the second photoelectric conversion unit 102b (small pixel) accounts for one fourth of the region of the unit pixel 100.

The first photoelectric conversion unit 101b is configured with an L-shape, and the second photoelectric conversion unit 102b is placed in the recessed region of the L-shaped first photoelectric conversion unit 101b, thereby efficiently placing the first photoelectric conversion unit 101b and the second photoelectric conversion unit 102b without forming an unnecessary gap between the first photoelectric conversion unit 101b and the second photoelectric conversion unit 102b.

The first photoelectric conversion unit 101b-1 and the second photoelectric conversion unit 102b-2 constitute the unit pixel 100b having the circuit configuration of Fig. 2.

Referring to Fig. 6, a first transfer transistor 103, a second transfer transistor 104, a reset transistor 108, an amplification transistor 109, a selection transistor 110, and a PCON 121 are formed in a region where the first photoelectric conversion unit 101b-1 is formed. These transistors are connected via an N+ diffusion layer corresponding to a source or a drain that is formed in the semiconductor substrate 131.

In a region where the second photoelectric conversion unit 102b-2 is formed, a third transfer transistor 105 for the second photoelectric conversion unit 102b-2 and a PCON 122 (contact) are disposed, the PCON 122 being connected to wires formed in other layers and a power supply voltage. The second photoelectric conversion unit 102b-1 corresponds to a small pixel having a small light-receiving area, and at least one transistor and a contact are formed in the region of the second photoelectric conversion unit 102b-1.

Referring to Fig. 7, the first photoelectric conversion unit 101b and the second photoelectric conversion unit 102b are each surrounded by the inter-pixel isolation portion 132b. The inter-pixel isolation portion 132b is formed between the first photoelectric conversion unit 101b and the adjacent first photoelectric conversion unit 101b and is configured to prevent light from leaking into the adjacent first photoelectric conversion unit 101b. Likewise, the inter-pixel isolation portion 132b is formed between the first photoelectric conversion unit 101b and the adjacent second photoelectric conversion unit 102b and is configured to prevent light from leaking into the adjacent second photoelectric conversion unit 102b.

The inter-pixel isolation portion 132b is configured such that a trench penetrates the semiconductor substrate 131 in the depth direction and the trench is filled with an insulator in the semiconductor substrate 131 made of, for example, silicon. For example, SiO2 is used as the insulator. The structure in the trench may be a layer made of SiO2 alone or a multilayer configuration made of SiO2 and polysilicon. A metallic film made of, for example, aluminum or tungsten may be formed on the inter-pixel isolation portion 132b.

As illustrated in Fig. 8, the first photoelectric conversion unit 101b and the second photoelectric conversion unit 102b are each provided with the on-chip lens 181. The first photoelectric conversion unit 101b-1 is provided with on-chip lenses 181-1 to 181-3, and the first photoelectric conversion unit 101b-2 is provided with on-chip lenses 181-5 to 181-7.

The second photoelectric conversion unit 102b-1 is provided with an on-chip lens 181-4, and the second photoelectric conversion unit 102b-2 is provided with an on-chip lens 181-8.

The on-chip lenses 181-1 to 181-8 are circularly formed in the same size. The three on-chip lenses 181 are provided on the single first photoelectric conversion unit 101b. The three on-chip lenses 181 are disposed in an L-shape aligned with the L-shaped first photoelectric conversion unit 101b. The single on-chip lens 181 is disposed on the second photoelectric conversion unit 102b.

The first photoelectric conversion unit 101b and the second photoelectric conversion unit 102b have different light-receiving areas and thus are provided with different numbers of on-chip lenses 181. The sizes and positions of the on-chip lenses can be determined to suppress color mixture to the small pixel, which will be described later.

Referring to Fig. 9, in the unit pixel 100b taken along line A-A' of Fig. 6, the first photoelectric conversion unit 101b-1 is provided in the semiconductor substrate 131. The first photoelectric conversion unit 101b-1 is formed as a so-called embedded photodiode that has an n-type impurity region formed in a p-type impurity region 133 formed in the semiconductor substrate 131 made of silicon. The second photoelectric conversion unit 102b is also formed as an embedded photodiode, which is not illustrated.

The inter-pixel isolation portion 132b configured with a trench penetrating the semiconductor substrate 131 and an insulating material charged into the trench is provided around the first photoelectric conversion unit 101b.

The gate of the selection transistor 110 and the gate of the amplification transistor 109 are provided on the front side (the upper side in Fig. 9) of the semiconductor substrate 131. On the front side in the semiconductor substrate 131, an N-type diffusion layer 191, an N-type diffusion layer 192, and an N-type diffusion layer 193 are sequentially formed from the left side in Fig. 9. These N-type diffusion layers are diffusion layers acting as sources or drains of the connected transistors.

Referring to Figs. 9 and 6, the N-type diffusion layer 191 is a diffusion layer formed between the first transfer transistor 103 (denoted as TGL in Fig. 6) and the second transfer transistor 104 (denoted as FDG in Fig. 6).

The N-type diffusion layer 193 is a diffusion layer formed between the reset transistor 108 (denoted as RST in Fig. 6) and the amplification transistor 109 (denoted as AMP in Fig. 6). The N-type diffusion layer 193 is a diffusion layer formed between the amplification transistor 109 (denoted as AMP in Figs. 6 and 8) and the selection transistor 110 (denoted as SEL in Figs. 6 and 8).

An element isolation region 194 is formed between the N-type diffusion layer 191 and the N-type diffusion layer 192. The element isolation region 194 can have the same basic configuration as the inter-pixel isolation portion 132b. The element isolation region 194 can be configured with a trench not penetrating the semiconductor substrate 131 and an insulating material charged in the trench.

As described above, the unit pixel 100b is configured with the coexistence of the inter-pixel isolation portion 132b configured with the trench penetrating the semiconductor substrate 131 and the insulating material and the element isolation region 194 configured without penetration (non-penetrating) through the semiconductor substrate 131 and the insulating material.

Also in the unit pixel 100 according to the second embodiment, the saturation signal amount of the large pixel (first photoelectric conversion unit 101b) can be increased, the transition point of signal processing to the small pixel (second photoelectric conversion unit 102b) can be delayed, and an SN ratio by the transition point can be improved. Blooming from the large pixel to the small pixel can be also suppressed, thereby preventing a deterioration of image quality of the small pixel.

### <Third Embodiment>

Figs. 10 to 12 illustrate a configuration example of a unit pixel 100c disposed in a pixel array unit 11 according to a third embodiment. Figs. 10 to 12 illustrate the two unit pixels 100c vertically disposed in the pixel array unit 11.

Fig. 10 illustrates the configuration example on the front side of a semiconductor substrate 131 of the unit pixel 100c. Fig. 7 illustrates the configuration example on the back side of the semiconductor substrate 131. Fig. 8 illustrates a configuration example of an on-chip lens 181 disposed on the back side of the semiconductor substrate 131.

The circuit configuration example of the unit pixel 100c in Figs. 10 to 12 is identical to the circuit configuration example of the unit pixel 100a according to the first embodiment illustrated in Fig. 2, and thus the description thereof is omitted. The configuration example of the unit pixel 100c in Figs. 10 to 12 is basically identical to the configuration example of the unit pixel 100b in Figs. 6 to 9. Thus, the same parts are denoted by the same reference numerals and the description thereof is omitted.

An inter-pixel isolation portion 201 that isolates a first photoelectric conversion unit 101c and a second photoelectric conversion unit 102c in the unit pixel 100c illustrated in Figs. 10 to 12 is different from the inter-pixel isolation portion 132b that isolates the first photoelectric conversion unit 101b and the second photoelectric conversion unit 102b of the unit pixel 100b illustrated in Figs. 6 to 9, and other parts of the unit pixel 100c are identical to those of the unit pixel 100b.

Referring to Figs. 10 and 11, the unit pixel 100c including a first photoelectric conversion unit 101c 1 and a second photoelectric conversion unit 102c-1 is surrounded by an inter-pixel isolation portion 132c. Like the inter-pixel isolation portion 132a and the inter-pixel isolation portion 132b, the inter-pixel isolation portion 132c is configured with an insulator containing an insulating material charged in a trench penetrating the semiconductor substrate 131.

An inter-pixel isolation portion 201-1 formed between the first photoelectric conversion unit 101c-1 and the second photoelectric conversion unit 102c-1 that are included in the unit pixel 100c is configured with a P-type diffusion layer containing a diffused P-type impurity. Likewise, an inter-pixel isolation portion 201-2 formed between the first photoelectric conversion unit 101c-1 and the second photoelectric conversion unit 102c-1 is configured with a P-type diffusion layer containing a diffused P-type impurity.

If the first photoelectric conversion unit 101c and the second photoelectric conversion unit 102c are formed as the P-type, the inter-pixel isolation portion 201 is formed by an N-type diffusion layer containing a diffused N-type impurity.

Referring to Fig. 12, an on-chip lens 181-4 provided in the region of the second photoelectric conversion unit 102c-1 is formed to a position of the inter-pixel isolation portion 201-1 in plan view. Likewise, an on-chip lens 181-8 provided in the region of a second photoelectric conversion unit 102c-2 is formed to a position of the inter-pixel isolation portion 201-2 in plan view.

As described above, the inter-pixel isolation portion 201 formed by a P-type diffusion layer may be formed between the first photoelectric conversion unit 101c and the second photoelectric conversion unit 102c that constitute the single unit pixel 100c. In other words, the inter-pixel isolation portion 132c surrounding the unit pixel 100c and the inter-pixel isolation portion 201 provided in the unit pixel 100c may have different structures.

Also in the unit pixel 100c according to the third embodiment, the saturation signal amount of the large pixel (first photoelectric conversion unit 101c) can be increased, the transition point of signal processing to the small pixel (second photoelectric conversion unit 102c) can be delayed, and an SN ratio by the transition point can be improved. Blooming from the large pixel to the small pixel can be also suppressed, thereby preventing a deterioration of image quality of the small pixel.

### <Fourth Embodiment>

Figs. 13 to 14 illustrate a configuration example of a unit pixel 100d disposed in a pixel array unit 11 according to a fourth embodiment. Fig. 13 illustrates the two unit pixels 100d vertically disposed in the pixel array unit 11.

Fig. 13 illustrates the configuration example on the front side of a semiconductor substrate 131 of the unit pixel 100d. Fig. 14 illustrates a sectional configuration example of the unit pixel 100d taken along line A-A' of Fig. 13.

The configuration example of the unit pixel 100d in Fig. 13 is basically identical to the configuration example of the unit pixel 100b in Fig. 6. Thus, the same parts are denoted by the same reference numerals and the description thereof is omitted.

Fig. 13 illustrates a plan configuration example of the unit pixel 100d in which an in-pixel capacitor 106 is formed by an MIM (Metal-Insulator-Metal) capacitor 221. The circuit configuration example of the unit pixel 100d in Fig. 13 is basically identical to the circuit configuration example of the unit pixel 100a according to the first embodiment in Fig. 2. The in-pixel capacitor 106 is replaced with the MIM capacitor 221.

Referring to the plan configuration example of the unit pixel 100d in Fig. 13, an MIM capacitor 221-1 is connected to a third transfer transistor 105 of a second photoelectric conversion unit 102-1, and an MIM capacitor 221-2 is connected to a third transfer transistor 105 of a second photoelectric conversion unit 102-2.

Referring to Fig. 14, in a sectional configuration example of the unit pixel 100d taken along line A-A' of Fig. 13, a first photoelectric conversion unit 101d-1 and a second photoelectric conversion unit 102d-1 are provided in the semiconductor substrate 131. In the example of Fig. 14, the first photoelectric conversion unit 101d-1 and the second photoelectric conversion unit 102d-1 are formed as embedded photodiodes.

On the left side of the first photoelectric conversion unit 101d-1 in Fig. 14, an inter-pixel isolation portion 132d surrounding the unit pixel 100d is provided. Also on the right side of the second photoelectric conversion unit 102d-1 in Fig. 14, the inter-pixel isolation portion 132d surrounding the unit pixel 100d is provided.

The inter-pixel isolation portion 132d is also provided between the first photoelectric conversion unit 101d-1 and the second photoelectric conversion unit 102d-1. The inter-pixel isolation portion provided between the first photoelectric conversion unit 101d-1 and the second photoelectric conversion unit 102d-1 may be replaced with the inter-pixel isolation portion 201 of the third embodiment.

The gate of a selection transistor 110 and the gate of the third transfer transistor 105 are provided on the front side (the upper side in Fig. 14) of the semiconductor substrate 131. An N-type diffusion layer 231 is formed on the front side of the first photoelectric conversion unit 101d-1 in the semiconductor substrate 131. Referring to Figs. 13 and 14, the N-type diffusion layer 231 is a diffusion layer formed between the selection transistor 110 (denoted as SEL in Fig. 13) and the inter-pixel isolation portion 132d.

On the front side of the second photoelectric conversion unit 102d-1 in the semiconductor substrate 131, an N-type diffusion layer 232 and an N-type diffusion layer 233 are formed. Referring to Figs. 13 and 14, the N-type diffusion layer 232 is a diffusion layer formed between the third transfer transistor 105 (denoted as FCG in Fig. 13) and the inter-pixel isolation portion 132d provided between the first photoelectric conversion unit 101d and the second photoelectric conversion unit 102d-1. The N-type diffusion layer 232 is a diffusion layer formed between the third transfer transistor 105 and the inter-pixel isolation portion 132d provided between the second photoelectric conversion unit 102d-1 and the first photoelectric conversion unit 101d (not illustrated) in the adjacent unit pixel 100d.

The MIM capacitor 221-1 is connected to the N-type diffusion layer 233. The N-type diffusion layer 231, the N-type diffusion layer 232, and the N-type diffusion layer 233 are diffusion layers acting as sources or drains of connected transistors.

Also in the unit pixel 100d according to the fourth embodiment, the saturation signal amount of the large pixel (first photoelectric conversion unit 101d) can be increased, the transition point of signal processing to the small pixel (second photoelectric conversion unit 102d) can be delayed, and an SN ratio by the transition point can be improved. Blooming from the large pixel to the small pixel can be also suppressed, thereby preventing a deterioration of image quality of the small pixel.

### <Operation of Unit Pixel>

Referring to Fig. 15, the operations of the unit pixel 100 according to the first to fourth embodiments will be described below. Fig. 15 is a timing chart for explaining operations performed when the unit pixel 100 is read.

Fig. 15 shows a driving example of the unit pixel 100 in a 1H period (one horizontal period) in the pixel array unit 11. In Fig. 15, the horizontal direction indicates a time direction.

At a time before a reset period is started in the low conversion efficiency (LCG) of the large pixel (first photoelectric conversion unit 101), the vertical driving unit 12 turns on the selection transistor 110 and the reset transistor 108. At this point, the first transfer transistor 103, the second transfer transistor 104, and the third transfer transistor 105 are placed in an off-state. In the case of a setting for the unit pixel 100 to be read, the power supply voltage FCVDD is set at a high level from the start to the end of reading.

When the reset period in the low conversion efficiency (LCG) of the large pixel (first photoelectric conversion unit 101) is started, the driving signal RST and the driving signal FDG are set at the high level, the reset transistor 108 and the second transfer transistor 104 are brought into conduction, and a charge accumulated in the FD 107 is reset.

The vertical driving unit 12 electrically connects the FD unit 107 and the node 112 by turning on the second transfer transistor 104. Charge accumulated in the FD unit 107 and the node 112 is discharged, and then the FD unit 107 and the node 112 are reset.

Thereafter, the driving signal FDG and the driving signal RST are sequentially set at a low level, the second transfer transistor 104 and the reset transistor 108 are sequentially brought into a nonconducting state (off-state), and then the driving signal FDG is set at the high level again; meanwhile, the second transfer transistor 104 is brought into conduction.

Thus, in the state of low conversion efficiency in which the FD unit 107 and the node 112 are connected to each other, a voltage signal corresponding to a charge held in the FD unit 107 and the node 112 is supplied to the column processing unit 13 from the amplification transistor 109 through the selection transistor 110 and the vertical signal line 17.

The column processing unit 13 determines a reset level in the low conversion efficiency of the large pixel by performing signal processing such as AD conversion on the signal supplied from the amplification transistor 109.

Thereafter, when a reset period in the high conversion efficiency (HCG) of the large pixel (first photoelectric conversion unit 101) is started, the driving signal FDG is set at the low level and the second transfer transistor 104 is brought out of conduction.

In this state, a voltage signal corresponding to a charge held in the FD unit 107 is supplied to the column processing unit 13 from the amplification transistor 109 through the selection transistor 110 and the vertical signal line 17. The column processing unit 13 obtains a noise level in the high conversion efficiency of the large pixel by performing signal processing such as AD conversion on the signal supplied from the amplification transistor 109.

Thereafter, when a reading period in the high conversion efficiency (HCG) of the large pixel (first photoelectric conversion unit 101) is started, the driving signal TGL is set at the high level and the first transfer transistor 103 is brought into conduction. In the first photoelectric conversion unit 101, photoelectric conversion is performed and the obtained charge is accumulated therein. When the first transfer transistor 103 is turned on, a charge accumulated in the first photoelectric conversion unit 101 is transferred to the FD unit 107 through the first transfer transistor 103 and is held therein.

In this case, the FD unit 107 and the node 112 are electrically isolated from each other, that is, a connection is not made therebetween, so that the conversion efficiency is high.

The vertical driving unit 12 sets the driving signal TGL at the low level, turns off the first transfer transistor 103, and terminates the transfer of charge from the first photoelectric conversion unit 101 to the FD unit 107. In this state, a voltage signal corresponding to a charge held in the FD unit 107 is supplied to the column processing unit 13 from the amplification transistor 109 through the selection transistor 110 and the vertical signal line 17. The column processing unit 13 determines a signal level in the high conversion efficiency of the large pixel by performing signal processing such as AD conversion on the signal supplied from the amplification transistor 109.

Furthermore, the column processing unit 13 obtains a pixel signal in the high conversion efficiency of the large pixel by determining a difference between the signal level from the large pixel and a reset level, and supplies the pixel signal to the signal processing unit 18. The difference between the signal level and the reset level may be calculated in the signal processing unit 18.

Thereafter, when a reading period in the low conversion efficiency (LCG) of the large pixel (first photoelectric conversion unit 101) is started, the vertical driving unit 12 sets the driving signal FDG at the high level and brings the second transfer transistor 104 into conduction. When the reading period is started, the driving signal TGL is set at the high level for a predetermined time and the first transfer transistor 103 is brought into conduction for a predetermined time.

The vertical driving unit 12 turns on the first transfer transistor 103, transfers a charge from the first photoelectric conversion unit 101 to the FD unit 107, turns on the second transfer transistor 104, and obtains a state of low conversion efficiency again. In this case, the charge transferred from the first photoelectric conversion unit 101 is accumulated in the FD unit 107 and the node 112.

The vertical driving unit 12 turns off the first transfer transistor 103 and terminates the transfer of the charge from the first photoelectric conversion unit 101 to the FD unit 107. In this state, a voltage signal corresponding to a charge held in the FD unit 107 and the node 112 is supplied to the column processing unit 13 from the amplification transistor 109 through the selection transistor 110 and the vertical signal line 17.

The column processing unit 13 determines a signal level in the low conversion efficiency of the large pixel by performing signal processing such as AD conversion on the signal supplied from the amplification transistor 109. Furthermore, the column processing unit 13 obtains a pixel signal in the low conversion efficiency of the large pixel by determining a difference between the signal level in the low conversion efficiency of the large pixel and the reset level, and supplies the pixel signal to the signal processing unit 18.

Driving for obtaining the pixel signals corresponding to the high conversion frequency and the low conversion frequency of the large pixel (first photoelectric conversion unit 101) is CDS driving.

Thereafter, a reading period for the small pixel (second photoelectric conversion unit 102) is started. The driving signal FDG is kept at the high level, and the second transfer transistor 104 is kept in a conduction state. The driving signal FCG is set at the high level, and the third transfer transistor 105 is brought into conduction.

In the second photoelectric conversion unit 102, photoelectric conversion is performed and the obtained charge is accumulated in the in-pixel capacitor 106. When the third transfer transistor 105 is turned on, a charge accumulated in the in-pixel capacitor 106 is transferred to the FD unit 107 through the third transfer transistor 105 and is held therein.

In this state, a voltage signal corresponding to a charge held in the FD unit 107, the node 112, and the in-pixel capacitor 106 is supplied to the column processing unit 13 from the amplification transistor 109 through the selection transistor 110 and the vertical signal line 17.

The column processing unit 13 performs signal processing such as AD conversion on the signal supplied from the amplification transistor 109 and reads a signal level in the low conversion efficiency of the small pixel.

Thereafter, a reset period for the small pixel (second photoelectric conversion unit 102) is started. The driving signal FDG is kept at the high level, and the second transfer transistor 104 is kept in a conduction state. The driving signal SEL is set at the low level for a predetermined time and then is returned to the high level, so that the selection transistor 110 is brought out of conduction for a predetermined time and then is returned to a conduction state.

The vertical driving unit 12 turns off the selection transistor 110, temporarily brings the unit pixel 100 into an unselected state, that is, a state in which a signal is not output to the vertical signal line 17, and turns on the reset transistor 108 to perform a reset.

In this case, charge accumulated in the second photoelectric conversion unit 102, the in-pixel capacitor 106, the FD unit 107, and the node 112 is discharged, and then the second photoelectric conversion unit 102, the in-pixel capacitor 106, the FD unit 107, and the node 112 are reset.

The vertical driving unit 12 turns on the selection transistor 110 by setting the driving signal SEL at the high level again, brings the unit pixel 100 into a selected state, turns off the third transfer transistor 105 by setting the driving signal FCG at the low level, and electrically isolates the second photoelectric conversion unit 102 and the in-pixel capacitor 106 from the node 112.

Thereafter, the vertical driving unit 12 turns off the reset transistor 108 by setting the driving signal RST at the low level and terminates the reset. Furthermore, the vertical driving unit 12 turns on the third transfer transistor 105 by setting the driving signal FCG at the high level and electrically connects the second photoelectric conversion unit 102, the in-pixel capacitor 106, the FD unit 107, and the node 112.

In this state, a voltage signal corresponding to a charge held in the FD unit 107, the node 112, and the in-pixel capacitor 106 is supplied to the column processing unit 13 from the amplification transistor 109 through the selection transistor 110 and the vertical signal line 17.

The column processing unit 13 determines a reset level in the small pixel by performing signal processing such as AD conversion on the signal supplied from the amplification transistor 109. Furthermore, the column processing unit 13 obtains the pixel signal of the small pixel by determining a difference between the signal level of the small pixel and the reset level, and supplies the pixel signal to the signal processing unit 18. Driving for obtaining the pixel signal of the small pixel is DDS driving.

The signal processing unit 18 generates the image signal of an image on the basis of the pixel signals from the high conversion efficiency and low conversion efficiency of the large pixel and the small pixel for each unit pixel 100 and outputs the image signal to the subsequent stage, the pixel signals being supplied from the column processing unit 13 as described above.

Subsequently, a DOL (Digital Over Lap) period is executed. The DOL period is a reading period of a signal level for obtaining a pixel signal corresponding to the maximum illuminance and a reset level.

The vertical driving unit 12 turns off the third transfer transistor 105 by setting the driving signal FCG at the low level, and electrically isolates the second photoelectric conversion unit 102 and the in-pixel capacitor 106 from the node 112.

The vertical driving unit 12 turns off the selection transistor 110 by setting the driving signal SEL at the low level and places the unit pixel 100 in an unselected state. Furthermore, after the DOL period, the vertical driving unit 12 turns on the reset transistor 108 by setting the driving signal RST at the high level and resets the FD unit 107 and the node 112.

At this point, the column processing unit 13 reads a signal from the unit pixel 100, that is, a signal corresponding to a charge accumulated in the FD unit 107 or the like, and then the image signal is generated in the signal processing unit 18 on the basis of the read signal according to, for example, a method called DOL.

The foregoing driving allows the imaging device 10 to generate an image with a wide dynamic range on the basis of a plurality of pixel signals corresponding to illuminance levels.

### <Fifth Embodiment>

Fig. 16 illustrates a circuit configuration example of a unit pixel 100e according to a fifth embodiment. In the unit pixel 100e in Fig. 16, parts having the same functions as the unit pixel 100a in Fig. 2 are denoted by the same reference numerals and the description thereof is omitted as necessary.

The circuit configuration of the unit pixel 100e in Fig. 16 is different in that a second transfer transistor 104 is omitted from the unit pixel 100a in Fig. 2 and a second photoelectric conversion unit 102 is directly connected to an in-pixel capacitor 106. Moreover, in the circuit configuration of the unit pixel 100e in Fig. 16, the counter electrode of an MIM capacitor 221 is connected to a power supply voltage VDD.

Fig. 17 is a timing chart for explaining the operations of the unit pixel 100e in Fig. 16.

In response to a shutter operation, a driving signal RST supplied to a reset transistor 108, a driving signal FCG supplied to a third transfer transistor 105, and a driving signal TGL supplied to a first transfer transistor 103 are set at a high level for a predetermined time and then are returned to a low level. During an exposure period, a driving signal SEL, the driving signal RST, the driving signal FCG, and the driving signal TGL are set at the low level, and thus the selection transistor 110, the reset transistor 108, the third transfer transistor 105, and the first transfer transistor 103 are in a nonconducting state.

When the reset period of the large pixel (first photoelectric conversion unit 101) is started, the driving signal RST is set at the high level and the reset transistor 108 is brought into conduction, so that the FD unit 107 is reset. When the driving signal RST is set at the low level and the reset transistor 108 is brought out of conduction, the driving signal SEL is set at the high level, the selection transistor 110 is brought into conduction, and the reset level is read from the FD unit 107.

When the driving signal SEL is set at the low level and the selection transistor 110 is brought out of conduction, the driving signal TGL is set at the high level and the first transfer transistor 103 is brought into conduction, so that the reading period of the large pixel (first photoelectric conversion unit 101) is started. In the first photoelectric conversion unit 101, photoelectric conversion is performed and the obtained charge is accumulated therein. When the first transfer transistor 103 is turned on, a charge accumulated in the first photoelectric conversion unit 101 is transferred to the FD unit 107 through the first transfer transistor 103 and is held therein.

After the driving signal TGL is set at the low level, the driving signal SEL is set at the high level and the selection transistor 110 is brought into conduction, so that the signal transferred to the FD unit 107 is supplied from an amplification transistor 109 to the column processing unit 13 through the selection transistor 110 and a vertical signal line 17. The column processing unit 13 determines the signal level by performing signal processing such as AD conversion on the signal supplied from the amplification transistor 109. Furthermore, the column processing unit 13 obtains the pixel signal of the large pixel (first photoelectric conversion unit 101) by determining a difference between the signal level and the reset level and supplies the pixel signal to the signal processing unit 18.

When the driving signal SEL is set at the low level and the selection transistor 110 is brought out of conduction, the reading period of the small pixel (second photoelectric conversion unit 102) is started. The driving signal RST is set at the high level and the reset transistor 108 is brought into conduction, so that the FD unit 107 is reset. After the driving signal RST is set at the low level and the reset transistor 108 is brought out of conduction, the driving signal FCG is set at the high level and the third transfer transistor 105 is brought into conduction. Thereafter, the driving signal SEL is set at the high level, and the selection transistor 110 is brought into conduction.

In the second photoelectric conversion unit 102, photoelectric conversion is performed and the obtained charge is accumulated in the MIM capacitor 221. When the third transfer transistor 105 is turned on, a charge accumulated in the MIM capacitor 221 is transferred to the FD unit 107 through the third transfer transistor 105 and is held therein.

Moreover, the selection transistor 110 is placed in a conducting state, so that the signal transferred to the FD unit 107 is supplied from the amplification transistor 109 to the column processing unit 13 through the selection transistor 110 and the vertical signal line 17. The column processing unit 13 determines the signal level of the small pixel (second photoelectric conversion unit 102) by performing signal processing such as AD conversion on the signal supplied from the amplification transistor 109.

When the driving signal SEL is set at the low level and the selection transistor 110 is brought out of conduction, the reset period of the small pixel (second photoelectric conversion unit 102) is started. Since the driving signal FCG is kept at the high level, the third transfer transistor 105 is placed in a conduction state. The driving signal RST is set at the high level, and the reset transistor 108 is brought into conduction.

Since the selection transistor 110 is turned off, the unit pixel 100 is placed in an unselected state, that is, in a state in which no signal is output to the vertical signal line 17. At this point, the reset transistor 108 is turned on to perform a reset. In this case, a charge accumulated in the in-pixel capacitor 106 and the FD unit 107 is discharged, and then the in-pixel capacitor 106 and the FD unit 107 are reset.

The vertical driving unit 12 turns on the selection transistor 110 by setting the driving signal SEL at the high level again and places the unit pixel 100 in a selected state. The vertical driving unit 12 then turns off the reset transistor 108 by setting the driving signal RST at the low level and terminates the reset.

Thereafter, the driving signal FCG is also set at the low level, and the third transfer transistor 105 is brought out of conduction.

The column processing unit 13 determines the reset level by performing signal processing such as AD conversion on the signal supplied from the amplification transistor 109. Furthermore, the column processing unit 13 obtains a pixel signal from the small pixel by determining a difference between the signal level obtained from the small pixel (second photoelectric conversion unit 102) and the reset level and supplies the pixel signal to the signal processing unit 18. Driving for obtaining the pixel signal of the small pixel is DDS driving.

The signal processing unit 18 generates the image signal of an image on the basis of the pixel signals of the large pixel and the small pixel for each unit pixel 100e and outputs the image signal to the subsequent stage, the pixel signals being supplied from the column processing unit 13 as described above.

Fig. 18 illustrates a plan configuration example of the unit pixel 100e that has the circuit configuration and performs the operations. Fig. 19 illustrates a sectional configuration example of the unit pixel 100e taken along line A-B of Fig. 18.

The unit pixel 100e in Fig. 18 is configured with a first photoelectric conversion unit 101e acting as a large pixel and a second photoelectric conversion unit 102e acting as a small pixel. The first photoelectric conversion unit 101e is L-shaped in plan view like the first photoelectric conversion units 101 included in the unit pixels 100b to 100d described as the second to fourth embodiments. The second photoelectric conversion unit 102e is square-shaped.

In the pixel array unit 11, the unit pixels 100e are arranged in a matrix, the unit pixel 100e being configured with the first photoelectric conversion unit 101e and the second photoelectric conversion unit 102e. The unit pixels 100e are isolated from each other by an inter-pixel isolation portion 132e. The inter-pixel isolation portion 132e is also formed between the first photoelectric conversion unit 101e and the second photoelectric conversion unit 102e. The first photoelectric conversion unit 101e and the second photoelectric conversion unit 102e are isolated from each other by the inter-pixel isolation portion 132e.

The inter-pixel isolation portion 132 described as the first to fourth embodiments can be applied as the inter-pixel isolation portion 132e that may be configured with an insulator or partially configured with a P-type diffusion layer.

In a region where the first photoelectric conversion unit 101e is formed, the first transfer transistor 103, the second transfer transistor 104, the reset transistor 108, the amplification transistor 109, and the selection transistor 110 are formed. These transistors are connected via an N+ diffusion layer corresponding to a source or a drain that is formed in a semiconductor substrate 131.

In a region where the second photoelectric conversion unit 102e is formed, the third transfer transistor 105 for the second photoelectric conversion unit 102e is formed.

In the region where the first photoelectric conversion unit 101e is formed and the region where the second photoelectric conversion unit 102e is formed, a plurality of contacts are also formed. On an N-type diffusion layer 311 constituting the first transfer transistor 103, a contact 301 to a VSS wire connected to GND or a negative power supply. On an N-type diffusion layer 312 between the first transfer transistor 103 and the reset transistor 108, a contact 302 connected to the FD unit 107.

The contact 302 is connected to a contact 306 provided in the region where the second photoelectric conversion unit 102e is formed. On an N-type diffusion layer 313 constituting the reset transistor 108, a contact 303 connected to the power supply voltage VDD is formed. On an N-type diffusion layer 314 connected to the amplification transistor 109, a contact 304 connected to the power supply voltage VDD is formed.

The amplification transistor 109 and the selection transistor 110 are connected to each other via an N-type diffusion layer 319. On an N-type diffusion layer 315 connected to the selection transistor 110, a contact 305 connected to the vertical signal line 17 is formed.

In the region where the second photoelectric conversion unit 102e is formed, a contact 307 connected to the VSS wire is formed on an N-type diffusion layer 317. For the third transfer transistor 105 formed in the region where the second photoelectric conversion unit 102e is formed, a contact 308 connected to the MIM capacitor 221 is formed. The contact 308 is formed on an N-type diffusion layer 318 constituting the third transfer transistor 105.

The first photoelectric conversion unit 101e and the second photoelectric conversion unit 102e are each provided with an on-chip lens 181 as illustrated in, for example, Fig. 8. If the layout of the on-chip lenses 181 provided on the unit pixel 100b according to the second embodiment illustrated in Fig. 8 is applied to the unit pixel 100e according to the fifth embodiment illustrated in Fig. 18, the first photoelectric conversion unit 101e is provided with on-chip lenses 181-1 to 181-3 and the second photoelectric conversion unit 102e is provided with an on-chip lens 184.

Fig. 19 illustrates a sectional configuration example of the unit pixel 100e taken along line A-B of Fig. 18. The first photoelectric conversion unit 101e and the second photoelectric conversion unit 102e are provided in a semiconductor substrate 131e.

On the left side of the first photoelectric conversion unit 101e in Fig. 19, an inter-pixel isolation portion 132e-1 surrounding the unit pixel 100e is provided. The inter-pixel isolation portions 132e are identified as the inter-pixel isolation portion 132e-1, an inter-pixel isolation portion 132e-2, and an inter-pixel isolation portion 132e-3 depending upon the position of the inter-pixel isolation portion 132e.

On the right side of the second photoelectric conversion unit 102e in Fig. 19, the inter-pixel isolation portion 132e-3 surrounding the unit pixel 100e is provided. The inter-pixel isolation portion 132e-2 is provided between the first photoelectric conversion unit 101e and the second photoelectric conversion unit 102e. The inter-pixel isolation portion 132e-2 is configured with an insulator like the inter-pixel isolation portion 132 according to the second embodiment.

On the front side (the upper side in Fig. 19) of the semiconductor substrate 131e where the first photoelectric conversion unit 101e is formed, the gate of the amplification transistor 109 is formed. An oxide film 321 is formed between the gate of the amplification transistor 109 and the semiconductor substrate 131e.

On the front side (the upper side in Fig. 19) of the semiconductor substrate 131e where the second photoelectric conversion unit 102e is formed, the gate of the third transfer transistor 105 is formed. An oxide film 322 is formed between the gate of the third transfer transistor 105 and the semiconductor substrate 131e. An N-type diffusion layer 316 is provided in a region in the semiconductor substrate 131e between the gate of the third transfer transistor 105 and the inter-pixel isolation portion 132e-2. The contact 306 (a wire connected to the FD unit 107) is connected to the N-type diffusion layer 316.

Figs. 18 and 19 will be referred to again. Apart of the amplification transistor 109 is sized and located to overlap the inter-pixel isolation portion 132e. Specifically, the left end of the gate of the amplification transistor 109 in Figs. 18 and 19 is located on the inter-pixel isolation portion 132e-1, and the right end of the amplification transistor 109 in Figs. 18 and 19 is located on the inter-pixel isolation portion 132e-2.

The inter-pixel isolation portion 132e-1 is an isolation portion that is provided between the unit pixels 100e and isolates the unit pixels 100e, and the inter-pixel isolation portion 132e-2 is an isolation portion that is provided in the unit pixel 100e and isolates the first photoelectric conversion unit 101e and the second photoelectric conversion unit 102e in the unit pixel 100e. With this configuration, the gate of the amplification transistor 109 is configured in contact with the inter-pixel isolation portion 132e provided between the unit pixels 100e and the inter-pixel isolation portion 132e provided in the unit pixel 100e.

If the gate of the amplification transistor 109 is square-shaped, the gate of the amplification transistor 109 is configured such that two of four sides constituting the gate of the amplification transistor 109 are located on the inter-pixel isolation portion 132e. The two sides are parallel to a line (hereinafter referred to as a virtual line) assumed to be a line connecting the source and the drain of the amplification transistor 109.

Specifically, in the sectional configuration example of Fig. 18, the source and the drain of the amplification transistor 109 are the N-type diffusion layer 311 and the N-type diffusion layer 319, and the virtual line (not illustrated) connecting the N-type diffusion layer 311 and the N-type diffusion layer 319 extends in the vertical direction in Fig. 18. In other words, the virtual line is perpendicular to line A-B. The left side of the gate of the amplification transistor 109 in Fig. 18 is a side perpendicular to line A-B, and the right side of the gate of the amplification transistor 109 in Fig. 18 is also a side perpendicular to line A-B.

Thus, the left side, the right side, and the virtual line of the gate of the amplification transistor 109 are extended in parallel. As described above, the gate of the amplification transistor 109 is configured such that among the four sides of the gate of the amplification transistor 109, the two sides parallel to the virtual line connecting the source and the drain are located on the inter-pixel isolation portion 132e.

Since the inter-pixel isolation portion 132e is configured with a trench penetrating the semiconductor substrate 131e, the gate of the amplification transistor 109 may have a structure such that both sides extended in one direction parallel to the virtual line connecting the source and the drain are located in contact with the through trench.

The gate of the amplification transistor 109 is configured thus, thereby increasing the area of the amplification transistor 109. Since the area of the amplification transistor 109 results from the shape of the inter-pixel isolation portion 132e, variations in production can be suppressed as compared with isolation by impurity injection. The isolation by impurity injection may reduce yields because the channel size of the transistor depends upon variations in the distribution of impurity. However, according to the unit pixel 100e to which the present technique is applied, the isolation is not isolation by impurity injection but isolation by the inter-pixel isolation portion 132e (through trench), so that yields are unlikely to decrease.

If elements are isolated by dielectric isolation such as STI (Shallow Trench Isolation) or CION (Concealed Isolation with Oxide burynig Nick), a portion isolated by impurity injection or an impurity injection portion extended for isolation at the bottom according to STI or CION has a junction capacitance with the channel of the transistor, which may reduce the performance of the transistor. The amplification transistor 109 can be improved in performance, for example, noise reduction by upsizing. Thus, for transistors such as the amplification transistor 109 to be upsized, a junction capacitance with STI or CION is not negligible and may reduce an amplification gain.

According to the present technique, the amplification transistor 109 and other elements are isolated by the through trench instead of STI or CION, thereby suppressing the occurrence of a junction capacitance and a reduction in amplification gain.

STI or CION has a corner portion from a side to the bottom. In this case, the trap probability of charge may be increased by an interface state caused by a stress generated around the corner portion and deteriorate random noise characteristics.

According to the present technique, the amplification transistor 109 and other elements are isolated by the through trench instead of STI or CION, thereby suppressing the occurrence of a stress at an interface portion and reducing random noise caused by the trap of the interface state.

The second photoelectric conversion unit 102e serving as the small pixel has lower sensitivity than the first photoelectric conversion unit 101e serving as the large pixel, and the dynamic range can be extended by providing a sensitivity ratio. The second photoelectric conversion unit 102e serving as the small pixel is configured to be directly connected to the MIM capacitor 221, thereby increasing the charge saturation amount of the second photoelectric conversion unit 102e.

In the foregoing example, the gate of the amplification transistor 109 was described. However, the gate of another transistor, or the gate of another transistor also, can be located on the two inter-pixel isolation portions 132. The gate of at least one transistor of the transistors constituting the unit pixel 100e can be configured to be located on the two inter-pixel isolation portions 132.

### <Sixth Embodiment>

Fig. 20 illustrates a circuit configuration example of a unit pixel 100f according to a sixth embodiment. In the unit pixel 100f in Fig. 20, parts having the same functions as the unit pixel 100a in Fig. 2 are denoted by the same reference numerals and the description thereof is omitted as necessary.

The circuit configuration of the unit pixel 100f in Fig. 20 is different in that a fourth transfer transistor 341 is added to the unit pixel 100a in Fig. 2, and other points are identical to those of the unit pixel 100a. As compared with the unit pixel 100e according to the fifth embodiment in Fig. 16, the unit pixel 100f in Fig. 20 is different in that the fourth transfer transistor 34 is added and the counter electrode of an MIM capacitor 221 is a power supply voltage FCVDD, and other points are identical to those of unit pixel 100e.

The fourth transfer transistor 341 provided for the second photoelectric conversion unit 102f allows separate processing of a charge accumulated in the MIM capacitor 221 after overflowing a second photoelectric conversion unit 102f and a charge accumulated in the second photoelectric conversion unit 102f. Thus, processing for reading the capacity of the MIM capacitor 221 and processing for reading the capacity of the second photoelectric conversion unit 102f can be performed.

In a configuration where the power supply voltage FCVDD is connected to the MIM capacitor 221, a voltage different from a power supply voltage VDD can be applied to the MIM capacitor 221. The MIM capacitor 221 has the function of accumulating a charge overflowing the second photoelectric conversion unit 102f in bright light. At this point, the occurrence of a dark current during an accumulation period can be suppressed by reducing the voltage of the power supply voltage FCVDD.

Fig. 21 is a timing chart for explaining the operations of the unit pixel 100f in Fig. 20.

In response to a shutter operation, the voltage of the power supply voltage FCVDD is set at a high level for a predetermined time and then is returned to a low level. A driving signal RST supplied to a reset transistor 108, a driving signal FDG supplied to a second transfer transistor 104, a driving signal FCG supplied to a third transfer transistor 105, a driving signal TGL supplied to a first transfer transistor 103, and a driving signal TGS supplied to the fourth transfer transistor 341 are set at the high level for a predetermined time and then are returned to the low level.

During an exposure period, the power supply voltage FCVDD has a voltage at the low level, and a driving signal SEL, the driving signal RST, the driving signal FDG, the driving signal FCG, the driving signal TGL, and the driving signal TGS are set at the low level. Thus, a selection transistor 110, the reset transistor 108, the second transfer transistor 104, the third transfer transistor 105, the first transfer transistor 103, and the fourth transfer transistor 341 are brought out of conduction.

When a reset period in the low conversion efficiency (LCG) of a large pixel (first photoelectric conversion unit 101) is started, the driving signal RST and the driving signal FDG are set at the high level, and the reset transistor 108 and the second transfer transistor 104 are brought into conduction.

Since the second transfer transistor 104 is brought into conduction, an FD unit 107 and a node 112 are electrically connected to each other. Charge accumulated in the FD unit 107 and the node 112 is discharged, and then the FD unit 107 and the node 112 are reset.

In the state in which the FD unit 107 and the node 112 are connected, the conversion efficiency of charge to a voltage signal is lower as compared with a state in which the FD unit 107 and the node 112 are not connected.

Thereafter, the driving signal FDG and the driving signal RST are sequentially set at the low level, the second transfer transistor 104 and the reset transistor 108 are sequentially brought into a nonconducting state (off-state), and then the driving signal FDG is set at the high level again; meanwhile, the second transfer transistor 104 is brought into conduction. Moreover, the voltage of the power supply voltage FCVDD is set at the high level and the driving signal SEL is set at the high level, so that the selection transistor 110 is brought into conduction.

Thus, in the state of low conversion efficiency in which the FD unit 107 and the node 112 are connected to each other, a voltage signal corresponding to a charge held in the FD unit 107 and the node 112 is supplied to a column processing unit 13 from an amplification transistor 109 through the selection transistor 110 and a vertical signal line 17.

The column processing unit 13 determines a reset level in the low conversion efficiency (LCG) of the large pixel by performing signal processing such as AD conversion on the signal supplied from the amplification transistor 109.

Thereafter, when a reset period in the high conversion efficiency (HCG) of the large pixel (first photoelectric conversion unit 101) is started, the driving signal FDG is set at the low level and the second transfer transistor 104 is brought out of conduction. Thus, the FD unit 107 and the node 112 are electrically isolated from each other and are placed in a state of high conversion efficiency with higher conversion efficiency than in a state of low conversion efficiency.

In this state, a voltage signal corresponding to a charge held in the FD unit 107 is supplied to the column processing unit 13 from the amplification transistor 109 through the selection transistor 110 and the vertical signal line 17. The column processing unit 13 obtains a noise level in the high conversion efficiency (HCG) of the large pixel by performing signal processing such as AD conversion on the signal supplied from the amplification transistor 109.

Thereafter, when a reading period in the high conversion efficiency (HCG) of the large pixel (first photoelectric conversion unit 101) is started, the driving signal TGL is set at the high level and the first transfer transistor 103 is brought into conduction. In a first photoelectric conversion unit 101f, photoelectric conversion is performed and the obtained charge is accumulated therein. When the first transfer transistor 103 is turned on, a charge accumulated in the first photoelectric conversion unit 101f is transferred to the FD unit 107 through the first transfer transistor 103 and is held therein.

In this case, the FD unit 107 and the node 112 are electrically isolated from each other, that is, a connection is not made therebetween, so that the conversion efficiency is high.

The driving signal TGL is set at the low level, the first transfer transistor 103 is turned off, and the transfer of charge from the first photoelectric conversion unit 101 to the FD unit 107 is terminated. In this state, when the driving signal SEL is set at the high level and the selection transistor 110 is turned on, a voltage signal corresponding to a charge held in the FD unit 107 is supplied to the column processing unit 13 from the amplification transistor 109 through the selection transistor 110 and the vertical signal line 17. The column processing unit 13 determines a signal level in the high conversion efficiency of the large pixel by performing signal processing such as AD conversion on the signal supplied from the amplification transistor 109.

Furthermore, the column processing unit 13 obtains a pixel signal in the high conversion efficiency of the large pixel by determining a difference between the signal level of the first photoelectric conversion unit 101 and a reset level, and supplies the pixel signal to a signal processing unit 18. The difference between the signal level and the reset level may be calculated in the signal processing unit 18.

When the driving signal SEL is set at the low level and the selection transistor 110 is turned off, a reading period in the low conversion efficiency (LCG) of the large pixel (first photoelectric conversion unit 101) is started. The vertical driving unit 12 sets the driving signal FDG at the high level and brings the second transfer transistor 104 into conduction. When the reading period is started, the driving signal TGL is set at the high level for a predetermined time and the first transfer transistor 103 is brought into conduction for a predetermined time.

The vertical driving unit 12 turns on the first transfer transistor 103, transfers a charge from the first photoelectric conversion unit 101 to the FD unit 107, turns on the second transfer transistor 104, and obtains a state of low conversion efficiency again. In this case, the charge transferred from the first photoelectric conversion unit 101 is accumulated in the FD unit 107 and the node 112.

When the first transfer transistor 103 is turned off, the transfer of charge from the first photoelectric conversion unit 101 to the FD unit 107 is terminated. In this state, when the driving signal SEL is set at the high level and the selection transistor 110 is brought into conduction, a voltage signal corresponding to a charge held in the FD unit 107 and the node 112 is supplied to the column processing unit 13 from the amplification transistor 109 through the selection transistor 110 and the vertical signal line 17.

The column processing unit 13 determines a signal level in the low conversion efficiency of the large pixel by performing signal processing such as AD conversion on the signal supplied from the amplification transistor 109. Furthermore, the column processing unit 13 obtains a pixel signal in the low conversion efficiency of the large pixel by determining a difference between the signal level in the low conversion efficiency of the large pixel and the reset level, and supplies the pixel signal to the signal processing unit 18.

Driving for obtaining the pixel signal of the large pixel is CDS driving.

Thereafter, a reset period for the small pixel (second photoelectric conversion unit 102) is started. Before the reset period is started, the driving signal SEL is also set at the low level and the selection transistor 110 is turned off.

The driving signal FDG is kept at the high level, and the second transfer transistor 104 is kept in a conduction state. The driving signal RST is set at the high level, and the reset transistor 108 is turned on. In this case, a charge accumulated in the FD unit 107 and the node 112 is discharged, and then the FD unit 107 and the node 112 are reset.

The vertical driving unit 12 turns on the selection transistor 110 by setting the driving signal SEL at the high level again and places the unit pixel 100f in a selected state. The vertical driving unit 12 then turns off the reset transistor 108 by setting the driving signal RST at the low level and terminates the reset.

The vertical driving unit 12 turns on the third transfer transistor 105 by setting the driving signal FCG at the high level and electrically connects the MIM capacitor 221, the FD unit 107, and the node 112.

In this state, a voltage signal corresponding to a charge held in the FD unit 107, the node 112, and the MIM capacitor 221 is supplied to the column processing unit 13 from the amplification transistor 109 through the selection transistor 110 and the vertical signal line 17.

The column processing unit 13 obtains the reset signal of the small pixel by performing signal processing such as AD conversion on the signal supplied from the amplification transistor 109.

When the driving signal SEL is set at the low level and the selection transistor 110 is turned off, the reading period of the signal of the small pixel (second photoelectric conversion unit 102f) and the reading period of a signal for a combination of the small pixel (second photoelectric conversion unit 102f) and the MIM capacitor 221 are started. When the reading period of the small pixel and the reading period of the small pixel + the MIM capacitor 221 are started, the driving signal TGS is set at the high level and the fourth transfer transistor 341 is turned on. In the second photoelectric conversion unit 102, photoelectric conversion is performed and the obtained charge is accumulated in the second photoelectric conversion unit 102, and a charge having overflown the second photoelectric conversion unit 102 is accumulated in the MIM capacitor 221.

When the fourth transfer transistor 341 is turned on, a charge accumulated in the second photoelectric conversion unit 102 and the MIM capacitor 221 is transferred to the FD unit 107 through the third transfer transistor 105 and is held therein. In this state, when the driving signal TGS is set at the low level, the fourth transfer transistor 341 is turned off, the driving signal SEL is set at the high level, and the selection transistor 110 is turned on, a voltage signal corresponding to a charge held in the MIM capacitor 221, the FD unit 107, and the node 112 is supplied to the column processing unit 13 from the amplification transistor 109 through the selection transistor 110 and the vertical signal line 17.

The column processing unit 13 determines the signal level of the small pixel (second photoelectric conversion unit 102) by performing signal processing such as AD conversion on the signal supplied from the amplification transistor 109, and then determines the signal level of the combination of the small pixel (second photoelectric conversion unit 102) and the MIM capacitor 211.

When the driving signal SEL is set at the low level and the selection transistor 110 is turned off, the reset period of the small pixel (second photoelectric conversion unit 102) and the MIM capacitor 221 is started. The driving signal FDG is kept at the high level, and the second transfer transistor 104 is kept in a conduction state.

The vertical driving unit 12 turns off the selection transistor 110, temporarily brings the unit pixel 100 into an unselected state, that is, a state in which a signal is not output to the vertical signal line 17, and turns on the reset transistor 108 to perform a reset.

In this case, a charge accumulated in the MIM capacitor 221, the FD unit 107, and the node 112 is discharged, and then the MIM capacitor 221, the FD unit 107, and the node 112 are reset. The reset transistor 108 is turned off by setting the driving signal RST at the low level, so that the reset is terminated.

The vertical driving unit 12 turns on the selection transistor 110 by setting the driving signal SEL at the high level again and places the unit pixel 100f in a selected state. The driving signal FDG and the driving signal FCG are kept at the high level, so that the second transfer transistor 104 and the third transfer transistor 105 are turned on, and the MIM capacitor 221, the FD unit 107, and the node 112 are electrically connected.

In this state, a voltage signal corresponding to a charge held in the FD unit 107, the node 112, and the MIM capacitor 221 is supplied to the column processing unit 13 from the amplification transistor 109 through the selection transistor 110 and the vertical signal line 17.

The column processing unit 13 determines the reset level of the small pixel by performing signal processing such as AD conversion on the signal supplied from the amplification transistor 109. Furthermore, the column processing unit 13 obtains the pixel signal of the small pixel by determining a difference between the signal level from the small pixel and the reset level, and supplies the pixel signal to the signal processing unit 18.

At the completion of the reset period of the small pixel and the MIM capacitor 221, the driving signal SEL, the driving signal FDG, and the driving signal FCG are set at the low level, and the reset transistor 108, the second transfer transistor 104, and the third transfer transistor 105 are turned off.

The signal processing unit 18 generates the image signal of an image on the basis of the pixel signals of the high conversion efficiency and low conversion efficiency of the large pixel and the pixel signal of the small pixel for each unit pixel 100 and outputs the image signal to the subsequent stage, the pixel signals being supplied from the column processing unit 13 as described above.

The foregoing driving allows the imaging device 10 to generate an image with a wide dynamic range on the basis of a plurality of pixel signals corresponding to the conversion efficiency.

Fig. 22 illustrates a plan configuration example of the unit pixel 100f that has the circuit configuration and performs the operations. The unit pixel 100f in Fig. 22 is different in that the second transfer transistor 104 and the fourth transfer transistor 341 are added to the unit pixel 100e in Fig. 18 and the counter electrode of the MIM capacitor 221 is the power supply voltage FCVDD. Other points are identical to those of the unit pixel 100e, and thus the explanation of identical portions is omitted as necessary. The different points will be described below.

In the unit pixel 100f in Fig. 22, the second transfer transistor 104 is disposed in a region where the first photoelectric conversion unit 101f is formed, that is, the upper region of Fig. 22. One end of the second transfer transistor 104 is connected to an N-type diffusion layer 351 constituting the first transfer transistor 103. The other end of the second transfer transistor 104 is connected to an N-type diffusion layer 352 constituting the reset transistor 108.

On the N-type diffusion layer 351, a contact 361 to be connected to the FD unit 107 is formed. On the N-type diffusion layer 352, a contact 362 to be connected to the node 112 is formed. A contact to be connected to the node 112 is formed also in a region where a second transfer transistor 104f is formed.

In a region where the second transfer transistor 104f is formed, the gate of the third transfer transistor 105 and the gate of the fourth transfer transistor 341 are formed. Between the third transfer transistor 105 and the fourth transfer transistor 341, an N-type diffusion layer 353 is provided. On the N-type diffusion layer 353, a contact 363 connected to the node 112 is formed.

Also in the unit pixel 100f according to the sixth embodiment illustrated in Fig. 22, the gate of the amplification transistor 109 is located on an inter-pixel isolation portion 132f as in the unit pixel 100e according to the fifth embodiment illustrated in Fig. 18. Specifically, referring to Fig. 22, the left side of the gate of an amplification transistor 109e in Fig. 22 is located on an inter-pixel isolation portion 132e-1, and the right side of the amplification transistor 109 in Fig. 22 is located on an inter-pixel isolation portion 132e-2.

If the gate of the amplification transistor 109 is square-shaped, the gate of the amplification transistor 109f is configured such that two of four sides constituting the gate of the amplification transistor 109f are located on an inter-pixel isolation portion 132e. The two sides are parallel to a virtual line connecting the source and the drain of the amplification transistor 109f.

The gate of the amplification transistor 109 is configured such that among the four sides of the gate of the amplification transistor 109f, the two sides parallel to the virtual line connecting the source and the drain are located on the inter-pixel isolation portion 132f.

In other words, the gate of the amplification transistor 109f has a structure such that both sides extended in one direction parallel to the virtual line connecting the source and the drain are located in contact with the through trench.

The gate of the amplification transistor 109f is configured thus, thereby extending the area of the amplification transistor 109f. Since the area of the amplification transistor 109f results from the shape of the inter-pixel isolation portion 132f, variations in production can be suppressed as compared with isolation by impurity injection. According to the present technique, the amplification transistor 109f and other elements are isolated by the through trench instead of STI or CION, thereby suppressing the occurrence of a junction capacitance and a reduction in amplification gain.

According to the present technique, the amplification transistor 109f and other elements are isolated by the through trench instead of STI or CION, thereby suppressing the occurrence of a stress at an interface portion and reducing random noise caused by the trap of the interface state.

The second photoelectric conversion unit 102f serving as the small pixel has lower sensitivity than the first photoelectric conversion unit 101f serving as the large pixel, and the dynamic range can be extended by providing a sensitivity ratio. The second photoelectric conversion unit 102f serving as the small pixel is configured to be directly connected to the MIM capacitor 221, thereby increasing the charge saturation amount of the second photoelectric conversion unit 102f.

### <Seventh Embodiment>

Fig. 23 illustrates a circuit configuration example of a unit pixel 100g according to a seventh embodiment. In the unit pixel 100g in Fig. 23, parts having the same functions as the unit pixel 100e in Fig. 16 are denoted by the same reference numerals and the description thereof is omitted as necessary.

The circuit configuration of the unit pixel 100g in Fig. 23 is different in that the selection transistor 110 is omitted from the circuit configuration of the unit pixel 100e in Fig. 16 and an amplification transistor 109 is directly connected to a vertical signal line 17. Another difference is that a power supply voltage SELVDD serves as the counter electrodes of a reset transistor 108 and the amplification transistor 109.

In the unit pixel 100g illustrated in Fig. 23, the reset transistor 108 has the drain connected to the selection power supply voltage SELVDD and the source connected to an FD unit 107. The selection power supply voltage SELVDD is a power supply selectively set at a VDD level or a GND level.

The amplification transistor 109 has a source follower configuration in which the gate is connected to the FD unit 107, the drain is connected to the selection power supply voltage SELVDD, and the source is connected to the vertical signal line 17. The amplification transistor 109 is placed in an operating state by setting the selection power supply voltage SELVDD at the VDD level, allowing the selection of the unit pixel 100g. The amplification transistor 109 outputs the potential of the FD unit 107 as a reset level to the vertical signal line 17 after a reset by the reset transistor 108 and outputs the potential of the FD unit 107 as a signal level to the vertical signal line 17 after a signal charge is transferred by a first transfer transistor 103.

Fig. 24 is a timing chart for explaining the operations of the unit pixel 100g in Fig. 23.

In response to a shutter operation, a power supply voltage SELVDD and a power supply voltage FCVDD are set at a high level for a predetermined time. Furthermore, a driving signal RST supplied to the reset transistor 108, a driving signal FCG supplied to a third transfer transistor 105, and a driving signal TGL supplied to the first transfer transistor 103 are set at the high level for a predetermined time and then are returned to a low level.

During an exposure period, the driving signal RST, the driving signal FCG, and the driving signal TGL are set at the low level, and thus the reset transistor 108, the third transfer transistor 105, and the first transfer transistor 103 are in a nonconducting state. The power supply voltage SELVDD and the power supply voltage FCVDD are both set at the low level.

When the reset period of the large pixel (first photoelectric conversion unit 101) is started, the power supply voltage SELVDD is set at the high level and the unit pixel 100g is placed in a selected state. When the reset period of the large pixel (first photoelectric conversion unit 101) is started, the driving signal RST is set at the high level and the reset transistor 108 is brought into conduction, so that the FD unit 107 is reset.

Thereafter, the reset transistor 108 is turned off by setting the driving signal RST at the low level, so that the reset is terminated. When the driving signal RST is set at the low level, the power supply voltage FCVDD is set at the high level.

When the reading period of the large pixel (first photoelectric conversion unit 101) is started, the driving signal TGL is set at the high level and the first transfer transistor 103 is brought into conduction. In the first photoelectric conversion unit 101, photoelectric conversion is performed and the obtained charge is accumulated therein. When the first transfer transistor 103 is turned on, a charge accumulated in the first photoelectric conversion unit 101 is transferred to the FD unit 107 through the first transfer transistor 103 and is held therein.

After the driving signal TGL is set at the low level, the signal transferred to the FD unit 107 is supplied from the amplification transistor 109 to a column processing unit 13 through the vertical signal line 17. The column processing unit 13 determines the signal level by performing signal processing such as AD conversion on the signal supplied from the amplification transistor 109. Furthermore, the column processing unit 13 obtains the pixel signal of the large pixel (first photoelectric conversion unit 101) by determining a difference between the signal level and the reset level and supplies the pixel signal to a signal processing unit 18.

When the reading period of the small pixel (second photoelectric conversion unit 102) is started, the driving signal RST is set at the high level and the reset transistor 108 is brought into conduction, so that the FD unit 107 is reset. After the driving signal RST is set at the low level and the reset transistor 108 is brought out of conduction, the driving signal FCG is set at the high level and the third transfer transistor 105 is brought into conduction.

In the second photoelectric conversion unit 102, photoelectric conversion is performed and the obtained charge is accumulated in an MIM capacitor 221. When the third transfer transistor 105 is turned on, a charge accumulated in the MIM capacitor 221 is transferred to the FD unit 107 through the third transfer transistor 105 and is held therein.

Moreover, the power supply voltage SELVDD is set at the high level, so that the unit pixel 100g is placed in a selected state. Thus, the signal transferred to the FD unit 107 is supplied from the amplification transistor 109 to the column processing unit 13 through the vertical signal line 17. The column processing unit 13 determines the signal level of the small pixel (second photoelectric conversion unit 102) by performing signal processing such as AD conversion on the signal supplied from the amplification transistor 109.

The reset period for the small pixel (second photoelectric conversion unit 102) is started. The driving signal RST is set at the high level, and the reset transistor 108 is brought into conduction. Since the driving signal FCG is kept at the high level, the third transfer transistor 105 is also placed in a conduction state. The reset transistor 108 is turned on by setting the driving signal RST at the high level, so that a reset is performed. In this case, a charge accumulated in the MIM capacitor 221 and the FD unit 107 is discharged, and then the MIM capacitor 221 and the FD unit 107 are reset.

The vertical driving unit 12 then turns off the reset transistor 108 by setting the driving signal RST at the low level and terminates the reset. Thereafter, the driving signal FCG is also set at the low level, and the third transfer transistor 105 is brought out of conduction.

The column processing unit 13 determines a reset level in the small pixel by performing signal processing such as AD conversion on the signal supplied from the amplification transistor 109. Furthermore, the column processing unit 13 obtains a pixel signal in the small pixel by determining a difference between the signal level obtained from the small pixel (second photoelectric conversion unit 102) and the reset level and supplies the pixel signal to the signal processing unit 18. Driving for obtaining the pixel signal in the small pixel is DDS driving.

The signal processing unit 18 generates the image signal of an image on the basis of the pixel signals of the large pixel and the small pixel for each unit pixel 100g and outputs the image signal to the subsequent stage, the pixel signals being supplied from the column processing unit 13 as described above.

Fig. 25 illustrates a plan configuration example of the unit pixel 100g that has the circuit configuration and performs the operations. The unit pixel 100g in Fig. 25 is different in that the selection transistor 110 is omitted from the unit pixel 100e in Fig. 18 and the reset transistor 108 and the amplification transistor 109 are connected to the power supply voltage SELVDD. Other points are identical to those of the unit pixel 100e, and thus the explanation of identical portions is omitted as necessary. The different points will be described below.

A contact 303 formed on an N-type diffusion layer 313 constituting the reset transistor 108 and a contact 304 formed on an N-type diffusion layer 314 constituting the amplification transistor 109 are connected to the power supply voltage SELVDD.

The amplification transistor 109 is connected to an N-type diffusion layer 391 on which a contact 392 connected to the vertical signal line 17 is formed. The amplification transistor 109 is configured with the N-type diffusion layer 314 and the N-type diffusion layer 391 that serve as a source or a drain.

In the seventh embodiment, the selection transistor 110 is not provided, so that the amplification transistor 109 can be configured with a larger size, accordingly. Comparing the amplification transistor 109g in Fig. 25 and the amplification transistor 109e in Fig. 18, the amplification transistor 109e in Fig. 18 needs a region for forming the selection transistor 110 on the lower side of Fig. 18 and thus has a smaller size, accordingly. In contrast, the amplification transistor 109g in Fig. 25 does not need a region for forming the selection transistor 110 and thus can be extended to a region where the selection transistor 110 was formed.

It is known that a reduction of random noise can be increased with the size of the amplification transistor 109. Thus, as in the unit pixel 100g according to the seventh embodiment, random noise can be further reduced by forming the amplification transistor 109g with a large size.

Also in the unit pixel 100g according to the seventh embodiment illustrated in Fig. 25, the gate of an amplification transistor 109g is located on an inter-pixel isolation portion 132g as in the unit pixel 100e according to the fifth embodiment illustrated in Fig. 18. Specifically, referring to Fig. 25, the left side of the gate of the amplification transistor 109e in Fig. 25 is located on an inter-pixel isolation portion 132g-1, and the right side of the amplification transistor 109 in Fig. 25 is located on an inter-pixel isolation portion 132g-2.

If the gate of the amplification transistor 109g is square-shaped, the gate of the amplification transistor 109g is configured such that two of four sides constituting the gate of the amplification transistor 109g are located on the inter-pixel isolation portion 132g. The two sides are parallel to a virtual line connecting the source and the drain (the N-type diffusion layer 314 and the N-type diffusion layer 391) of the amplification transistor 109g.

The gate of the amplification transistor 109g has a structure such that both sides extended in one direction parallel to the virtual line connecting the source and the drain are located in contact with a through trench.

The gate of the amplification transistor 109g is configured thus, thereby extending the area of the amplification transistor 109g. Since the area of the amplification transistor 109g results from the shape of the inter-pixel isolation portion 132g, variations in production can be suppressed as compared with isolation by impurity injection. According to the present technique, the amplification transistor 109g and other elements are isolated by the through trench instead of STI or CION, thereby suppressing the occurrence of a junction capacitance and a reduction in amplification gain.

According to the present technique, the amplification transistor 109g and other elements are isolated by the through trench instead of STI or CION, thereby suppressing the occurrence of a stress at an interface portion and reducing random noise caused by the trap of an interface state.

The second photoelectric conversion unit 102g serving as the small pixel has lower sensitivity than the first photoelectric conversion unit 101g serving as the large pixel, and the dynamic range can be extended by providing a sensitivity ratio. The second photoelectric conversion unit 102g serving as the small pixel is configured to be directly connected to the MIM capacitor 221, thereby increasing the charge saturation amount of the second photoelectric conversion unit 102g.

### <Eighth Embodiment>

A unit pixel 100h according to an eighth embodiment will be described below. The eighth embodiment relates to the layout, size, and shape of an on-chip lens. Fig. 26 illustrates the four unit pixels 100h in a two by two array disposed in a pixel array unit 11 (Fig. 1). Fig. 27 illustrates a sectional configuration example of the unit pixel 100h taken along line A-B of Fig. 26.

In Fig. 26, a unit pixel 100h- 1 is disposed on the upper left, a unit pixel 100h-2 is disposed on the upper right, a unit pixel 100h-3 is disposed on the lower left, and a unit pixel 100h-4 is disposed on the lower right. In the following description, if the unit pixels 100h-1 to 100h-4 do not need to be distinguished from one another, the unit pixels will be simply referred to as unit pixels 100h. Other parts will be similarly described.

The unit pixel 100h-1 is configured to include a first photoelectric conversion unit 101h-1 and a second photoelectric conversion unit 102h-1. The unit pixel 100h-2 is configured to include a first photoelectric conversion unit 101h-2 and a second photoelectric conversion unit 102h-2. The unit pixel 100h-3 is configured to include a first photoelectric conversion unit 101h-3 and a second photoelectric conversion unit 102h-3. The unit pixel 100h-4 is configured to include a first photoelectric conversion unit 101h-4 and a second photoelectric conversion unit 102h-4.

The first photoelectric conversion unit 101h is L-shaped, and the second photoelectric conversion unit 102h is square-shaped. The combined shape of the first photoelectric conversion unit 101h and the second photoelectric conversion unit 102h, in other words, the shape of the unit pixel 100h is a quadrangle (a square in Fig. 26).

In the pixel array unit 11, the unit pixels 100h are arranged in a matrix, the unit pixel 100h being configured with the first photoelectric conversion unit 101h and the second photoelectric conversion unit 102h. The unit pixels 100h are isolated from each other by an inter-pixel isolation portion 132h. The inter-pixel isolation portion 132h is also formed between the first photoelectric conversion unit 101h and the second photoelectric conversion unit 102h. The first photoelectric conversion unit 101h and the second photoelectric conversion unit 102h are isolated from each other by the inter-pixel isolation portion 132h.

The unit pixel 100h is surrounded by the inter-pixel isolation portion 132h. Referring to the sectional configuration example of the unit pixels 100h in Fig. 27, an inter-pixel isolation portion 132h-1 is provided on the left side of the unit pixel 100h including the first photoelectric conversion unit 101h-1 and the second photoelectric conversion unit 102h-2, and an inter-pixel isolation portion 132h-3 is provided on the right side (on the right side of the second photoelectric conversion unit 102h-1).

The unit pixel 100h is configured to be surrounded by the inter-pixel isolation portion 132h, thereby preventing light from leaking into the adjacent unit pixel 100h.

Likewise, an inter-pixel isolation portion 132h-2 (Fig. 27) is formed between the first photoelectric conversion unit 101h and the second photoelectric conversion unit 102h constituting the unit pixels 100h with the first photoelectric conversion unit 101h, thereby preventing light from leaking from the first photoelectric conversion unit 101h-1 into the adjacent second photoelectric conversion unit 102h-2.

The inter-pixel isolation portion 132h is configured such that a trench penetrates a semiconductor substrate 131 in the depth direction and the trench is filled with an insulator in the semiconductor substrate 131 made of, for example, silicon. For example, SiO2 is used as the insulator. The structure in the trench may be a layer made of SiO2 alone or a multilayer configuration made of SiO2 and polysilicon. A metallic film made of, for example, aluminum or tungsten may be formed on the inter-pixel isolation portion 132h.

The first photoelectric conversion unit 101h-1 in Fig. 27 is formed as a so-called embedded photodiode that has an n-type impurity region formed in a p-type impurity region 133 formed in the semiconductor substrate 131 made of silicon. Likewise, the second photoelectric conversion unit 102h-1 is also formed as an embedded photodiode.

Alight shielding film 411 is formed on the inter-pixel isolation portion 132h. A light shielding film 411-1 is provided on the inter-pixel isolation portion 132h-1, a light shielding film 411-2 is provided on the inter-pixel isolation portion 132h-2, and a light shielding film 411-3 is provided on the inter-pixel isolation portion 132h-3. The light shielding film 411 is a film made of a light shielding material that prevents incident light from entering an adjacent pixel.

On the upper side of the semiconductor substrate 131 where the first photoelectric conversion unit 101h-1 and the second photoelectric conversion unit 102h-2 are formed, a planarizing film 412 is formed and the light shielding film 411 is formed in the planarizing film 412. An on-chip lens 401-3 and an on-chip lens 401-4 are provided on the planarizing film 412.

Referring to Fig. 26, on-chip lenses 401-1 to 401-3 are provided on the first photoelectric conversion unit 101h-1, and the on-chip lens 401-4 is provided on the second photoelectric conversion unit 102h-1. Likewise, on-chip lenses 401-5 to 401-7 are provided on the first photoelectric conversion unit 101h-2, and an on-chip lens 401-8 is provided on the second photoelectric conversion unit 102h-2.

Similarly, on-chip lenses 401-9 to 401-11 are provided on the first photoelectric conversion unit 101h-3, and an on-chip lens 401-12 is provided on the second photoelectric conversion unit 102h-3. Similarly, on-chip lenses 401-13 to 401-15 are provided on the first photoelectric conversion unit 101h-4, and an on-chip lens 401-16 is provided on the second photoelectric conversion unit 102h-4.

The on-chip lenses 401-1 to 401-16 are circularly formed in the same size. The three on-chip lenses 401 are provided on the single first photoelectric conversion unit 101h. The three on-chip lenses 401 are disposed in an L-shape aligned with the L-shaped first photoelectric conversion unit 101h. The single on-chip lens 401 is disposed on the second photoelectric conversion unit 102h.

The on-chip lenses 401 formed in large sizes can improve light-gathering capability, thereby increasing sensitivity in the photoelectric conversion unit. In the example illustrated in Figs. 26 and 27, the on-chip lenses 401 are formed in large sizes in contact with one another.

Referring to Fig. 27 again, a boundary between the on-chip lens 401-3 and the on-chip lens 401-4 is denoted as a boundary P1. The boundary P1 is located substantially at the center of the inter-pixel isolation portion 132h-2 formed between the first photoelectric conversion unit 101h-1 and the second photoelectric conversion unit 102h-2. The on-chip lens 401 is formed with one end thereof large-sized to be located at the boundary P1 between pixels.

As described above, if the plurality of on-chip lenses 401 are disposed in the unit pixel 100h and the on-chip lenses 401 are identical in size and shape, the on-chip lenses 401 can be formed with one ends thereof large-sized to be located at the center of the inter-pixel isolation portion 132h.

The eighth embodiment can be implemented in combination with one or more of the second to seventh embodiments.

### <Ninth Embodiment>

A unit pixel 100i according to a ninth embodiment will be described below. The ninth embodiment relates to the layout, size, and shape of an on-chip lens. Fig. 28 illustrates the four unit pixels 100i in a 2 by 2 array disposed in a pixel array unit 11 (Fig. 1). Fig. 29 illustrates a sectional configuration example of the unit pixel 100i taken along line A-B of Fig. 28.

The unit pixel 100i in Fig. 28 is configured with a first photoelectric conversion unit 101i in an L-shape and a second photoelectric conversion unit 102i in a square shape like the unit pixels 100h in Fig. 26. The unit pixel 100i in Fig. 28 is different from the unit pixel 100h according to the eighth embodiment in the shape, size, and position or the like of an on-chip lens 421 provided on each of a first photoelectric conversion unit 101i and a second photoelectric conversion unit 102i. Other points are identical to those of the unit pixel 100h and thus the explanation of identical portions is omitted as necessary.

On-chip lenses 421-1 to 421-3 are provided on a first photoelectric conversion unit 101i-1, and an on-chip lens 421-4 is provided on a second photoelectric conversion unit 102i-1. Similarly, on-chip lenses 421-5 to 421-7 are provided on a first photoelectric conversion unit 101i-2, and an on-chip lens 421-8 is provided on a second photoelectric conversion unit 102i-2.

Likewise, on-chip lenses 421-9 to 421-11 are provided on a first photoelectric conversion unit 101i-3, and an on-chip lens 421-12 is provided on a second photoelectric conversion unit 102i-3. Similarly, on-chip lenses 421-13 to 421-15 are provided on a first photoelectric conversion unit 101i-4, and an on-chip lens 421-16 is provided on a second photoelectric conversion unit 102i-4.

The unit pixel 100i-1 will be referred to below. The on-chip lenses 421-1 to 421-3 are provided on the first photoelectric conversion unit 101i-1 of a unit pixel 100i-1. Among the on-chip lenses 421-1 to 421-3, the on-chip lens 421-1 is shaped like a circle smaller than the on-chip lenses 421-2 and 411-3.

The on-chip lens 421-4 disposed on the second photoelectric conversion unit 102i-1 is formed in a smaller size than the on-chip lenses 421-1 to 421-3. In a comparison of the sizes of the four on-chip lenses 421-1 to 421-4 disposed on the unit pixels 100i, the relationship of the on-chip lens 421-2 = the on-chip lens 421-3 > the on-chip lens 421-1 > the on-chip lens 421-4 is satisfied.

The plurality of (in this case, four) on-chip lenses 421 disposed in the unit pixel 100i are formed in different sizes. Thus, the first photoelectric conversion unit 101i can be covered with the on-chip lenses 421 with a minimum gap, thereby improving the sensitivity of the first photoelectric conversion unit 101i. In other words, in the first photoelectric conversion unit 101i illustrated in Fig. 28, the on-chip lenses 421 can be disposed with a minimum gap, thereby improving the sensitivity of the first photoelectric conversion unit 101i.

Regarding the on-chip lenses 421-1 to 421-4 disposed in the unit pixel 100i-1, the ends of the on-chip lens 421-1 and the on-chip lens 421-2 are partially placed in contact with each other, and the ends of the on-chip lens 421-1 and the on-chip lens 421-3 are also partially placed in contact with each other. The end of the on-chip lens 421-4 disposed on a second photoelectric conversion unit 102i-1 is partially placed in contact with the end of the on-chip lens 421-2 and the end of the on-chip lens 421-3.

As described above, the on-chip lenses 421-1 to 421-4 disposed in the unit pixel 100i-1 are formed with contact positions.

The on-chip lens 421-4 disposed on the second photoelectric conversion unit 102i-1 is formed with positions of contact with the on-chip lenses 421 in the unit pixel 100i-1 without making contact with the on-chip lenses 421 formed in other unit pixels 100i-2 to 100i-4 adjacent to the unit pixel 100i-1.

An on-chip lens 421-7 formed in the unit pixel 100i-2 adjacent to the unit pixel 100i-1 on the right side and an on-chip lens 421-4 formed on the second photoelectric conversion unit 102i-1 of the unit pixel 100i-1 are formed in a separated state. An on-chip lens 421-10 formed in the unit pixel 100i-3 with the lower left side adjacent to the unit pixel 100i-1 and the on-chip lens 421-4 formed on the second photoelectric conversion unit 102i-1 of the unit pixel 100i-1 are formed in a separated state.

As described above, in a unit pixel 100i, the on-chip lens 421 disposed on the second photoelectric conversion unit 102 is formed with a position of contact with the on-chip lens 421 disposed on the first photoelectric conversion unit 101i. Along with the adjacent unit pixel 100i, the on-chip lens 421 disposed on the second photoelectric conversion unit 102 is formed without a position of contact with the on-chip lens 421 disposed on the first photoelectric conversion unit 101i included in another unit pixel 100i.

In other words, the on-chip lens 421 of the second photoelectric conversion unit 102i serving as a small pixel is disposed at a distance from the on-chip lens 421 of the first photoelectric conversion unit 101i in a different color such that influence from a large pixel in a different color is eliminated. Thus, the influence from the pixel in a different color can be reduced on the second photoelectric conversion unit 102i serving as a small pixel, thereby suppressing color mixture.

The on-chip lens 421 formed on the first photoelectric conversion unit 101i is formed in a size with a position of contact with the on-chip lens 421 formed on the adjacent first photoelectric conversion unit 101i. For example, the on-chip lens 421-13 formed on the first photoelectric conversion unit 101i-4 of the unit pixel 100i-4 is formed in a size in contact with the on-chip lens 421-10 formed on the first photoelectric conversion unit 101i-3 of the unit pixel 100i-3 adjacent to the unit pixel 100i-4 on the left side.

The on-chip lens 421-13 formed on the first photoelectric conversion unit 101i-4 of the unit pixel 100i-4 is formed in a size in contact with the on-chip lens 421-7 formed on the first photoelectric conversion unit 101i-2 of the unit pixel 100i-2 with the upper side adjacent to the unit pixel 100i-4.

As described above, the on-chip lens 421 disposed on the first photoelectric conversion unit 101i serving as the large pixel is formed with a maximum size and is configured to improve the sensitivity of the first photoelectric conversion unit 101i.

A sectional configuration example in Fig. 29 will be referred to below. The sectional configuration of the unit pixel 100i in Fig. 29 is basically identical to that of the unit pixel 100i in Fig. 28, and the position of the on-chip lens 421 is different. Thus, only different points will be described below.

The center position of an inter-pixel isolation portion 132i-2 formed between the first photoelectric conversion unit 101i-1 and the second photoelectric conversion unit 102i-1 is denoted as a position P11. The position of a boundary between the on-chip lens 421-3 and the on-chip lens 421-4 is denoted as a position P12. The position of the end of the on-chip lens 421-4 is denoted as a position P13. The position of the end of the on-chip lens 421-7 is denoted as a position P14.

The on-chip lens 421-3 provided on the first photoelectric conversion unit 101i-1 is formed to a position that covers the inter-pixel isolation portion 132i-2. In the example illustrated in Fig. 29, the on-chip lens 421-3 is formed to the position P12. The position P12 is the position of a side of the inter-pixel isolation portion 132i-2 near the second photoelectric conversion unit 102i-1. In other words, the on-chip lenses 421-3 is formed over the position P11 to the position P12 near the second photoelectric conversion unit 102i-1.

As described above, the on-chip lens 421 formed on the first photoelectric conversion unit 101i is formed in a large size to a position that covers the inter-pixel isolation portion 132i. Thus, the sensitivity of the first photoelectric conversion unit 101i serving as the large pixel can be improved.

The on-chip lens 421-4 provided on the second photoelectric conversion unit 102i is provided between the inter-pixel isolation portion 132i-2 and an inter-pixel isolation portion 132i-3. In Fig. 29, the on-chip lens 421-4 is formed between the position P12 and the position P13.

The on-chip lens 421 is not formed in a region between the on-chip lens 421-4 and the on-chip lens 421-7 adjacent to the on-chip lens 421-4 on the right side of Fig. 29. In Fig. 29, the end of the on-chip lens 421-4 is located at the position P13, and the end of the on-chip lens 421-7 is located at the position P14. The on-chip lens 421 is not formed in a region between the position P13 and the position P14. In other words, the on-chip lens 421-4 and the on-chip lens 421-7 are formed in a separated state.

The on-chip lenses 421-4 is an on-chip lens 421 formed on the second photoelectric conversion unit 102i serving as the small pixel, and the on-chip lens 421-7 is an on-chip lens 421 formed on the first photoelectric conversion unit 101i-2 included in the adjacent unit pixel 100i. As described above, the on-chip lens 421 serving as a small pixel and the on-chip lens 421 serving as a large pixel in an adjacent unit pixel are formed in a separated state.

Thus, the influence from the pixel in a different color can be reduced on the second photoelectric conversion unit 102i serving as a small pixel, thereby suppressing color mixture.

The ninth embodiment can be implemented in combination with one or more of the second to seventh embodiments.

### <Tenth Embodiment>

A unit pixel 100j according to a tenth embodiment will be described below. The tenth embodiment relates to the layout, size, and shape of an on-chip lens. Fig. 30 illustrates the four unit pixels 100j in a 2 by 2 array disposed in a pixel array unit 11 (Fig. 1). Fig. 31 illustrates a sectional configuration example of the unit pixel 100j taken along line A-B of Fig. 30.

The unit pixel 100j in Fig. 30 is configured with a first photoelectric conversion unit 101j in an L-shape and a second photoelectric conversion unit 102j in a square shape like the unit pixels 100h in Fig. 26. The unit pixel 100j in Fig. 30 is different from the unit pixel 100h according to the eighth embodiment in the shape, size, and position or the like of an on-chip lens 441 provided on each of a first photoelectric conversion unit 101j and a second photoelectric conversion unit 102j. Other points are identical to those of the unit pixel 100h and thus the explanation of identical portions is omitted as necessary.

On-chip lenses 441-1 to 441-3 are provided on a first photoelectric conversion unit 101j-1, and an on-chip lens 441-4 is provided on a second photoelectric conversion unit 102j-1. Similarly, on-chip lenses 441-5 to 441-7 are provided on a first photoelectric conversion unit 101j-2, and an on-chip lens 441-8 is provided on a second photoelectric conversion unit 102j-2.

Likewise, on-chip lenses 441-9 to 441-11 are provided on a first photoelectric conversion unit 101j-3, and an on-chip lens 441-12 is provided on a second photoelectric conversion unit 102j-3. Similarly, on-chip lenses 441-13 to 441-15 are provided on a first photoelectric conversion unit 101j-4, and an on-chip lens 441-16 is provided on a second photoelectric conversion unit 102j-4.

The unit pixel 100j-1 will be referred to below. The on-chip lenses 441-1 to 441-3 are provided on the first photoelectric conversion unit 101j-1 of a unit pixel 100j-1. Among the on-chip lenses 441-1 to 441-3, the on-chip lens 441-1 is shaped like a circle and the on-chip lens 441-2 and the on-chip lens 441-3 are shaped like ellipses.

The on-chip lens 441-4 disposed on the second photoelectric conversion unit 102j-1 is shaped like a circle in a smaller size than the on-chip lenses 441-1 to 441-3. In a comparison of the sizes of the four on-chip lenses 441-1 to 441-4 disposed on the unit pixel 100j, the relationship of the on-chip lens 441-1 > the on-chip lens 441-2 = the on-chip lens 441-3 > the on-chip lens 441-4 is satisfied.

The plurality of (in this case, four) on-chip lenses 441 disposed in the unit pixel 100j are formed in different sizes and shapes. Thus, the on-chip lens 441 covering the first photoelectric conversion unit 101j can be increased in size and can be disposed with a minimum gap, thereby improving the sensitivity of the first photoelectric conversion unit 101j.

In the first photoelectric conversion unit 101j illustrated in Fig. 30, the on-chip lens 441-1 like a large circle, the on-chip lens 441-2 like an oval having the major axis in the longitudinal direction of Fig. 30 on the left side of the on-chip lenses 441-1, and the on-chip lenses 441-3 like an oval having the major axis in the horizontal direction of Fig. 30 on the lower side of the on-chip lenses 441-1 can be with a minimum gap, thereby improving the sensitivity of the first photoelectric conversion unit 101j.

Regarding the on-chip lenses 441-1 to 441-4 disposed in the unit pixel 100j-1, the ends of the circular on-chip lens 441-1 and the oval on-chip lens 441-2 are partially placed in contact with each other. Furthermore, the ends of the circular on-chip lens 441-1 and the oval on-chip lens 441-3 are also partially placed in contact with each other. The end of the circular on-chip lens 441-4 disposed on the second photoelectric conversion unit 102j-1 is partially placed in contact with the end of the oval on-chip lens 441-2 and the end of the oval on-chip lens 441-3.

As described above, the on-chip lenses 441-1 to 441-4 disposed in the unit pixel 100j-1 are formed with contact positions. The on-chip lens 441-4 disposed on the second photoelectric conversion unit 102j-1 is formed with positions of contact with the on-chip lenses 441 in the unit pixel 100j-1 without making contact with the on-chip lenses 441 formed in other unit pixels 100j-2 to 100j-4 adjacent to the unit pixel 100j-1.

The oval on-chip lens 441-7 formed in the unit pixel 100j-2 adjacent to the unit pixel 100j-1 on the right side and the circular on-chip lens 441-4 formed in the second photoelectric conversion unit 102j-1 of the unit pixel 100j-1 are formed in a separated state. The oval on-chip lens 441-10 formed in the unit pixel 100j-3 adjacent to the unit pixel 100j-1 on the lower left side and the circular on-chip lens 441-4 formed in the second photoelectric conversion unit 102j-1 of the unit pixel 100j-1 are formed in a separated state.

As described above, in the unit pixel 100j, the circular on-chip lens 441 disposed on the second photoelectric conversion unit 102 is formed with a position of contact with the oval on-chip lens 441 disposed on the first photoelectric conversion unit 101j. Along with the adjacent unit pixel 100j, the circular on-chip lens 441 disposed on the second photoelectric conversion unit 102 is formed without a position of contact with the oval on-chip lens 441 disposed on the first photoelectric conversion unit 101j included in another unit pixel 100j.

In other words, the on-chip lens 441 of the second photoelectric conversion unit 102j serving as a small pixel is disposed at a distance from the on-chip lens 441 of the first photoelectric conversion unit 101j in a different color such that influence from a large pixel in a different color is eliminated. Thus, the influence from the pixel in a different color can be reduced on the second photoelectric conversion unit 102j serving as a small pixel, thereby suppressing color mixture.

The on-chip lens 441 formed on the first photoelectric conversion unit 101j is formed in a size with a position of contact with the on-chip lens 441 formed on the adjacent first photoelectric conversion unit 101j. For example, the circular on-chip lens 441-13 formed on the first photoelectric conversion unit 101j-4 of the unit pixel 100j-4 is formed in a size in contact with the oval on-chip lens 441-10 formed on the first photoelectric conversion unit 101j-3 of the unit pixel 100j-3 adjacent to the unit pixel 100j-4 on the left side.

The circular on-chip lens 441-13 formed on the first photoelectric conversion unit 101j-4 of the unit pixel 100j-4 is formed in a size in contact with the oval on-chip lens 441-7 formed on the first photoelectric conversion unit 101j-2 of the unit pixel 100j-2 adjacent to the unit pixel 100j-4 on the upper side.

As described above, the on-chip lens 441 disposed on the first photoelectric conversion unit 101j serving as the large pixel is formed with a maximum size, and the first photoelectric conversion unit 101i is formed with a minimum gap, thereby improving the sensitivity of the first photoelectric conversion unit 101j.

A sectional configuration example in Fig. 31 will be referred to below. The sectional configuration of the unit pixel 100j in Fig. 31 is basically identical to that of the unit pixel 100i in Fig. 29, and the position of the on-chip lens 441 is different. Thus, only different points will be described below.

The center position of an inter-pixel isolation portion 132j-2 formed between the first photoelectric conversion unit 101j-1 and the second photoelectric conversion unit 102j-1 is denoted as a position P21. The position of a boundary between the on-chip lens 441-3 and the on-chip lens 441-4 is denoted as a position P22. The position of the end of the on-chip lens 441-4 is denoted as a position P23. The position of the end of the on-chip lens 441-7 is denoted as a position P24.

The surface of the on-chip lens 441-3 provided on the first photoelectric conversion unit 101j-1 is oval in plan view and thus forms a gentler curve than the circular on-chip lens 441 in cross section. The on-chip lens 441-3 is formed to a position that covers an inter-pixel isolation portion 132j-2. In the example illustrated in Fig. 31, the on-chip lens 441-3 is formed to the position P22. The position P22 is the position of a side of the inter-pixel isolation portion 132j-2 near the second photoelectric conversion unit 102j-1. In other words, the on-chip lens 441-3 is formed over the position P21 to the position P22 near the second photoelectric conversion unit 1 02j -1.

As described above, the on-chip lens 441 formed on the first photoelectric conversion unit 101j is formed in a large size to a position that covers the inter-pixel isolation portion 132j. Thus, the sensitivity of the first photoelectric conversion unit 101j serving as the large pixel can be improved.

The on-chip lens 441-4 provided on the second photoelectric conversion unit 102j is provided between the inter-pixel isolation portion 132j-2 and an inter-pixel isolation portion 132j-3. In Fig. 31, the on-chip lens 441-4 is formed between the position P22 and the position P23.

The on-chip lens 441 is not formed in a region between the on-chip lens 441-4 and the on-chip lens 441-7 adjacent to the on-chip lens 441-4 on the right side of Fig. 31. In Fig. 31, the end of the on-chip lens 441-4 is located at the position P23, and the end of the on-chip lens 441-7 is located at the position P24. The on-chip lens 441 is not formed in a region between the position P23 and the position P24. In other words, the on-chip lens 441-4 and the on-chip lens 441-7 are formed in a separated state.

The on-chip lenses 441-4 is an on-chip lens 441 formed on the second photoelectric conversion unit 102j serving as the small pixel, and the on-chip lens 441-7 is an on-chip lens 441 formed on the first photoelectric conversion unit 101j-2 included in the adjacent unit pixel 100j. As described above, the on-chip lens 441 serving as a small pixel and the on-chip lens 441 serving as a large pixel in an adjacent unit pixel are formed in a separated state.

Thus, the influence from the pixel in a different color can be reduced on the second photoelectric conversion unit 102j serving as a small pixel, thereby suppressing color mixture.

The tenth embodiment can be implemented in combination with one or more of the second to seventh embodiments.

### <Eleventh Embodiment>

A unit pixel 100k according to an eleventh embodiment will be described below. The eleventh embodiment relates to the layout, size, and shape of an on-chip lens. Fig. 32 illustrates the four unit pixels 100k in a 2 by 2 array disposed in a pixel array unit 11 (Fig. 1). Fig. 33 illustrates a sectional configuration example of the unit pixel 100k taken along line A-B of Fig. 32.

The unit pixel 100k in Fig. 32 is configured with a first photoelectric conversion unit 101k in an L-shape and a second photoelectric conversion unit 102k in a square shape like the unit pixels 100h in Fig. 26. The unit pixel 100k in Fig. 32 is different from the unit pixel 100h according to the eighth embodiment in the shape, size, and position or the like of an on-chip lens 461 provided on each of a first photoelectric conversion unit 101k and a second photoelectric conversion unit 102k. Other points are identical to those of the unit pixel 100h and thus the explanation of identical portions is omitted as necessary.

The first photoelectric conversion unit 101k-1 is provided with on-chip lenses 461-1 and 461-2, and the second photoelectric conversion unit 102k-1 is provided with an on-chip lens 461-3. Similarly, on-chip lenses 461-4 and 461-5 are provided on a first photoelectric conversion unit 101k-2, and an on-chip lens 461-6 is provided on a second photoelectric conversion unit 102k-2.

Likewise, on-chip lenses 461-7 and 461-8 are provided on a first photoelectric conversion unit 101k-3, and an on-chip lens 461-9 is provided on a second photoelectric conversion unit 102k-3. Similarly, on-chip lenses 461-10 and 461-11 are provided on a first photoelectric conversion unit 101k-4, and an on-chip lens 461-12 is provided on a second photoelectric conversion unit 102k-4.

The unit pixel 100k-1 will be referred to below. The on-chip lenses 461-1 and 461-2 provided on the first photoelectric conversion unit 101k-1 of the unit pixels 100k-1 are both formed in square shapes. If it is assumed that the L-shaped first photoelectric conversion unit 101k-1 is divided into three, two thirds of the first photoelectric conversion unit 101k-1 are covered with the on-chip lens 461-1 and the other one third is covered with the on-chip lens 461-2.

In the example illustrated in Fig. 32, the on-chip lens 461-1 is formed into a rectangle having long sides in the horizontal direction and short sides in the vertical direction. The on-chip lens 461-2 is also formed into a rectangle having long sides in the horizontal direction and short sides in the vertical direction like the on-chip lens 461-1 but has a smaller area than the on-chip lens 461-1.

The on-chip lens 461-3 disposed on the second photoelectric conversion unit 102k-1 is shaped like a circle in a smaller size than the on-chip lenses 461-1 and 461-2. In a comparison of the sizes of the three on-chip lenses 461-1 to 461-3 disposed on the unit pixel 100k, the relationship of the on-chip lens 461-1 > the on-chip lens 461-2 > the on-chip lens 461-3 is satisfied.

The second photoelectric conversion unit 102k can also be square-shaped like the first photoelectric conversion unit 101k.

The plurality of (in this case, three) on-chip lenses 461 disposed in the unit pixel 100k are formed in different sizes and shapes. Thus, the on-chip lens 461 covering the first photoelectric conversion unit 101k can be increased in size, thereby improving the sensitivity of the first photoelectric conversion unit 101k. In other words, in the first photoelectric conversion unit 101k illustrated in Fig. 32, the square on-chip lenses 461 are disposed in combination in an L-shape with a minimum gap like the L-shaped first photoelectric conversion unit 101k, thereby improving the sensitivity of the first photoelectric conversion unit 101k.

Regarding the on-chip lenses 461-1 to 461-3 disposed in the unit pixel 100k-1, the sides of the square on-chip lens 461-1 and the square on-chip lens 461-2 are in contact with each other. The end of the circular on-chip lens 461-2 disposed on the second photoelectric conversion unit 102k-1 is partially placed in contact with a part of a side of the square on-chip lens 461-1 and a part of the square on-chip lens 461-2.

As described above, the on-chip lenses 461-1 to 461-3 disposed in the unit pixel 100k-1 are formed with contact positions. The on-chip lens 461-3 disposed on the second photoelectric conversion unit 102k-1 is formed with positions of contact with the on-chip lenses 461 in the unit pixel 100k-1 without making contact with the on-chip lenses 461 formed in other unit pixels 100k-2 to 100k-4 adjacent to the unit pixel 100k-1.

The square on-chip lens 461-5 formed in the unit pixel 100k-2 adjacent to the unit pixel 100k-1 on the right side and the circular on-chip lens 461-3 formed in the second photoelectric conversion unit 102k-1 of the unit pixel 100k-1 are formed in a separated state. The square on-chip lens 461-7 formed in the unit pixel 100k-3 adjacent to the unit pixel 100k-1 on the lower left side and the circular on-chip lens 461-3 formed in the second photoelectric conversion unit 102k-1 of the unit pixel 100k-1 are formed in a separated state.

As described above, in the unit pixel 100k, the circular on-chip lens 461 disposed on the second photoelectric conversion unit 102 is formed with a position of contact with the square on-chip lens 461 disposed on the first photoelectric conversion unit 101k. Along with the adjacent unit pixel 100k, the circular on-chip lens 461 disposed on the second photoelectric conversion unit 102 is formed without a position of contact with the square on-chip lens 461 disposed on the first photoelectric conversion unit 101k included in another unit pixel 100k.

In other words, the on-chip lens 461 of the second photoelectric conversion unit 102k serving as a small pixel is disposed at a distance from the on-chip lens 461 of the first photoelectric conversion unit 101k in a different color such that influence from a large pixel in a different color is eliminated. Thus, the influence from the pixel in a different color can be reduced on the second photoelectric conversion unit 102k serving as a small pixel, thereby suppressing color mixture.

The on-chip lens 461 formed on the first photoelectric conversion unit 101k is formed in a size with a position of contact with the on-chip lens 461 formed on the adjacent first photoelectric conversion unit 101k. For example, the square on-chip lens 461-10 formed on the first photoelectric conversion unit 101k-4 of the unit pixel 100k-4 is formed in a size with a side in contact with the square on-chip lens 461-7 formed on the first photoelectric conversion unit 101k-3 of the unit pixel 100k-3 adjacent to the unit pixel 100k-4 on the left side.

The square on-chip lens 461-10 formed on the first photoelectric conversion unit 101k-4 of the unit pixel 100k-4 is formed in a size with a side in contact with a side of the square on-chip lens 461-5 formed on the first photoelectric conversion unit 101k-2 of the unit pixel 100k-2 adjacent to the unit pixel 100k-4 on the upper side.

As described above, the on-chip lens 461 disposed on the first photoelectric conversion unit 101k serving as the large pixel is formed with a maximum size, and the first photoelectric conversion unit 101i is formed with a minimum gap, thereby improving the sensitivity of the first photoelectric conversion unit 101k.

In this example, the two square-shaped on-chip lenses 461k are disposed on the first photoelectric conversion unit 101k. The single on-chip lens 461k in an L shape may be disposed instead.

A sectional configuration example in Fig. 33 will be referred to below. The sectional configuration of the unit pixel 100k in Fig. 33 is basically identical to that of the unit pixel 100h in Fig. 27, and the position of the on-chip lens 461 is different. Thus, only different points will be described below.

The center position of an inter-pixel isolation portion 132k-2 formed between the first photoelectric conversion unit 101k-1 and the second photoelectric conversion unit 102k-1 is denoted as a position P31. The position of a boundary between the on-chip lens 461-2 and the on-chip lens 461-3 is denoted as a position P32. The position of the end of the on-chip lens 461-3 is denoted as a position P33. The position of the end of the on-chip lens 461-5 is denoted as a position P34.

The on-chip lens 461-2 provided on the first photoelectric conversion unit 101k-1 is formed to a position that covers the inter-pixel isolation portion 132k-2. In the example illustrated in Fig. 33, the on-chip lens 461-2 is formed to the position P32. The position P32 is the position of a side of the inter-pixel isolation portion 132k-2 near the second photoelectric conversion unit 102k-1. In other words, the on-chip lens 461-2 is formed over the position P31 to the position P32 near the second photoelectric conversion unit 102k-1.

As described above, the on-chip lens 461 formed on the first photoelectric conversion unit 101k is formed in a large size to a position that covers the inter-pixel isolation portion 132k. Thus, the sensitivity of the first photoelectric conversion unit 101k serving as the large pixel can be improved.

The on-chip lens 461-3 provided on the second photoelectric conversion unit 102k is provided between the inter-pixel isolation portion 132k-2 and an inter-pixel isolation portion 132k-3. In Fig. 33, the on-chip lens 461-3 is formed between the position P32 and the position P33.

The on-chip lens 461 is not formed in a region between the on-chip lens 461-3 and the on-chip lens 461-5 adjacent to the on-chip lens 461-3 on the right side of Fig. 33. In Fig. 29, the end of the on-chip lens 461-3 is located at the position P33, and the end of the on-chip lens 461-5 is located at the position P34. The on-chip lens 461 is not formed in a region between the position P33 and the position P34. In other words, the on-chip lens 461-3 and the on-chip lens 461-5 are formed in a separated state.

The on-chip lenses 461-3 is an on-chip lens 461 formed on the second photoelectric conversion unit 102k serving as the small pixel, and the on-chip lens 461-5 is an on-chip lens 461 formed on the first photoelectric conversion unit 101k-2 included in the adjacent unit pixel 100k. As described above, the on-chip lens 461 serving as a small pixel and the on-chip lens 461 serving as a large pixel in an adjacent unit pixel are formed in a separated state.

Thus, the influence from the pixel in a different color can be reduced on the second photoelectric conversion unit 102k serving as a small pixel, thereby suppressing color mixture.

The eleventh embodiment can be implemented in combination with one or more of the second to seventh embodiments.

### <Twelfth Embodiment>

A unit pixel 100m according to a twelfth embodiment will be described below. The twelfth embodiment relates to the layout, size, and shape of an on-chip lens. Fig. 34 illustrates the four unit pixels 100m in a 2 by 2 array disposed in a pixel array unit 11 (Fig. 1). Fig. 34 illustrates a sectional configuration example of the unit pixel 100m taken along line A-B of Fig. 33.

The unit pixel 100m according to the twelfth embodiment is different from the unit pixel 100i according to ninth embodiment in Fig. 28 in that an on-chip lens 481 provided on a first photoelectric conversion unit 101m is formed larger than that of the unit pixel 100i. Other points are identical to those of the unit pixel 100i and thus the explanation of identical portions is omitted as necessary.

A first photoelectric conversion unit 101m-1 is provided with on-chip lenses 481-1 to 481-3, and a second photoelectric conversion unit 102m-1 is provided with an on-chip lens 481-4. Similarly, on-chip lenses 481-5 to 481-7 are provided on a first photoelectric conversion unit 101m-2, and an on-chip lens 481-8 is provided on a second photoelectric conversion unit 102m-2.

Likewise, on-chip lenses 481-9 to 481-11 are provided on a first photoelectric conversion unit 101m-3, and an on-chip lens 481-12 is provided on a second photoelectric conversion unit 102m-3. Similarly, on-chip lenses 481-13 to 481-15 are provided on a first photoelectric conversion unit 101m-4, and an on-chip lens 481-16 is provided on a second photoelectric conversion unit 102m-4.

A unit pixel 100m-1 will be referred to below. The on-chip lenses 481-1 to 481-3 are provided on the first photoelectric conversion unit 101m-1 of the unit pixel 100m-1. Among the on-chip lenses 481-1 to 481-3, the on-chip lens 481-1 is shaped like a circle smaller than the on-chip lenses 481-2 and 411-3.

The on-chip lens 481-1 is formed smaller than the on-chip lens 421-1 of the unit pixel 100i in Fig. 28. The on-chip lens 421-1 of the unit pixel 100i in Fig. 28 is extended to the inter-pixel isolation portion 132i, whereas the on-chip lens 481-1 of the unit pixel 100m in Fig. 34 is formed within an inter-pixel isolation portion 132m.

Since the on-chip lens 481-1 is formed in a small size, the on-chip lenses 481-2 and 411-3 are formed in a large size. As will be described later, the on-chip lenses 481-2 and 411-3 are formed so large as to make contact with the on-chip lens 481 formed on the second photoelectric conversion unit 102m of another adjacent unit pixel 100m.

The on-chip lens 481-4 disposed on the second photoelectric conversion unit 102m-1 is as large as the on-chip lens 481-1 and is smaller than the on-chip lenses 481-2 and 481-3. In a comparison of the sizes of the four on-chip lenses 481-1 to 481-4 disposed on the unit pixel 100m, the relationship of the on-chip lens 481-2 = the on-chip lens 481-3 > the on-chip lens 481-1 = the on-chip lens 481-4 is satisfied.

The plurality of (in this case, four) on-chip lenses 481 disposed in the unit pixel 100m are formed in different sizes. Thus, the on-chip lens 481 covering the first photoelectric conversion unit 101m can be increased in size, thereby improving the sensitivity of the first photoelectric conversion unit 101m. In other words, in the first photoelectric conversion unit 101m illustrated in Fig. 34, the on-chip lenses 481 can be disposed with a minimum gap, thereby improving the sensitivity of the first photoelectric conversion unit 101m.

Regarding the on-chip lenses 481-1 to 481-4 disposed in the unit pixel 100m-1, the ends of the on-chip lens 481-1 and the on-chip lens 481-2 are partially placed in contact with each other, and the ends of the on-chip lens 481-1 and the on-chip lens 481-3 are also partially placed in contact with each other. The end of the on-chip lens 481-4 disposed on the second photoelectric conversion unit 102m-1 is partially placed in contact with the end of the on-chip lens 481-2 and the end of the on-chip lens 481-3.

As described above, the on-chip lenses 481-1 to 481-4 disposed in the unit pixel 100m-1 are formed with contact positions. The on-chip lens 481-4 disposed on the second photoelectric conversion unit 102m-1 is formed with a position of contact with the on-chip lens 481 in the unit pixel 100m-1. The on-chip lens 481-4 disposed on the second photoelectric conversion unit 102m-1 is formed in contact with the on-chip lenses 481 formed on other unit pixels 100m-2 to 100m-4 adjacent to the unit pixel 100m-1.

The end of the on-chip lens 481-7 formed in the unit pixel 100m-2 adjacent to the unit pixel 100m-1 on the right side and the end of the on-chip lens 481-4 formed on the second photoelectric conversion unit 102m-1 of the unit pixel 100m-1 are formed with contact positions. The end of the on-chip lens 481-10 formed in the unit pixel 100m-3 adjacent to the unit pixel 100m-1 on the lower left side and the end of the on-chip lens 481-4 formed on the second photoelectric conversion unit 102m-1 of the unit pixel 100m-1 are formed with contact positions.

The on-chip lens 481 disposed on the first photoelectric conversion unit 101m is formed so large as to make partial contact with the on-chip lens 481 disposed on the second photoelectric conversion unit 102m in the adjacent unit pixel 100m.

As described above, in the unit pixel 100m, the on-chip lens 481 disposed on the second photoelectric conversion unit 102 is formed with a position of contact with the on-chip lens 481 disposed on the first photoelectric conversion unit 101m. Along with the adjacent unit pixel 100m, the on-chip lens 481 disposed on the second photoelectric conversion unit 102 is formed with a position of contact with the on-chip lens 481 disposed on the first photoelectric conversion unit 101m included in another unit pixel 100m.

The on-chip lens 481 formed on the first photoelectric conversion unit 101m is formed in a size with a position of contact with the on-chip lens 481 formed on the adjacent first photoelectric conversion unit 101m. For example, the on-chip lens 481-13 formed on the first photoelectric conversion unit 101m-4 of the unit pixel 100m-4 is formed in a size in contact with the on-chip lens 481-10 formed on the first photoelectric conversion unit 101m-3 of the unit pixel 100m-3 adjacent to the unit pixel 100m-4 on the left side.

The on-chip lens 481-13 formed on the first photoelectric conversion unit 101m-4 of the unit pixel 100m-4 is formed in a size in contact with the on-chip lens 481-7 formed on the first photoelectric conversion unit 101m-2 of the unit pixel 100m-2 adjacent to the unit pixel 100m-4 on the upper side.

As described above, the on-chip lens 481 provided on the first photoelectric conversion unit 101m serving as a large pixel is formed with a maximum size and is configured to improve the sensitivity of the first photoelectric conversion unit 101m.

A sectional configuration example in Fig. 35 will be referred to below. The sectional configuration of the unit pixel 100m in Fig. 35 is basically identical to that of the unit pixel 100i in Fig. 29, and the position and size of the on-chip lens 481 are different. Thus, only different points will be described below.

The center position of an inter-pixel isolation portion 132m-2 formed between the first photoelectric conversion unit 101m-1 and the second photoelectric conversion unit 102m-1 is denoted as a position P51. The position of a boundary between the on-chip lens 481-3 and the on-chip lens 481-4 is denoted as a position P52. The position of a boundary between the on-chip lens 481-4 and the on-chip lens 481-7 is denoted as a position P53. The center position of an inter-pixel isolation portion 132m-3 formed between the second photoelectric conversion unit 102m-1 and the first photoelectric conversion unit 101m-2 is denoted as a position P54.

The on-chip lens 481-3 provided on the first photoelectric conversion unit 101m-1 is formed to a position that covers the inter-pixel isolation portion 132m-2. In the example illustrated in Fig. 35, the on-chip lens 481-3 is formed to the position P52. The position P52 is the position of a side of the inter-pixel isolation portion 132m-2 near the second photoelectric conversion unit 102m-1. In other words, the on-chip lens 481-3 is formed over the position P51 to the position P52 near the second photoelectric conversion unit 102m-1.

The on-chip lens 481-4 provided on the second photoelectric conversion unit 102m-1 is provided between the inter-pixel isolation portion 132m-2 and the inter-pixel isolation portion 132m-3. In Fig. 35, the on-chip lens 481-4 is formed between the position P52 and the position P53.

The on-chip lens 481-7 provided on the first photoelectric conversion unit 101m-2 on the right side of Fig. 35 is formed to a position that covers the inter-pixel isolation portion 132m-3. In the example illustrated in Fig. 35, the on-chip lens 481-7 is formed to the position P53. The position P53 is the position of a side of the inter-pixel isolation portion 132m-3 near the second photoelectric conversion unit 102m-1.

In other words, the on-chip lens 481-7 is formed over the position P54 to the position P53 near the second photoelectric conversion unit 102m-1.

As described above, the on-chip lens 481 formed on the first photoelectric conversion unit 101m is formed in a large size to a position that covers the inter-pixel isolation portion 132m. The on-chip lens 481 formed on the first photoelectric conversion unit 101m is formed without a region separating the on-chip lens 481 formed on the adjacent second photoelectric conversion unit 102m, that is, in contact with the on-chip lens 481, so that the on-chip lens 481 can be formed in a large size. Thus, the sensitivity of the first photoelectric conversion unit 101m serving as the large pixel can be improved.

The twelfth embodiment can be implemented in combination with one or more of the second to seventh embodiments.

### <Thirteenth Embodiment>

A unit pixel 100n according to a thirteenth embodiment will be described below.

Fig. 36 is an explanatory drawing showing a difference in refractive index according to the wavelength of light incident on the on-chip lens 501. Even if light enters at the same point and at the same angle of the on-chip lens 501, the light is refracted according to the wavelength of the incident light and travels in different directions after entering the lens.

The refractive index on the on-chip lens 501 decreases in the order of the wavelength of incident light, that is, blue (B), green (G), and red (R). As shown in Fig. 36, in the case of blue (B) incident light, the light has a high refractive index and thus travels toward the central direction of a pixel. In the case of red (R) incident light, the light has a low refractive index and thus is hardly refracted while traveling. In the case of green (G) incident light, the light has a lower refractive index than blue but higher than red and thus travels in a direction between the direction of blue and the direction of red.

A difference in refractive index is represented as the degree of gathering light to the center of the pixel, in other words, a difference in the light-gathering capability of the on-chip lens 501. The on-chip lens 501 in Fig. 36 is assumed to be highly capable of gathering blue light but less capable of gathering red light. An adjustment of the size of the on-chip lens 501 according to a difference in light-gathering capability will be described as the thirteenth embodiment.

If the on-chip lens 501 transmits a wavelength of light with high light-gathering capability, the on-chip lens 501 is less likely to leak light into an adjacent pixel and thus is designed as large as possible. If the on-chip lens 501 transmits a wavelength of light with low light-gathering capability, the on-chip lens 501 is more likely to leak light into an adjacent pixel and thus is designed as large as possible without affecting an adjacent pixel.

Fig. 37 illustrates a plan configuration example of a unit pixel 100n configured with a first photoelectric conversion unit 101n and a second photoelectric conversion unit 102n according to the thirteenth embodiment.

A first photoelectric conversion unit 101Gr is provided with on-chip lenses 501-1 to 501-3, and a second photoelectric conversion unit 102Gr is provided with an on-chip lens 501-4. A unit pixel configured with the first photoelectric conversion unit 101Gr and the second photoelectric conversion unit 102Gr is denoted as a unit pixel 100Gr. The unit pixel 100Gr is a pixel that has a color filter of green and processes green light.

A first photoelectric conversion unit 101R is provided with on-chip lenses 501-5 to 501-7, and a second photoelectric conversion unit 102R is provided with an on-chip lens 501-8. A unit pixel configured with the first photoelectric conversion unit 101R and the second photoelectric conversion unit 102R is denoted as a unit pixel 100R. The unit pixel 100R is a pixel that has a color filter of red and processes red light.

A first photoelectric conversion unit 101B is provided with on-chip lenses 501-9 to 501-11, and a second photoelectric conversion unit 102B is provided with an on-chip lens 501-12.

A unit pixel configured with the first photoelectric conversion unit 101B and the second photoelectric conversion unit 102B is denoted as a unit pixel 100B. The unit pixel 100B is a pixel that has a color filter of blue and processes blue light.

A first photoelectric conversion unit 101Gb is provided with on-chip lenses 501-13 to 501-15, and a second photoelectric conversion unit 102Gb is provided with an on-chip lens 501-16. A unit pixel configured with the first photoelectric conversion unit 101Gb and the second photoelectric conversion unit 102Gb is denoted as a unit pixel 100Gb. The unit pixel 100Gb is a pixel that has a color filter of green and processes green light.

The on-chip lenses 501-1 to 501-3 are provided on the first photoelectric conversion unit 101Gr of the unit pixel 100Gr. Among the on-chip lenses 501-1 to 501-3, the on-chip lens 501-1 is shaped like a circle smaller than the on-chip lenses 501-2 and 501-3. The on-chip lenses 501-2 and 501-3 are formed into ellipses close to circles. The minor axes of the on-chip lenses 501-2 and 501-3 are denoted as minor axes Gr.

Regarding the on-chip lenses 501-1 to 501-4 disposed in the unit pixel 100Gr, the ends of the circular on-chip lens 501-1 and the oval on-chip lens 501-2 are partially placed in contact with each other. Furthermore, the ends of the circular on-chip lens 501-1 and the oval on-chip lens 501-3 are also partially placed in contact with each other.

The circular on-chip lens 501-4 disposed on the second photoelectric conversion unit 102Gr and the oval on-chip lens 501-2 are formed in a separated state. Likewise, the circular on-chip lens 501-4 disposed on the second photoelectric conversion unit 102Gr and the oval on-chip lens 501-3 are formed in a separated state.

The minor axes Gr of the on-chip lenses 501-2 and 501-3 are set to keep the relationship.

The on-chip lenses 501-5 to 501-7 are provided on the first photoelectric conversion unit 101R of the unit pixel 100R. Among the on-chip lenses 501-5 to 501-7, the on-chip lens 501-5 is shaped like a circle smaller than the on-chip lenses 501-6 and 501-7. The on-chip lenses 501-6 and 501-7 are formed into ellipses. The minor axes of the on-chip lenses 501-6 and 501-7 are denoted as minor axes R.

Regarding the on-chip lenses 501-5 to 501-8 disposed in the unit pixel 100R, the ends of the circular on-chip lens 501-5 and the oval on-chip lens 501-6 are partially placed in contact with each other. Furthermore, the ends of the circular on-chip lens 501-5 and the oval on-chip lens 501-7 are also partially placed in contact with each other.

The circular on-chip lens 501-8 disposed on the second photoelectric conversion unit 102R and the oval on-chip lens 501-6 are formed in a separated state. Likewise, the circular on-chip lens 501-8 disposed on the second photoelectric conversion unit 102R and the oval on-chip lens 501-7 are formed in a separated state.

The minor axes R of the on-chip lenses 501-6 and 501-7 are set to keep the relationship. The minor axis R is shorter than the minor axis Gr. If a distance between the on-chip lens 501-2 and the on-chip lens 501-4 that are disposed on the unit pixel 100Gr is denoted as a distance Gr and a distance between the on-chip lens 501-5 and the on-chip lens 501-8 that are disposed on the unit pixel 100R is denoted as a distance R, the relationship of the distance Gr < the distance R is satisfied.

As described with reference to Fig. 36, green (Gr) has a higher refractive index than red (R) on the on-chip lens 501. If the on-chip lens 501 has a large size with a high refractive index and is likely to leak light into an adjacent pixel, the size of the on-chip lens 501 is set to satisfy the relationship of the minor axis Gr > the minor axis R.

Regarding the on-chip lenses 501-9 to 501-12 disposed in the unit pixel 100B, the ends of the circular on-chip lens 501-9 and the circular on-chip lens 501-10 are partially placed in contact with each other. Furthermore, the ends of the circular on-chip lens 501-9 and the circular on-chip lens 501-11 are also partially placed in contact with each other.

The circular on-chip lens 501-12 disposed on the second photoelectric conversion unit 102B and the circular on-chip lens 501-10 are partially placed in contact with each other. Likewise, the circular on-chip lens 501-12 disposed on the second photoelectric conversion unit 102B and the circular on-chip lens 501-11 are partially placed in contact with each other.

Diameters B of the on-chip lenses 501-10 and 501-11 are set to keep the relationship. The diameter B is longer than the minor axis Gr and the minor axis R. The on-chip lenses 501-9 and 501-12 disposed in the unit pixel 100B are not separated from each other, so that a distance B = 0 is obtained where B is a distance between the lenses. The relationship among the distance Gr, the distance R, and the distance B is expressed as the distance R > the distance Gr > the distance B = 0.

As described with reference to Fig. 36, blue (B) has a higher refractive index than green (GB) and red (B) on the on-chip lens 501. If the on-chip lens 501 has a large size with a high refractive index and is likely to leak light into an adjacent pixel, the size of the on-chip lens 501 is set to satisfy the relationship of the diameter B > the minor axis Gr > the minor axis R.

As described above, the on-chip lens 501 disposed on the first photoelectric conversion unit 101n serving as a large pixel is formed with a maximum size, and the first photoelectric conversion unit 101n is formed with a minimum gap, thereby improving the sensitivity of the first photoelectric conversion unit 101n. According to the wavelength of transmitted light, the size of the on-chip lens 501 is changed, in other words, a distance between the on-chip lenses 501 disposed on the large pixel and the small pixel (the first photoelectric conversion unit 101n and the second photoelectric conversion unit 102n) is changed, so that the sensitivity of the first photoelectric conversion unit 101n can be improved and influence on an adjacent pixel can be reduced.

The thirteenth embodiment can be implemented in combination with one or more of the second to twelfth embodiments.

### <Fourteenth Embodiment>

A unit pixel 100p according to a fourteenth embodiment will be described below. The fourteenth embodiment is an embodiment related to the position and size of a light shielding film.

The light shielding film according to the first to thirteenth embodiments will be described again. In this example, the unit pixel 100i according to the ninth embodiment described with reference to Figs. 28 and 29 will be illustrated. Fig. 38 illustrates a plan configuration example of the unit pixel 100i. Fig. 39 illustrates a sectional configuration example taken along line A-B of Fig. 38. The unit pixel 100i-1 illustrated in Figs. 38 and 39 are enlarged views of the unit pixel 100i-1 from among the unit pixels 100i-1 to 100i-4 illustrated in Figs. 28 and 29. Referring to Figs. 28 and 29, a duplicate explanation will be omitted as appropriate.

The plan configuration example of the unit pixel 100i in Fig. 38 will be referred to below. As illustrated in Fig. 38, the unit pixels 100i-1 is surrounded by an inter-pixel isolation portion 132i. The inter-pixel isolation portion 132i is also provided between a first photoelectric conversion unit 101i-1 and a second photoelectric conversion unit 102i-1.

In plan view, a light shielding film 411i is formed in a region where the inter-pixel isolation portion 132i is formed. In Fig. 38, the inter-pixel isolation portion 132i and the light shielding film 411i are formed in the same region in plan view and thus are denoted by reference numerals at the same point.

Referring to a sectional configuration example of the unit pixel 100i in Fig. 39, the unit pixels 100i-1 is surrounded by an inter-pixel isolation portion 132i-1 and an inter-pixel isolation portion 132i-3. An inter-pixel isolation portion 132i-2 is formed between the first photoelectric conversion unit 101i-1 and the second photoelectric conversion unit 102i-1.

Between the inter-pixel isolation portion 132i-1 and an on-chip lens 421-3, a light shielding film 411-1 is formed with the same size (width) at the same position as the inter-pixel isolation portion 132i-1. Between the inter-pixel isolation portion 132i-2 and the on-chip lens 421-3, a light shielding film 411-2 is formed with the same size (width) at the same position as the inter-pixel isolation portion 132i-2. Between the inter-pixel isolation portion 132i-3 and an on-chip lens 421-4, a light shielding film 411-3 is formed with the same size (width) at the same position as the inter-pixel isolation portion 132i-3.

As described above, the inter-pixel isolation portion 132 and the light shielding film 411 can be formed in overlapping regions in plan view.

Referring to Figs. 40 and 41, the inter-pixel isolation portion 132 and the light shielding film 411 may be formed to be displaced from each other in order to extend the opening of the first photoelectric conversion unit 101.

Fig. 40 illustrates a plan configuration example of the unit pixel 100p according to the fourteenth embodiment. Fig. 41 illustrates a sectional configuration example of the unit pixel 100p taken along line A-B of Fig. 40. In the following description, the unit pixel 100i according to the ninth embodiment described with reference to Figs. 28 and 29 is applied to the positions and sizes of the on-chip lenses in the unit pixel 100p illustrated in Figs. 40 and 41.

Referring to Fig. 40, the unit pixel 100p is surrounded by an inter-pixel isolation portion 132p. The inter-pixel isolation portion 132p is also formed between a first photoelectric conversion unit 101p and a second photoelectric conversion unit 102p. The configuration of the inter-pixel isolation portion 132p is identical to those of other embodiments, for example, the unit pixel 100i (Fig. 28) according to the ninth embodiment.

A light shielding film 411p is formed with a region not partially overlapping the inter-pixel isolation portion 132p. In other words, the light shielding film 411p has a region formed at a position displaced from the inter-pixel isolation portion 132p. The region formed at the displaced position is a region displaced to the second photoelectric conversion unit 102p corresponding to a small pixel. According to the displacement, the opening of the first photoelectric conversion unit 101p corresponding to a large pixel is formed larger.

Referring to Figs. 40 and 41, the opening of the first photoelectric conversion unit 101p is formed from a center position P71 of the inter-pixel isolation portion 132p-1 to a center position P74 of an inter-pixel isolation portion 132p-2. A light shielding film 411p-1 is not formed in a region from the position P71 to a position P72 of the inter-pixel isolation portion 132p-1. Likewise, a light shielding film 411p-2 is not formed from a position P73 to the position P74 of the inter-pixel isolation portion 132p-2.

When the center position of the inter-pixel isolation portion 132p-2 is set at the position P74, the light shielding film 411p-2 is formed from the position P74 to a position P76. When the center position between the position P74 and the position P76 is denoted as a position P75, the position P75 is the position of a side of the inter-pixel isolation portion 132p-2 near the second photoelectric conversion unit 102p.

The inter-pixel isolation portion 132p-2 is formed in a region from the position P73 to the position P75, whereas the light shielding film 411p-2 is formed in a region from the position P74 to the position P76. In other words, the light shielding film 411p-2 is formed at a position shifted toward the second photoelectric conversion unit 102p with respect to the inter-pixel isolation portion 132p-2.

An inter-pixel isolation portion 132p-3 provided on the right side of the second photoelectric conversion unit 102p in Fig. 41 is formed from a position P78 to a position P80. Alight shielding film 411p-3 is not formed from a position P79 to the position P80 of the inter-pixel isolation portion 132p-2.

When the center position of the inter-pixel isolation portion 132p-3 is set at the position P79, the light shielding film 411p-3 is formed from a position P77 to the position P79. When the center position between the position P77 and the position P79 is denoted as a position P78, the position P78 is the position of a side of the inter-pixel isolation portion 132p-3 near the second photoelectric conversion unit 102p.

The inter-pixel isolation portion 132p-3 is formed in a region from the position P78 to the position P80, whereas the light shielding film 411p-3 is formed in a region from the position P77 to the position P79. In other words, the light shielding film 411p-3 is formed at a position shifted toward the second photoelectric conversion unit 102p with respect to the inter-pixel isolation portion 132p-3.

A structure where the light shielding film 411 is shifted toward the second photoelectric conversion unit 102p is located at a point where the first photoelectric conversion unit 101p and the second photoelectric conversion unit 102p are adjacent to each other. The point where the first photoelectric conversion unit 101p is adjacent to the second photoelectric conversion unit 102p is provided in a region where the light shielding film 411 overlaps the region of the inter-pixel isolation portion 132p.

As described above, the light shielding film 411p is configured to be shifted toward the second photoelectric conversion unit 102p serving as a small pixel, so that the opening of the first photoelectric conversion unit 101p is extended. Thus, the sensitivity of the first photoelectric conversion unit 101p serving as the large pixel can be improved. The provision of the light shielding film 411p can prevent light incident on a large pixel adjacent to a small pixel from entering the second photoelectric conversion unit 102p of the small pixel.

In the foregoing embodiment, a circle and a square were mainly described as the examples of the shape of the on-chip lens. Other shapes, for example, a polygon may be used.

The fourteenth embodiment can be implemented in combination with one or more of the first to thirteenth embodiments.

According to the present technique, sensitivity and quantization efficiency can be improved in the L-shaped first photoelectric conversion unit 101, in other words, a photoelectric conversion unit shaped without point symmetry. Furthermore, color mixture in a small pixel between different colors can be also reduced.

### <Fifteenth Embodiment>

A unit pixel 100q according to a fifteenth embodiment will be described below. The fifteenth embodiment is different from other embodiments in that a solid phase diffusion layer is added. The fifteenth embodiment can be implemented in combination with any of the first to fourteenth embodiments. In this example, the fifteenth embodiment is applied to the unit pixel 100h according to the eighth embodiment illustrated in Fig. 27.

The sectional configuration example of the unit pixels 100q in Fig. 42 indicates the sectional configuration example of the unit pixel 100 taken along line A-B of Fig. 26. The unit pixel 100q in Fig. 42 includes a first photoelectric conversion unit 101-1 and a second photoelectric conversion unit 102-2. An inter-pixel isolation portion 132-1 is provided on the left side of Fig. 42, and an inter-pixel isolation portion 132-3 is provided on the right side (on the right side of a second photoelectric conversion unit 102-1).

An inter-pixel isolation portion 132-2 is formed between a first photoelectric conversion unit 101 and a second photoelectric conversion unit 102 constituting a unit pixel 100 with the first photoelectric conversion unit 101, achieving a configuration that prevents light from leaking from the first photoelectric conversion unit 101-1 into the adjacent second photoelectric conversion unit 102-2.

In the unit pixel 100q illustrated in Fig. 42, a solid phase diffusion layer 531 is provided on a side wall of the inter-pixel isolation portion 132. The solid phase diffusion layer 531 is configured with a P-type or N-type solid phase diffusion layer 531. In the example of Fig. 42, the solid phase diffusion layer 531 is formed from the back side of a semiconductor substrate 131 and comes into contact with the front side of the semiconductor substrate 131 along the inter-pixel isolation portion 132.

On the first photoelectric conversion unit 101-1 serving as a large pixel, the solid phase diffusion layer 531 is formed around the first photoelectric conversion unit 101-1. The example in Fig. 42 illustrates a cross-sectional structure in which a solid phase diffusion layer 531-1 is formed on the left side of the first photoelectric conversion unit 101-1 of a large pixel in Fig. 42 and a solid phase diffusion layer 531-2 is formed on the right side. In plan view, the solid phase diffusion layer 531-1 and the solid phase diffusion layer 531-2 are solid phase diffusion layers 153 formed on two of four sides surrounding the first photoelectric conversion unit 101-1, and solid phase diffusion layers are formed also on the other two sides, so that the solid phase diffusion layers are formed around the first photoelectric conversion unit 101-1.

Likewise, on the second photoelectric conversion unit 102-1 serving as a small pixel, the solid phase diffusion layer 531 is formed around the second photoelectric conversion unit 102-1. The example in Fig. 42 illustrates a cross-sectional structure in which a solid phase diffusion layer 531-2 is formed on the left side of the second photoelectric conversion unit 102-1 of a small pixel in Fig. 42 and a solid phase diffusion layer 531-3 is formed on the right side. In plan view, the solid phase diffusion layer 531-2 and the solid phase diffusion layer 153-3 are solid phase diffusion layers 153 formed on two of four sides surrounding the second photoelectric conversion unit 102-1, and solid phase diffusion layers are formed also on the other two sides, so that the solid phase diffusion layers are formed around the second photoelectric conversion unit 102-1.

The provision of the solid phase diffusion layer 531 can form a high-field region that holds a charge generated in a PD 71.

The first photoelectric conversion unit 101-1 in Fig. 42 is formed as a so-called embedded photodiode that has an n-type impurity region formed in a p-type impurity region 133 formed in the semiconductor substrate 131 made of silicon. Likewise, the second photoelectric conversion unit 102-1 is also formed as an embedded photodiode.

Alight shielding film 411 is formed on the inter-pixel isolation portion 132. A light shielding film 411-1 is provided on the inter-pixel isolation portion 132-1, a light shielding film 411-2 is provided on the inter-pixel isolation portion 132-2, and a light shielding film 411-3 is provided on the inter-pixel isolation portion 132-3. The light shielding film 411 is a film made of a light shielding material that prevents incident light from entering an adjacent pixel.

On the upper side of the semiconductor substrate 131 where the first photoelectric conversion unit 101-1 and the second photoelectric conversion unit 102-2 are formed, a planarizing film 412 is formed and the light shielding film 411 is formed in the planarizing film 412. An on-chip lens 401-3 and an on-chip lens 401-4 are provided on the planarizing film 412.

On a surface opposite to a surface where on-chip lenses 401 are formed, the gate electrodes of transistors are provided. In the example of Fig. 42, the gate electrode of a selection transistor 110 is provided for the first photoelectric conversion unit 101-1 of the large pixel, and the gate electrode of a third transfer transistor 105 is provided for the second photoelectric conversion unit 102-1 of the small pixel.

By providing the solid phase diffusion layer 531, an impurity, e.g., boron may be extended to an active region. Thus, the gate electrode is formed in a region where the solid phase diffusion layer 531 is not formed.

In the case of a large/small pixel structure including the large pixel and the small pixel as illustrated in Fig. 42, a through trench (inter-pixel isolation portion 132) for isolating the large pixel and the small pixel is formed, thereby reducing an active region for placing a transistor. If the solid phase diffusion layer 531 is formed on a side of the inter-pixel isolation portion 132 as illustrated in Fig. 42, the active region is further reduced. If the region for placing a transistor is reduced, the L length and W width of the transistor may be insufficiently obtained, leading to difficulty in obtaining characteristics required for the transistor.

The active region for placing the transistor may be increased in the configuration of Fig. 43. The solid phase diffusion layer 531 of the unit pixel 100q in Fig. 43 is formed from the back side (light entrance surface) of the semiconductor substrate 131 to a position that is not in contact with the front side (a surface on which the transistor is formed) of the semiconductor substrate 131 along the inter-pixel isolation portion 132.

The solid phase diffusion layer 531-1 is formed on the left side of the first photoelectric conversion unit 101-1 in Fig. 43 and is formed at a certain distance, e.g., 0.5 µm from the front side. The solid phase diffusion layer 531-2 is formed on the right side of the first photoelectric conversion unit 101-1 in Fig. 43 and is formed at a certain distance from the front side.

Likewise, the solid phase diffusion layer 531-3 is formed on the left side of the second photoelectric conversion unit 102-1 in Fig. 43 and is formed at a certain distance from the front side. The solid phase diffusion layer 531-4 is formed on the right side of the second photoelectric conversion unit 102-1 in Fig. 43 and is formed at a certain distance from the front side.

When viewing the unit pixel 100q from the front side, the solid phase diffusion layer 531 is not formed on the front side, thereby extending the active region for placing the transistor. Thus, the transistor can be placed to the edge of the through trench (inter-pixel isolation portion 132), so that the L length and W width of the transistor can be sufficiently secured and desired transistor characteristics can be obtained.

For example, the layout of transistors in Fig. 3 is applicable to the layout of transistors on the unit pixels 100q in Fig. 42. A transistor illustrated in Fig. 3, for example, the gate electrode of the transfer transistor 103 is disposed without making contact with the inter-pixel isolation portion 132. The unit pixel 100q in Fig. 42 is applicable when the transistor is disposed without bringing the gate electrode into contact with the inter-pixel isolation portion 132.

For example, the layout of transistors in Fig. 6 is applicable to the layout of transistors on the unit pixels 100q in Fig. 43. A transistor illustrated in Fig. 6, for example, the gate electrode of the transfer transistor 103 is disposed in contact with the inter-pixel isolation portion 132. The unit pixel 100q in Fig. 43 is applicable when the transistor is disposed with the gate electrode in contact with the inter-pixel isolation portion 132.

The fifteenth embodiment can be implemented in combination with one or more of the first to fourteenth embodiments.

The concentration of boron in the solid phase diffusion layer 531 may be low on the front side (a side on which a pixel transistor is disposed) and high on the back side (the side of a light entrance surface). The concentration may gradually change from the front side to the back side. Alternatively, the concentration may change step by step. For example, a concentration on the front side may be about 1e13 to 1e18 while the concentration on the back side may be about 1e15 to 1e20. A concentration difference of an impurity, e.g., boron is made between the front side and the back side in solid phase diffusion, so that an electric field is generated in a front-side direction to obtain a photodiode potential advantageous to transfer.

### <Sixteenth Embodiment>

A unit pixel 100r according to a sixteenth embodiment will be described below. The sixteenth embodiment is different from other embodiments in that RDTI or DCR is added. The sixteenth embodiment can be implemented in combination with any of the first to fifteenth embodiments. In this example, the sixteenth embodiment is applied to the unit pixel 100b according to the second embodiment illustrated in Fig. 6.

Fig. 44 illustrates a plan configuration example of a unit pixel 100r according to 16-1 embodiment. The plan configuration of the unit pixel 100r in Fig. 44 is basically identical to the plan configuration example of the unit pixel 100b in Fig. 6. Thus, the same parts are denoted by the same reference numerals and the description thereof is omitted as necessary.

In the unit pixel 100r illustrated in Fig. 44, the gate electrode of a selection transistor 110 is located substantially at the center of the lower side of a first photoelectric conversion unit 101-1 serving as a large pixel in Fig. 44. The gate electrode, the drain region, and the source region of the selection transistor 110 are linearly formed and have an L-shaped region connected to an amplification transistor 109.

In the unit pixel 100r in Fig. 44, a third transfer transistor 105 (a transistor denoted as FCG in Fig. 44) disposed on a second photoelectric conversion unit 102-1 serving as a small pixel has a gate electrode disposed at a corner portion of the second photoelectric conversion unit 102-1 and two sides located on an inter-pixel isolation portion 132. The drain region and the source region of the third transfer transistor 105 are formed along the inter-pixel isolation portion 132 and are L-shaped.

Such a transistor layout is also applicable to other embodiments.

Figs. 45 to 49 illustrate an example of the unit pixel 100r according to the sixteenth embodiment. In Figs. 45 to 49, the upper drawing illustrates a plan configuration example of the inter-pixel isolation portion 132 and RDTI or DCR among the plan configuration examples of the unit pixels 100r, the middle drawing illustrates a sectional configuration example taken along line A-A' of Fig. 44, and the lower drawing illustrates a sectional configuration example taken along line B-B' of Fig. 44.

In the cross-sectional views in the middle and lower parts of Figs. 45 to 49, the upper side is the front side on which transistors or the like are disposed, and the lower side is the side of a light entrance surface.

Referring to the upper drawing of Fig. 45, the unit pixel 100r includes an L-shaped RDTI 551. In Fig. 45, the RDTI 551 formed in the horizontal direction is denoted as an RDTI 51-1 and the RDTI 551 formed in the longitudinal direction is denoted as an RDTI 551-2.

The RDTI 551 stands for Reverse side Deep Trench Isolation and is a trench dug from the back side (the lower side in Fig. 45) of a substrate. The inter-pixel isolation portion 132 may be an FDDI or RDTI that is dug from the front side (the upper side in Fig. 45). FDDI stands for Front side Deep Trench Isolation.

The RDTI 551 is L-shaped in plan view. An inter-pixel isolation portion 132-2 formed between the first photoelectric conversion unit 101-1 and the second photoelectric conversion unit 102-1 is L-shaped (two sides in the vertical direction and the horizontal direction in Fig. 45). The L-shaped RDTI 551 is formed with symmetry with respect to the L-shaped inter-pixel isolation portion 132.

An overlap between the RDTI 551-1 and the RDTI 551-2 also overlaps the inter-pixel isolation portion 132. The overlap may be formed as the inter-pixel isolation portion 132 without forming the RDTI 551, or the inter-pixel isolation portion 132 may be configured to be formed as a part of the RDTI 551.

The RDTI 551 is shaped like a trench and can be configured as a region having a higher impurity concentration than an adjacent region. The RDTI 551 as a region having a high impurity concentration may be configured with an increased PN junction, thereby increasing a saturation signal amount.

Referring to the cross-sectional view taken along line A-A' in the middle part of Fig. 45, an inter-pixel isolation portion 132-1 is formed on the left side of the first photoelectric conversion unit 101-1 in the drawing, the inter-pixel isolation portion 132-2 is formed between the first photoelectric conversion unit 101-1 and the second photoelectric conversion unit 102-1, and an inter-pixel isolation portion 132-3 is formed on the right side of the second photoelectric conversion unit 102-1 in the drawing.

Referring to the cross-sectional view taken along line B-B' in the lower part of Fig. 45, an RDTI 551-2 is formed at the central portion of the first photoelectric conversion unit 101-1. The RDTI 551-2 is a trench that is formed to a midpoint of the first photoelectric conversion unit 101-1 in the height direction (thickness direction) and is not formed near a wiring layer (the upper side in the drawing) on which transistors or the like are disposed. The formation of the RDTI 551 does not reduce a region where transistors can be disposed. Thus, the RDTI 551 can be provided while keeping flexibility in the layout of the transistors, and the saturation signal amount can be increased.

### <16-2 Embodiment>

Fig. 46 illustrates a configuration example of the unit pixel 100r according to 16-2 embodiment.

The unit pixel 100r according to 16-2 embodiment is different from the unit pixel 100r (Fig. 45) according to 16-1 embodiment in the shape and position of the RDTI 551. Other points are identical in configuration.

Referring to a plan configuration example in the upper part of Fig. 46, the RDTI 551 is circular and is located at the center of a pixel. If the first photoelectric conversion unit 101-1 serving as a large pixel is divided as large as the second photoelectric conversion unit 102-1 serving as a small pixel, the first photoelectric conversion unit 101-1 is divided into three regions. If the first photoelectric conversion unit 101-1 is divided into three regions, an RDTI 551 is formed in each of the regions.

An RDTI 551-3 is formed in the lower left region of the first photoelectric conversion unit 101-1, an RDTI 551-4 is formed in the upper left region, and an RDTI 551-5 is formed in the upper right region. The RDTI 551-3 to 551-5 are each formed into a region located substantially at the center of the region. An RDTI 551-6 is formed substantially at the center of the second photoelectric conversion unit 102-1.

Referring to a cross-sectional view taken along line A-A' in the middle part of Fig. 46, the RDTI 551-3 is formed in a region located substantially at the center between the inter-pixel isolation portion 132-1 and the inter-pixel isolation portion 132-2 that are formed on the first photoelectric conversion unit 101-1. The RDTI 551-6 is formed substantially at the center between the inter-pixel isolation portion 132-2 and the inter-pixel isolation portion 132-3.

Referring to a cross-sectional view taken along line B-B' in the lower part of Fig. 46, the RDTI 551-4 and the RDTI 551-5 are formed between the inter-pixel isolation portion 132-1 and the inter-pixel isolation portion 132-3 that are formed on the first photoelectric conversion unit 101-1. A distance between the inter-pixel isolation portion 132-1 and the RDTI 551-4 and a distance between the inter-pixel isolation portion 132-3 and the RDTI 551-5 are equal to each other.

In the example of Fig. 46, the RDTI 551 is shaped like a cylinder located at a position at equal distances from the inter-pixel isolation portions 132.

In the example of Fig. 46, the RDTI 551 is circular in plan view. The RDTI 551 may have shapes other than a circle, for example, polygons such as a triangle and a square or an ellipse.

### <16-3 Embodiment>

Fig. 47 illustrates a configuration example of the unit pixel 100r according to 16-3 embodiment.

The unit pixel 100r according to 16-3 embodiment is different from the unit pixel 100r (Fig. 45) according to 16-1 embodiment in the shape and position of the RDTI 551. Other points are identical in configuration.

Referring to a plan configuration example in the upper part of Fig. 47, the RDTIs 551 are shaped like two straight lines and are located in the first photoelectric conversion unit 101-1. An RDTI 551-7 is disposed in the vertical direction and is formed with ends overlapping an inter-pixel isolation portion 132-4 and an inter-pixel isolation portion 132-5. Likewise, an RDTI 551-8 is disposed in the horizontal direction and is formed with ends overlapping the inter-pixel isolation portion 132-1 and the inter-pixel isolation portion 132-3.

The RDTI 551-7 is disposed at a position at equal distances from the inter-pixel isolation portion 132-1 and the inter-pixel isolation portion 132-2 in the vertical direction, in other words, the RDTI 551-7 is disposed substantially at the center between the inter-pixel isolation portion 132-1 and the inter-pixel isolation portion 132-2. The RDTI 551-8 is disposed at a position at equal distances from the inter-pixel isolation portion 132-2 in the horizontal direction and the inter-pixel isolation portion 132-5, in other words, the RDTI 551-8 is disposed substantially at the center between the inter-pixel isolation portion 132-2 and the inter-pixel isolation portion 132-5.

Like the L-shaped RDTI 551 in Fig. 45, an overlap between the RDTI 551 and the inter-pixel isolation portion 132 may be configured to be formed as the inter-pixel isolation portion 132 without the RDTI 551, or the inter-pixel isolation portion 132 may be configured to be formed as a part of the RDTI 551.

In the example of Fig. 47, the two RDTIs 551 including the RDTI 551-7 in the vertical direction and the RDTI 551-8 in the horizontal direction are formed in a cross arrangement. Only one of the RDTI 551-7 and the RDTI 551-8 may be formed.

Referring to a cross-sectional view taken along line A-A' in the middle part of Fig. 47, the RDTI 551-8 is formed in a region located substantially at the center between the inter-pixel isolation portion 132-1 and the inter-pixel isolation portion 132-2 that are formed on the first photoelectric conversion unit 101-1.

Referring to a cross-sectional view taken along line B-B' in the lower part of Fig. 47, the RDTI 551-7 is formed between the inter-pixel isolation portion 132-1 and the inter-pixel isolation portion 132-3 that are formed on the first photoelectric conversion unit 101-1.

The RDTI 551 may be configured to be formed also in the second photoelectric conversion unit 102-1 serving as a small pixel.

### <16-4 Embodiment>

Fig. 48 illustrates a configuration example of the unit pixel 100r according to 16-4 embodiment.

The unit pixel 100r according to 16-4 embodiment is different in that the RDTI 551 of the unit pixel 100r (Fig. 47) according to 16-3 embodiment is replaced with a DCR 571. Other points are identical in configuration.

The DCR 571 is a region that is formed by using a well implantation. A PN junction capacitance can be increased by providing the DCR 571.

Referring to a plan configuration example in the upper part of Fig. 48, the DCRs 571 are shaped like two straight lines and are located in the first photoelectric conversion unit 101-1. A DCR 571-1 is disposed in the vertical direction and is formed with ends overlapping the inter-pixel isolation portion 132-4 and the inter-pixel isolation portion 132-5.

Likewise, a DCR 571-2 is disposed in the horizontal direction and is formed with ends overlapping the inter-pixel isolation portion 132-1 and the inter-pixel isolation portion 132-3.

The DCR 571-1 is disposed at a position at equal distances from the inter-pixel isolation portion 132-1 and the inter-pixel isolation portion 132-2 in the vertical direction, in other words, the DCR 571-1 is disposed substantially at the center between the inter-pixel isolation portion 132-1 and the inter-pixel isolation portion 132-2. The DCR 571-2 is disposed at a position at equal distances from the inter-pixel isolation portion 132-2 and the inter-pixel isolation portion 132-5 in the horizontal direction, in other words, the DCR 571-2 is disposed substantially at the center between the inter-pixel isolation portion 132-2 and the inter-pixel isolation portion 132-5.

Like the L-shaped RDTI 551 in Fig. 45, an overlap between the DCR 571 and the inter-pixel isolation portion 132 may be configured to be formed as the inter-pixel isolation portion 132 without the DCR 571, or the inter-pixel isolation portion 132 may be configured to be formed as a part of the DCR 571.

In the example of Fig. 48, the two DCRs 571 including the DCR 571-1 in the vertical direction and the DCR 571-2 in the horizontal direction are formed in a cross arrangement. Only one of the DCR 571-1 and the DCR 571-2 may be formed.

Referring to a cross-sectional view taken along line A-A' in the middle part of Fig. 48, the DCR 571-1 is formed in a region located substantially at the center between the inter-pixel isolation portion 132-1 and the inter-pixel isolation portion 132-2 that are formed on the first photoelectric conversion unit 101-1.

Referring to a cross-sectional view taken along line B-B' in the lower part of Fig. 48, the DCR 571-2 is formed between the inter-pixel isolation portion 132-1 and the inter-pixel isolation portion 132-3 that are formed on the first photoelectric conversion unit 101-1.

The DCR 571 may be configured to be formed also in the second photoelectric conversion unit 102-1 serving as a small pixel.

### <16-5 Embodiment>

Fig. 49 illustrates a configuration example of the unit pixel 100r according to 16-5 embodiment.

The unit pixel 100r according to 16-5 embodiment is different from the unit pixel 100r (Fig. 48) according to 16-4 embodiment in the shape and layout of the DCR 571. Other points are identical in configuration.

Referring to a plan configuration example in the upper part of Fig. 49, a DCR 571-3 is shaped like a straight line. On the assumption that the first photoelectric conversion unit 101-1 and the second photoelectric conversion unit 102-1 are combined into a pixel, the DCR 571-3 is located at a position corresponding to a diagonal line in the pixel and is placed from the upper left to the lower right in Fig. 49. In this case, a DCR 571-3 formed by well implantation is disposed at the central portion of the pixel that is a combination of the first photoelectric conversion unit 101-1 and the second photoelectric conversion unit 102-1.

Like the L-shaped RDTI 551 in Fig. 46, an overlap (a corner portion in Fig. 49) between the DCR 571 and the inter-pixel isolation portion 132 may be configured to be formed as the inter-pixel isolation portion 132 without the DCR 571, or the inter-pixel isolation portion 132 may be configured to be formed as a part of the DCR 571.

Referring to a cross-sectional view taken along line A-A' in the middle part of Fig. 49, the DCR 571-3 is formed in a region located substantially at the center between the inter-pixel isolation portion 132-2 and the inter-pixel isolation portion 132-3 that are formed on the second photoelectric conversion unit 102-1.

Referring to a cross-sectional view taken along line B-B' in the lower part of Fig. 49, the DCR 571-3 is formed between the inter-pixel isolation portion 132-1 and the inter-pixel isolation portion 132-3 that are formed on the first photoelectric conversion unit 101-1.

### <Seventeenth Embodiment>

A unit pixel 100s according to a seventeenth embodiment will be described below.

Pupil correction will be described in the example of the unit pixels 100a according to the first embodiment described with reference to Figs. 3 to 5. Light emitted to the on-chip lens 161 formed on the first photoelectric conversion unit 101 serving as a large pixel enters at various angles with respect to an imaging surface. Thus, if the unit pixel 100a at the center of an angle of view and the unit pixel 100a at an end of an angle of view have the same structure, light is less efficiently gathered, causing a difference in sensitivity between the unit pixel 100a at the center of an angle of view and the unit pixel 100a at an end of an angle of view.

In order to keep constant sensitivity without causing a difference in sensitivity between the unit pixel 100a at the center of an angle of view and the unit pixel 100a at an end of an angle of view, for example, the optical axis of the on-chip lens 161 and the aperture of the first photoelectric conversion unit 101-1 are aligned with each other, and the position of the first photoelectric conversion unit 101-1 is shifted according to the direction of a principal ray as traveling toward the end of the angle of view. This technique is referred to as, for example, pupil correction.

In the unit pixel 100a disposed at the central portion of an angle of view, incident light enters substantially perpendicularly to the first photoelectric conversion unit 101. In the unit pixel 100a at an end portion of an angle of view, incident light enters diagonally with respect to the first photoelectric conversion unit 101. A pupil correction is added to the on-chip lens 161 or a color filter (not illustrated) such that skew rays can be efficiently gathered. The amount of pupil correction increases from the center of the angle of view (e.g., the center of a pixel portion) toward the end of the angle of view.

Such a phenomenon may similarly occur also in the second photoelectric conversion unit 102 serving as a small pixel. Thus, as in the large pixel, the small pixel may be configured without a difference in sensitivity by a pupil correction.

In the case of the unit pixel 100 where a large pixel and a small pixel are disposed, the large pixel and the small pixel may have different output values for incident light. Although the same pupil correction can be made in the large pixel and the small pixel, different pupil corrections may be made to the large pixel and the small pixel.

The upper part of Fig. 50 shows a graph of the relationship between an incident angle of incident light on a large pixel and an output value. The lower part of Fig. 50 shows a graph of the relationship between an incident angle of incident light on a small pixel and an output value. As shown in the upper part of Fig. 50, the output value of the large pixel peaks around an incident angle of 24°, whereas as shown in the lower part of Fig. 50, the output value of the small pixel peaks around incident angle of 18°.

In a comparison between the adjacent large and small pixels subjected to the same pupil correction, for example, a value of sensitivity is generated in the large pixel and the small pixel even if light enters at the same incident angle. Thus, if a pupil correction is made to a pixel including a large pixel and a small pixel, a proper pupil correction may be made to each of the large pixel and the small pixel.

Fig. 51 shows an example of a change of the correction amount of a pupil correction between a large pixel and a small pixel. A pupil correction is performed by, for example, changing the position of the photoelectric conversion unit at the center of an angle of view and the end of an angle of view, changing the position of the color filter, or changing the position of the on-chip lens. In this example, a pupil correction is made by changing the position of the photoelectric conversion unit (changing a pixel structure in a semiconductor substrate).

Fig. 51 illustrates 16 large pixels (first photoelectric conversion unit 101) in a 4 by 4 array at the end of an angle of view of the pixel array unit 11 and 16 small pixels (second photoelectric conversion unit 102) in a 4 by 4 array.

At the center of an angle of view, the center of the first photoelectric conversion unit 101 and the center of a color filter 601 are aligned with each other and the center of the second photoelectric conversion unit 102 and the center of the color filter 601 are also aligned with each other. At the end of an angle of view, as shown in Fig. 51, the center of the first photoelectric conversion unit 101 and the center of the color filter 601 are aligned with each other but the center of the second photoelectric conversion unit 102 and the center of the color filter 601 are displaced from each other.

In this case, a pupil correction amount is 0 with respect to the large pixel, whereas a pupil correction amount with respect to the small pixel is designed to increase toward the end of the pixel. As described above, a proper pupil correction can be made to each of the large pixel and the small pixel by changing the pupil correction amount of the large pixel and the pupil correction amount of the small pixel.

For the sake of description, it is assumed that the center of the first photoelectric conversion unit 101 and the center of the color filter 601 are aligned with each other also at the end of an angle of view. However, a pupil correction can be surely made to the first photoelectric conversion unit 101 such that a displacement at the center increases toward the end of an angle of view.

As described above with reference to Fig. 36, a refractive index changes according to the wavelength of light transmitted to the on-chip lens 501. Thus, the light gathering capability may change depending upon the color of received light (the color of the disposed color filter 601). In other words, if the graph in Fig. 50 is a graph for green, the graph may be different from a graph for red or a graph for green. In view of such circumstances, a different correction amount for each color in addition to each position in the pixel array unit 11 is used as a pupil correction amount.

Fig. 52 illustrates an exemplary configuration of a setting of a pupil correction amount for each color (each wavelength). In Fig. 52, 1 to 4 in the upper part indicate column numbers, whereas 1 to 4 on the left indicate row numbers. For example, the coordinates of an upper left pixel are expressed as (1, 1), and the coordinates of a pixel on the right are expressed as (2, 1).

On the first photoelectric conversion unit 101 and the second photoelectric conversion unit 102 at coordinates (1, 1), the blue color filter 601 (a dot pattern in Fig. 52) is disposed. On the first photoelectric conversion unit 101 and the second photoelectric conversion unit 102 at coordinates (2, 1), the green color filter 601 (a lattice pattern in Fig. 52) is disposed.

On the first photoelectric conversion unit 101 and the second photoelectric conversion unit 102 at coordinates (1, 2), the green color filter 601 is disposed. On the first photoelectric conversion unit 101 and the second photoelectric conversion unit 102 at coordinates (2, 2), the red color filter 601 (a line pattern in Fig. 52) is disposed. Such a layout pattern of the color filter 601 including four pixels in a 2 by 2 array is repeated in the vertical and horizontal directions.

For example, regarding the blue color filter 601 at coordinates (1, 1) and the second photoelectric conversion unit 102, the center of the second photoelectric conversion unit 102 is located on the left side of the center of the color filter 601. Regarding the green color filter 601 at coordinates (2, 1) and the second photoelectric conversion unit 102, the center of the second photoelectric conversion unit 102 is located on the right side of the center of the color filter 601. As described above, different pupil correction amounts are set for blue and green.

Regarding the red color filter 601 at coordinates (2, 2) and the second photoelectric conversion unit 102, the center of the second photoelectric conversion unit 102 is located on the lower right side of the center of the color filter 601. As described above, different pupil correction amounts are set for red, blue, and green.

Thus, a more proper pupil correction can be made by changing a correction amount for each color. Moreover, a pupil correction can be similarly made also to a large pixel (first photoelectric conversion unit 101), thereby making a proper pupil correction also to the first photoelectric conversion unit 101.

In this example, a pupil correction is made with the pixel structure in a silicon substrate and the color filter 601. A pupil correction can also be made to, for example, the on-chip lens and a metal layer in the inter-pixel isolation portion 132.

A pupil correction can be made to one or more points of the color filter, the on-chip lens, the inter-pixel isolation portion 132, and an inter-pixel structure. In the case of pupil corrections to multiple points, for example, a pupil correction amount applied to the on-chip lens and a pupil correction amount applied to the color filter may be set at different values to perform optimization.

In the case of a pupil correction to the on-chip lens, the on-chip lens can be produced on the basis of a flowchart in Fig. 53.

In step S11, the on-chip lens for a small pixel is produced. For example, the on-chip lens for a small pixel is produced through photolithography using the mask of a photoresister in which a pupil correction for a small pixel is set.

In step S12, the on-chip lens for a large pixel is produced. For example, the on-chip lens for a large pixel is produced through photolithography using the mask of a photoresister in which a pupil correction for a large pixel is set.

In step S13, the on-chip lens for a large pixel and the on-chip lens for a small pixel are worked.

As described above, a correction amount is set to optimize the pupil correction amount of a large pixel and the pupil correction amount of a small pixel, and a production process for a pupil correction to a large pixel and a production process for a pupil correction to a small pixel are performed at different times. In this example, a pupil correction is made to the on-chip lens. Also when a pupil correction is made to the color filter and the inter-pixel isolation portion 132 or the like, the on-chip lens can be produced according to the same production process.

### <Eighteenth Embodiment>

Referring to Fig. 54, a unit pixel 100t according to an eighteenth embodiment will be described below.

In a sectional configuration example of the unit pixel 100t in Fig. 54, a first photoelectric conversion unit 101t-1 and a second photoelectric conversion unit 102t-1 are provided in a semiconductor substrate 131.

For example, as compared with the unit pixels 100d in Fig. 14, the first photoelectric conversion unit 101d-1 and the second photoelectric conversion unit 102d-1 of the unit pixels 100d are formed as embedded photodiodes. In the unit pixel 100t in Fig. 54, the embedded photodiode is replaced with a p-type impurity region 133 disposed only on the upper side (front side) in Fig. 54.

On the left side of the first photoelectric conversion unit 101t-1 in Fig. 54, an inter-pixel isolation portion 132t surrounding the unit pixel 100t is provided. Also on the right side of the second photoelectric conversion unit 102t-1 in Fig. 54, the inter-pixel isolation portion 132t surrounding the unit pixel 100t is provided. The inter-pixel isolation portion 132t is also provided between the first photoelectric conversion unit 101t-1 and the second photoelectric conversion unit 102t-1.

On a side in the inter-pixel isolation portion 132t, in other words, on a side of a trench constituting the inter-pixel isolation portion 132t, a fixed charge film 701 having a negative fixed charge is formed. In the unit pixel 100t in Fig. 54, a fixed charge film 702 having a negative fixed charge is also formed on the light entrance surface (back side) on the lower side in Fig. 54. In the presence of the fixed charge film 701 having a negative fixed charge, holes gather at the interface of the trench (inter-pixel isolation portion 132t) of a silicon substrate, and electrons generated at the interface of the inter-pixel isolation portion 132t are coupled to the holes before flowing into a photodiode. Thus, the occurrence of a dark current or white scratches is suppressed.

The fixed charge films 701 and 702 are formed by a hafnium oxide (HfO2) film, an aluminum oxide (Al2O3), a zirconium oxide (ZrO2) film, a tantalum oxide (Ta2O5), or a titanium oxide (TiO2) film. Other materials such as lanthanum oxide (Ea2O3), praseodymium oxide (Pr2O3), cerium oxide (CeO2), neodim oxide (Nd2O3), promethium oxide (Pm2O3), samarium oxide (Sm2O3), europium oxide (Eu2O3), gadolinium oxide (Gd2O3), terbium oxide (Tb2O3), dysprosium oxide (Dy2O3), holmium oxide (Ho2O3), erbium oxide (Er2O3), thulium oxide (Tm2O3), ytterbium oxide (Yb2O3), lutetium oxide (Lu2O3), and yttrium oxide (Y2O3) may be used.

The fixed charge films 701 and 702 can be also formed by a hafnium nitride film, an aluminum nitride film, a hafnium oxynitride film, or an aluminum oxynitride film.

The gate of a selection transistor 110 and the gate of a third transfer transistor 105 are provided on the front side (the upper side in Fig. 54) of the semiconductor substrate 131. On the front side in the semiconductor substrate 131 of the first photoelectric conversion unit 101t-1, an N-type diffusion layer 231 is formed. On the front side in the semiconductor substrate 131 of the second photoelectric conversion unit 102t-1, an N-type diffusion layer 232 and an N-type diffusion layer 233 are formed.

The fixed charge film 701 is formed from the back side of the semiconductor substrate 131 to a position in contact with a p-type impurity region 133, along a side wall in the inter-pixel isolation portion 132t (a trench constituting the inter-pixel isolation portion 132t). When the fixed charge film 701 having a negative fixed charge comes into the N-type diffusion layer of the transistor, for example, the N-type diffusion layers 231 to 233 in the example of Fig. 54, an intense electric field may be generated and a dark current may occur. Thus, the fixed charge film 701 is formed to a position that does not make contact with the N-type diffusion layer. In the example of Fig. 54, the fixed charge film 701 is formed to a position in front of the p-type impurity region 133 in which an N-type diffusion layer is formed.

The n-type impurity region constituting each of the first photoelectric conversion unit 101t and the second photoelectric conversion unit 102t is formed to a position in contact with the inter-pixel isolation portion 132t (fixed charge film 701) in the horizontal direction and is formed to a position in contact with the fixed charge film 702 on the back side of the region. Thus, the first photoelectric conversion unit 101t and the second photoelectric conversion unit 102t are configured such that a conformal doping p-type impurity is not present around the fixed charge film 701.

The configuration containing no conformal doping p-type impurity can increase an effective volume of a photodiode. The influence of variations in conformal doping in the vertical direction is reduced, achieving an effective configuration for the imaging characteristics of white spots of floating diffusion FD.

As illustrated in Fig. 55, the inter-pixel isolation portion 132t may be configured to be divided into two in the vertical and horizontal directions (depth direction). In the example of Fig. 55, the inter-pixel isolation portion 132t is divided into an inter-pixel isolation portion 132t-1 and an inter-pixel isolation portion 132t-2. The inter-pixel isolation portion 132t-1 and the inter-pixel isolation portion 132t-2 are divided by a dividing layer 711.

The fixed charge film 701 is configured to be provided in the inter-pixel isolation portion 131t-1 but not to be provided in the inter-pixel isolation portion 132t-2.

The dividing layer 711 may be formed by a P-type impurity layer. In this case, in the formation of the pixel sensitivity isolation portion 132t-1, penetration through the silicon substrate is not necessary. When the dividing layer 711 comes into contact with the N-type diffusion layers 231 to 233, an impurity concentration can be adjusted, thereby reducing electric field intensity.

The configuration of the unit pixels 1000t, in which the effective volume of the photodiode is increased, is applicable instead of the embedded photodiode. The eighteenth embodiment and one or more of the first to seventeenth embodiments can be applied in combination.

### <Application to Electronic Device>

The present technique can be applied to a general electronic device in which an imaging element is used in an image capturing unit (a photoelectric conversion unit), for example, an imaging device such as a digital still camera or a video camera, a portable terminal device that has an imaging function, or a copy machine in which an image sensor is used in an image reading unit. The imaging element may be formed as a one-chip or may be formed as a module in which an imaging unit and a signal processing unit or an optical system are collectively packaged with an imaging function.

Fig. 56 is a block diagram illustrating a configuration example of an imaging device as an electronic device to which the present technique is applied.

An imaging device 1000 in Fig. 56 includes an optical unit 1001 formed of a lens group, an imaging element (an imaging device) 1002 in which the configuration of the imaging device 10 in Fig. 1 is adopted, and a DSP (Digital Signal Processor) circuit 1003 that is a camera signal processing circuit. The imaging device 1000 includes a frame memory 1004, a display unit 1005, a recording unit 1006, an operation unit 1007, and a power supply unit 1008. The DSP circuit 1003, the frame memory 1004, the display unit 1005, the recording unit 1006, the operation unit 1007, and the power supply unit 1008 are connected to one another via a bus line 1009.

The optical unit 1001 captures incident light (image light) from a subject and forms an image on an imaging surface of the imaging element 1002. The imaging element 1002 converts an amount of incident light imaged on the imaging surface by the optical unit 1001 into an electric signal for each pixel and outputs the electric signal as a pixel signal. The imaging device 10 in Fig. 1 can be used as the imaging element 1002.

The display unit 1005 is configured with, for example, a thin display such as an LCD (Liquid Crystal Display) or an organic EL (Electro Luminescence) display and displays a moving image or a still image captured by the imaging element 1002. The recording unit 1006 records a moving image or a still image captured by the imaging element 1002 in a recording medium such as a hard disk or a semiconductor memory.

The operation unit 1007 issues operation commands for various functions of the imaging device 1000 on the basis of a user operation. The power supply unit 1008 appropriately supplies various types of power serving as operation power sources of the DSP circuit 1003, the frame memory 1004, the display unit 1005, the recording unit 1006, and the operation unit 1007 to supply targets.

### <Application to Mobile Object>

The technique of the present disclosure (the present technology) can be applied to various products. For example, the technique according to the present disclosure may be implemented as a device mounted on any type of moving body such as an automobile, an electric automobile, a hybrid electric automobile, a motorcycle, a bicycle, a personal mobility device, an airplane, a drone, a ship, a robot, or the like.

Fig. 57 is a block diagram illustrating a schematic configuration example of a vehicle control system, which is an example of a mobile object control system to which the technique according to the present disclosure can be applied.

The vehicle control system 12000 includes a plurality of electronic control units connected to each other via a communication network 12001. In the example illustrated in Fig. 57, the vehicle control system 12000 includes a drive system control unit 12010, a body system control unit 12020, a vehicle external information detection unit 12030, a vehicle internal information detection unit 12040, and an integrated control unit 12050. As a functional configuration of the integrated control unit 12050, a microcomputer 12051, an audio/image output unit 12052, and an in-vehicle network I/F (Interface) 12053 are illustrated.

The drive system control unit 12010 controls an operation of an apparatus related to a drive system of a vehicle according to various programs. For example, the drive system control unit 12010 functions as a driving force generator for generating a driving force of a vehicle such as an internal combustion engine or a driving motor, a driving force transmission mechanism for transmitting a driving force to wheels, a steering mechanism for adjusting a turning angle of a vehicle, and a control apparatus such as a braking apparatus that generates a braking force of a vehicle.

The body system control unit 12020 controls operations of various devices mounted in the vehicle body according to various programs. For example, the body system control unit 12020 functions as a control device of a keyless entry system, a smart key system, a power window device, or various lamps such as a headlamp, a back lamp, a brake lamp, a turn signal, and a fog lamp. In this case, radio waves transmitted from a portable device that substitutes for a key or signals of various switches may be input to the body system control unit 12020. The body system control unit 12020 receives inputs of the radio waves or signals and controls a door lock device, a power window device, and a lamp of the vehicle.

The vehicle external information detection unit 12030 detects information on the outside of the vehicle having the vehicle control system 12000 mounted thereon. For example, an imaging unit 12031 is connected to the vehicle external information detection unit 12030. The vehicle external information detection unit 12030 causes the imaging unit 12031 to capture an image of the outside of the vehicle and receives the captured image. The vehicle external information detection unit 12030 may perform object detection processing or distance detection processing for persons, cars, obstacles, signs, and letters on the road on the basis of the received image.

The imaging unit 12031 is an optical sensor that receives light and outputs an electrical signal according to the amount of the received light. The imaging unit 12031 can also output the electrical signal as an image or distance measurement information. In addition, the light received by the imaging unit 12031 may be visible light or invisible light such as infrared light.

The vehicle internal information detection unit 12040 detects information on the inside of the vehicle. For example, a driver state detection unit 12041 that detects a state of a driver state is connected to the vehicle internal information detection unit 12040. The driver state detection unit 12041 includes, for example, a camera that captures an image of a driver, and the vehicle internal information detection unit 12040 may calculate a degree of fatigue or concentration of the driver or may determine whether or not the driver is dozing on the basis of detection information input from the driver state detection unit 12041.

The microcomputer 12051 can calculate a control target value of the driving force generation device, the steering mechanism, or the braking device on the basis of information inside and outside of the vehicle acquired by the vehicle external information detection unit 12030 or the vehicle internal information detection unit 12040, and output a control command to the drive system control unit 12010. For example, the microcomputer 12051 can perform cooperative control for the purpose of implementing functions of an ADAS (advanced driver assistance system) including vehicle collision avoidance, impact mitigation, following traveling based on an inter-vehicle distance, vehicle speed maintenance driving, vehicle collision warning, vehicle lane deviation warning, and the like.

Furthermore, the microcomputer 12051 can perform cooperative control for the purpose of automated driving or the like in which autonomous travel is performed without depending on operations of the driver, by controlling the driving force generator, the steering mechanism, or the braking device and the like on the basis of information about the surroundings of the vehicle, the information being acquired by the vehicle external information detection unit 12030 or the vehicle internal information detection unit 12040.

In addition, the microcomputer 12051 can output a control command to the body system control unit 12030 based on the information outside the vehicle acquired by the vehicle external information detection unit 12030. For example, the microcomputer 12051 can perform coordinated control for the purpose of antiglare such as switching a high beam to a low beam by controlling a headlamp according to a position of a preceding vehicle or an oncoming vehicle detected by the vehicle external information detection unit 12030.

The audio/image output unit 12052 transmits an output signal of at least one of sound and an image to an output device capable of visually or audibly notifying a passenger or the outside of the vehicle of information. In the example of Fig. 57, an audio speaker 12061, a display unit 12062, and an instrument panel 12063 are illustrated as examples of the output device. The display unit 12062 may include at least one of an on-board display and a head-up display, for example.

Fig. 58 illustrates an example of an installation position of the imaging unit 12031.

In Fig. 58, the imaging unit 12031 includes imaging units 12101, 12102, 12103, 12104, and 12105.

The imaging units 12101, 12102, 12103, 12104, and 12105 are provided at, for example, positions of a front nose, side mirrors, a rear bumper, and a back door of the vehicle 12100, and an upper portion of a front windshield inside the vehicle. The imaging unit 12101 provided at the front nose and the imaging unit 12105 provided in an upper portion of the front windshield inside the vehicle mainly acquire images ahead of the vehicle 12100. The imaging units 12102 and 12103 provided in the side mirrors mainly acquire images on the lateral sides of the vehicle 12100. The imaging unit 12104 included in the rear bumper or the back door mainly acquires an image of an area behind the vehicle 12100. The imaging unit 12105 included in the upper portion of the front windshield inside the vehicle is mainly used for detection of a vehicle ahead, a pedestrian, an obstacle, a traffic signal, a traffic sign, a lane, or the like.

Fig. 58 illustrates an example of the imaging ranges of the imaging units 12101 to 12104. An imaging range 12111 indicates an imaging range of the imaging unit 12101 provided at the front nose, imaging ranges 12112 and 12113 respectively indicate the imaging ranges of the imaging units 12102 and 12103 provided at the side-view mirrors, and an imaging range 12114 indicates the imaging range of the imaging unit 12104 provided at the rear bumper or the back door. For example, by superimposing image data captured by the imaging units 12101 to 12104, a bird's-eye view image viewed from the upper side of the vehicle 12100 can be obtained.

At least one of the imaging units 12101 to 12104 may have the function of obtaining distance information. For example, at least one of the imaging units 12101 to 12104 may be a stereo camera including a plurality of imaging elements or may be an imaging element that has pixels for phase difference detection.

For example, the microcomputer 12051 can extract, particularly, a closest three-dimensional object on a path through which the vehicle 12100 is traveling, which is a three-dimensional object traveling at a predetermined speed (for example, 0 km/h or higher) in the substantially same direction as the vehicle 12100, as a preceding vehicle by obtaining a distance to each three-dimensional object in the imaging ranges 12111 to 12114 and temporal change in the distance (a relative speed with respect to the vehicle 12100) based on distance information obtained from the imaging units 12101 to 12104. The microcomputer 12051 can also set a following distance to the vehicle ahead to be maintained in advance and perform automatic brake control (including following stop control) and automatic acceleration control (including following start control). It is therefore possible to perform coordinated control for the purpose of, for example, automated driving in which the vehicle travels in an automated manner without requiring the driver to perform operations.

For example, the microcomputer 12051 can classify and extract three-dimensional data regarding three-dimensional objects into two-wheeled vehicles, normal vehicles, large vehicles, pedestrians, and other three-dimensional objects such as electric poles based on distance information obtained from the imaging units 12101 to 12104 and can use the three-dimensional data to perform automated avoidance of obstacles. For example, the microcomputer 12051 differentiates surrounding obstacles of the vehicle 12100 into obstacles which can be viewed by the driver of the vehicle 12100 and obstacles which are difficult to view. Then, the microcomputer 12051 determines a collision risk indicating the degree of risk of collision with each obstacle, and when the collision risk is equal to or higher than a set value and there is a possibility of collision, an alarm is output to the driver through the audio speaker 12061 or the display unit 12062, forced deceleration or avoidance steering is performed through the drive system control unit 12010, and thus driving support for collision avoidance can be performed.

At least one of the imaging units 12101 to 12104 may be an infrared camera that detects infrared rays. For example, the microcomputer 12051 can recognize a pedestrian by determining the presence or absence of a pedestrian in the captured image of the imaging units 12101 to 12104. Such pedestrian recognition is performed by, for example, a procedure in which feature points in the captured images of the imaging units 12101 to 12104 as infrared cameras are extracted and a procedure in which pattern matching processing is performed on a series of feature points indicating an outline of an object to determine whether or not the object is a pedestrian. When the microcomputer 12051 determines that a pedestrian is present in the captured images of the imaging units 12101 to 12104 and the pedestrian is recognized, the audio/image output unit 12052 controls the display unit 12062 so that a square contour line for emphasis is superimposed and displayed with the recognized pedestrian. In addition, the audio/image output unit 12052 may control the display unit 12062 so that an icon indicating a pedestrian or the like is displayed at a desired position.

The system as used herein refers to an entire device configured by a plurality of devices.

The effects described in the present specification are merely examples and are not limited, and other effects may be obtained.

Embodiments of the present technique are not limited to the above-described embodiment and various modifications can be made within the scope of the present technique without departing from the gist of the present technique.

The present technique can also be configured as follows:
(1) An imaging element including: a first photoelectric conversion unit that is provided in a semiconductor substrate and generates a charge corresponding to the amount of light;
   a second photoelectric conversion unit having a smaller light-receiving area than the first photoelectric conversion unit;
   a first inter-pixel isolation portion that surrounds a unit pixel including the first photoelectric conversion unit and the second photoelectric conversion unit; and a second inter-pixel isolation portion provided between the first photoelectric conversion unit and the second photoelectric conversion unit,
   wherein the first inter-pixel isolation portion and the second inter-pixel isolation portion are each configured with a trench penetrating the semiconductor substrate.
(2) The imaging element according to (1), wherein the trench is filled with an insulator.
(3) The imaging element according to (1) or (2), wherein one or more transistors and a contact are disposed in a region where the second photoelectric conversion unit is formed in plan view.
(4) The imaging element according to any one of (1) to (3), wherein a capacitor is connected to the second photoelectric conversion unit.
(5) The imaging element according to any one of (1) to (4), wherein the unit pixel further includes an element isolation region that separates elements, and
   the element isolation region is configured with a trench not penetrating the semiconductor substrate.
(6) The imaging element according to any one of (1) to (5), wherein the first photoelectric conversion unit is L-shaped in plan view,
   the second photoelectric conversion unit is square-shaped, and
   a combination of the first photoelectric conversion unit and the second photoelectric conversion unit is square-shaped.
(7) The imaging element according to any one of (1) to (6), wherein two sides of the gate of at least one of a plurality of transistors constituting the unit pixel are located on the first inter-pixel isolation portion and the second inter-pixel isolation portion in plan view.
(8) The imaging element according to any one of (1) to (7), wherein two sides of the gate of an amplification transistor are located on the first inter-pixel isolation portion and the second inter-pixel isolation portion in plan view.
(9) The imaging element according to (8), wherein the two sides are parallel to a line connecting the source and the drain of the amplification transistor.
(10) The imaging element according to any one of (1) to (9), further including a first lens disposed on the first photoelectric conversion unit; and
   a second lens disposed on the second photoelectric conversion unit,
   wherein
   the first lens and the second lens are identical in size.
(11) The imaging element according to any one of (1) to (9), further including a first lens disposed on the first photoelectric conversion unit; and
   a second lens disposed on the second photoelectric conversion unit,
   wherein
   the first lens and the second lens have different sizes.
(12) The imaging element according to (11), wherein the first lens and the second lens that are disposed in the unit pixel are placed in contact with each other, and
   the second lens disposed in a first unit pixel and the first lens disposed in a second unit pixel adjacent to the first unit pixel are not placed in contact with each other.
(13) The imaging element according to (12), wherein the first lens in contact with the second lens is oval.
(14) The imaging element according to (11), wherein the plurality of square-shaped first lenses are disposed on the first photoelectric conversion unit.
(15) The imaging element according to (11), wherein the second lens disposed in a first unit pixel is placed in contact with the first lens disposed in the first unit pixel and the first lens disposed in a second unit pixel adjacent to the first unit pixel.
(16) The imaging element according to (11), wherein the first lens has a different size for each color of a placed color filter.
(17) The imaging element according to any one of (1) to (16), wherein a light shielding film provided on the second inter-pixel isolation portion is located at a position shifted toward the second photoelectric conversion unit.
(18) The imaging element according to any one of (1) to (17), wherein the trench of each of the first inter-pixel isolation portion and the second inter-pixel isolation portion includes a fixed charge film therein, and
   each of the first photoelectric conversion unit and the second photoelectric conversion unit has an n-type impurity region in contact with the trench.
(19) An electronic device including an imaging element and a processing unit that processes a signal from the imaging element, the imaging element including: a first photoelectric conversion unit that is provided in a semiconductor substrate and generates a charge corresponding to the amount of light;
   a second photoelectric conversion unit having a smaller light-receiving area than the first photoelectric conversion unit;
   a first inter-pixel isolation portion that surrounds a unit pixel including the first photoelectric conversion unit and the second photoelectric conversion unit; and a second inter-pixel isolation portion provided between the first photoelectric conversion unit and the second photoelectric conversion unit,
   wherein the first inter-pixel isolation portion and the second inter-pixel isolation portion are each configured with a trench penetrating the semiconductor substrate.

### [Reference Signs List]

- 10: Imaging device
- 11: Pixel array unit
- 12: Vertical driving unit
- 13: Column processing unit
- 14: Horizontal driving unit
- 15: System control unit
- 16: Pixel driving line
- 17: Vertical signal line
- 18: Signal processing unit
- 19: Data storage unit
- 100: Unit pixel
- 101: First photoelectric conversion unit
- 102: Second photoelectric conversion unit
- 103: First transfer transistor
- 104: Second transfer transistor
- 105: Third transfer transistor
- 106: In-pixel capacitor
- 107: FD unit
- 108: Reset transistor
- 109: Amplification transistor
- 110: Selection transistor
- 112: Node
- 131: Semiconductor substrate
- 132: Inter-pixel isolation portion
- 133: p-type impurity region
- 161, 162: On-chip lens
- 181, 184: 0n-chip lens
- 191, 192, 193: N-type diffusion layer
- 194: Element isolation region
- 201: Inter-pixel isolation portion
- 221: MIM capacitor
- 231, 232, 233: N-type diffusion layer
- 301, 302, 303, 304, 305, 306, 307, 308: Contact
- 311, 312, 313, 314, 315, 316, 317, 318, 319: N-type diffusion layer
- 321: Oxide film
- 322: Oxide film
- 341: Fourth transfer transistor
- 351, 352, 353, 361, 363, 391: N-type diffusion layer
- 392: Contact
- 401: On-chip lens
- 411: Light shielding film
- 412: Planarizing film
- 421, 441, 461, 481, 501: On-chip lens

## Claims

1. An imaging element comprising: a first photoelectric conversion unit that is provided in a semiconductor substrate and generates a charge corresponding to an amount of light;
a second photoelectric conversion unit having a smaller light-receiving area than the first photoelectric conversion unit;
a first inter-pixel isolation portion that surrounds a unit pixel including the first photoelectric conversion unit and the second photoelectric conversion unit; and a second inter-pixel isolation portion provided between the first photoelectric conversion unit and the second photoelectric conversion unit,
wherein the first inter-pixel isolation portion and the second inter-pixel isolation portion are each configured with a trench penetrating the semiconductor substrate.

2. The imaging element according to claim 1, wherein the trench is filled with an insulator.

3. The imaging element according to claim 1, wherein one or more transistors and a contact are disposed in a region where the second photoelectric conversion unit is formed in plan view.

4. The imaging element according to claim 1, wherein a capacitor is connected to the second photoelectric conversion unit.

5. The imaging element according to claim 1, wherein the unit pixel further includes an element isolation region that separates elements, and
the element isolation region is configured with a trench not penetrating the semiconductor substrate.

6. The imaging element according to claim 1, wherein the first photoelectric conversion unit is L-shaped in plan view,
the second photoelectric conversion unit is square-shaped, and
a combination of the first photoelectric conversion unit and the second photoelectric conversion unit is square-shaped.

7. The imaging element according to claim 1, wherein two sides of a gate of at least one of a plurality of transistors constituting the unit pixel are located on the first inter-pixel isolation portion and the second inter-pixel isolation portion in plan view.

8. The imaging element according to claim 1, wherein two sides of a gate of an amplification transistor are located on the first inter-pixel isolation portion and the second inter-pixel isolation portion in plan view.

9. The imaging element according to claim 8, wherein the two sides are parallel to a line connecting a source and a drain of the amplification transistor.

10. The imaging element according to claim 1, further comprising a first lens disposed on the first photoelectric conversion unit; and
a second lens disposed on the second photoelectric conversion unit,
wherein
the first lens and the second lens are identical in size.

11. The imaging element according to claim 1, further comprising a first lens disposed on the first photoelectric conversion unit; and
a second lens disposed on the second photoelectric conversion unit,
wherein
the first lens and the second lens have different sizes.

12. The imaging element according to claim 11, wherein the first lens and the second lens that are disposed in the unit pixel are placed in contact with each other, and
the second lens disposed in a first unit pixel and the first lens disposed in a second unit pixel adjacent to the first unit pixel are not placed in contact with each other.

13. The imaging element according to claim 12, wherein the first lens in contact with the second lens is oval.

14. The imaging element according to claim 11, wherein the plurality of square-shaped first lenses are disposed on the first photoelectric conversion unit.

15. The imaging element according to claim 11, wherein the second lens disposed in a first unit pixel is placed in contact with the first lens disposed in the first unit pixel and the first lens disposed in a second unit pixel adjacent to the first unit pixel.

16. The imaging element according to claim 11, wherein the first lens has a different size for each color of a placed color filter.

17. The imaging element according to claim 1, wherein a light shielding film provided on the second inter-pixel isolation portion is located at a position shifted toward the second photoelectric conversion unit.

18. The imaging element according to claim 1, wherein the trench of each of the first inter-pixel isolation portion and the second inter-pixel isolation portion includes a fixed charge film therein, and
each of the first photoelectric conversion unit and the second photoelectric conversion unit has an n-type impurity region in contact with the trench.

19. An electronic device comprising an imaging element and a processing unit that processes a signal from the imaging element, the imaging element including: a first photoelectric conversion unit that is provided in a semiconductor substrate and generates a charge corresponding to an amount of light;
a second photoelectric conversion unit having a smaller light-receiving area than the first photoelectric conversion unit;
a first inter-pixel isolation portion that surrounds a unit pixel including the first photoelectric conversion unit and the second photoelectric conversion unit; and a second inter-pixel isolation portion provided between the first photoelectric conversion unit and the second photoelectric conversion unit,
wherein the first inter-pixel isolation portion and the second inter-pixel isolation portion are each configured with a trench penetrating the semiconductor substrate.
